# EUROPEAN PATENT APPLICATION

(11) **EP 2 280 404 A2**
(43) Date of publication of application: **02.02.2011**
(21) Application number: 10014756.0
(22) Date of filing: 26.04.2000
(51) Int. Cl.: H01G 9/20, C07F 15/00

(54) **Metal complex dye for a photoelectrochemical cell**

(30) Priority: 28.12.1999 JP 37560999; 26.04.1999 JP 11782899; 14.06.1999 JP 16756499
(62) Divisional of application: 00108862.4
(71) Applicant: FUJIFILM Corporation, Tokyo 106-8620 (JP)
(72) Inventor: Takizawa, Hiroo, Tokyo 106-8620 (JP); Kuota, Tadahiko, Tokyo 106-8620 (JP)
(74) Representative: Grünecker, Kinkeldey, Stockmair & Schwanhäusser Anwaltssozietät

(57) **Abstract**

The first metal complex dye comprising a metal atom, bidentate or tridentate ligand(s) having nitrogen atoms, and monodentate or bidentate ligand(s) which coordinates to the metal atom via an acyloxy group, a 1,3-diketo group, etc. has a high stability to heat and light, and can efficiently sensitize semiconductor particles. The first photoelectric conversion device comprising the first dye exhibits a high stability to heat and light, and an excellent photoelectric conversion efficiency. The second metal complex dye comprising a metal atom, bidentate ligand(s) with a particular structure, and optional bidentate or tridentate ligand(s) having nitrogen atoms and a monodentate or bidentate ligand(s) such as 1,3-diketones, etc. has a high absorbancy at a large wave range, and can efficiently sensitize semiconductor particles. The second photoelectric conversion device comprising the second dye exhibits an excellent photoelectric conversion efficiency. These photoelectric conversion devices are useful for a photo-electrochemical cell.

## Description

### BACKGROUND OF THE INVENTION

The present invention relates to a metal complex dye that is able to efficiently sensitize semiconductor particles, a photoelectric conversion device comprising semiconductor particles sensitized by the metal complex dye, and a photo-electrochemical cell comprising the photoelectric conversion device.

Solar cells for the solar power generation comprising a monocrystalline silicon, a polycrystalline silicon, an amorphous silicon, cadmium telluride, indium copper selenide, etc. have been the subject of practical use and a major object of research and development. However, for a widespread use of the solar cell as a home power source, etc., there are such problems as a high production cost, difficulty in security of raw materials, and a long energy payback time, therefore, these obstacles must be overcome. On the other hand, a variety of solar cells comprising organic materials are proposed with the objects of increasing the surface area of the cell, lowering the price thereof, etc. However, they generally have such defects as a low conversion efficiency and a poor durability.

Under these circumstances, Nature, vol. 353, pp. 737 to 740 (1991), United States Patent No. 4,927,721 and WO 94/04497 proposed a wet-type photoelectric conversion device and a solar cell each comprising a titanium dioxide porous thin film spectrally sensitized with a ruthenium complex dye as a working electrode, and materials and a production technique for making the same. The primary advantage for the wet-type device is that a low-priced photoelectric conversion device can be provided because an inexpensive oxide semiconductor such as titanium dioxide can be used without purification thereof to a high purity. The secondary advantage therefor is that a light in almost whole visible wavelength region can be converted to electricity because the dye used therein exhibits a broad absorption spectrum.

Known ruthenium complex dye mentioned above have a thiocyanate group or an isothiocyanate group as a ligand. These groups are liable to be de-sulfurized by heat or light, to be converted into a cyano group. Consequently, it has been known that for the photoelectric conversion device comprising the ruthenium complex dye with these groups, a photoelectric conversion efficiency tends to be reduced by heat or light. Accordingly, for improvement of the photoelectric conversion device in stability to heat and light, it has been desired to develop a ligand exhibiting a higher stability to heat and light than those of the thiocyanate group and the isothiocyanate group.

On the other hand, known ruthenium complex dyes are disadvantageous in hardly absorbing an infrared ray with a wavelength of 700 nm or more. Consequently, a photoelectric conversion device comprising such a dye exhibits a low photoelectric conversion efficiency at infrared region. Accordingly, it has been desired to develop a dye having a high absorbancy at a large wave range containing visible region to infrared region.

### OBJECT AND SUMMARY OF THE INVENTION

The first object of the present invention is to provide a metal complex dye having a high stability to heat and light which is able to efficiently sensitize semiconductor particles, a photoelectric conversion device comprising the metal complex dye which exhibits a high stability to heat and light, and an excellent photoelectric conversion efficiency, and a photo-electrochemical cell comprising the photoelectric conversion device.

The second object of the present invention is to provide a metal complex dye having a high absorbability not only at visible region but also at infrared region, which is able to efficiently sensitize semiconductor particles, a photoelectric conversion device comprising the metal complex dye which exhibits an excellent photoelectric conversion efficiency, and a photo-electrochemical cell comprising the photoelectric conversion device.

As a result of intense research in view of the above first object, the inventors have found that a metal complex dye comprising a metal atom, bidentate or tridentate ligand(s) having nitrogen atoms for coordinating to the metal atom, and monodentate or bidentate ligand(s) which coordinates to the metal atom via one or two groups with an excellent stability to heat and light such as an acyloxy group, a 1,3-diketo group, etc. has a high stability to heat and light, and can efficiently sensitize semiconductor particles, and that a photoelectric conversion device comprising the metal complex dye exhibits a high stability to heat and light, and an excellent photoelectric conversion efficiency, so that it is useful for a photo-electrochemical cell. The first present invention has been accomplished by the findings.

Thus, in the first aspect of the present invention, there is provided the first photoelectric conversion device comprising semiconductor particles sensitized by the first metal complex dye represented by the following formula (I):

M₁(LL₁)m1(X₁)m2 • Cl₁ (l)

wherein M₁ represents a metal atom;

LL₁ represents a bidentate or tridentate ligand represented by the following general formula (III): 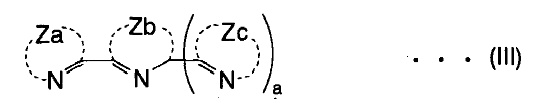
wherein Za, Zb and Zc independently represent nonmetallic atoms forming a 5- or 6-membered ring, *a* being 0 or 1;
X₁ represents a monodentate or bidentate ligand which coordinates to M₁ via one or two groups selected from the group consisting of an acyloxy group, an acylthio group, an acylaminooxy group, a thioacyloxy group, a thioacylthio group, a thiocarbonate group, a dithiocarbonate group, a trithiocarbonate group, an alkylthio group, an arylthio group, an alkoxy group and an aryloxy group, or a monodentate or bidentate ligand selected from the group consisting of ketones, carbonamides, thiocarbonamides, thioureas and isothioureas;
m1 represents 1 or 2, and LL₁ 's may be the same or different ligands when m1 is 2;
m2 represents an integer of 1 to 3, and X₁'s may be the same or different ligands that may be bonded together when m2 is 2 or 3; and
CI₁ represents a counter ion optionally contained to neutralize charge of said metal complex dye.

The first photo-electrochemical cell of the present invention is characterized by the use of the above-mentioned first photoelectric conversion device.

With respect to the first metal complex dye, the first photoelectric conversion device and the first photo-electrochemical cell, the stability to heat and light, and the photoelectric conversion efficiency are further improved by satisfying at least one of the following conditions (1) to (11).
(1) M₁ is preferably a metal atom that is able to form four- or six-coordinated complex, more preferably Ru, Fe, Os, Cu, W, Cr, Mo, Ni, Pd, Pt, Co, Ir, Rh, Mn or Zn, particularly preferably Ru, Fe, Os or Cu, most preferably Ru.
(2) It is preferable that the 5- or 6-membered rings formed by Za, Zb and Zc in the general formula (III) are independently an imidazole ring or a pyridine ring.
(3) It is preferable that LL₁ is a bidentate ligand, *a* in the general formula (III) being 0.
(4) It is preferable that LL₁ represents a bidentate or tridentate ligand represented by any one of the following general formulae (V-1) to (V-8): 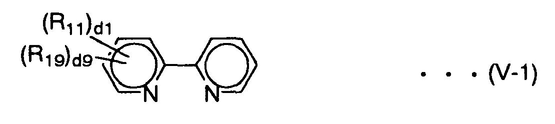 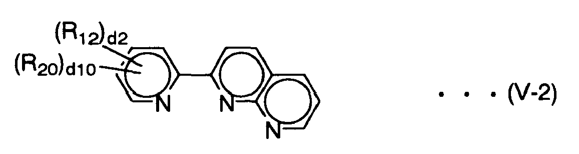 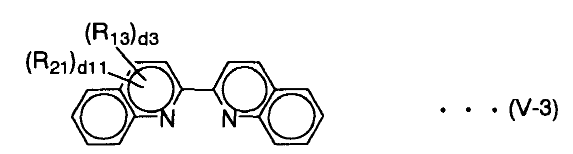 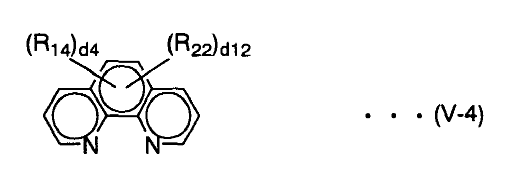 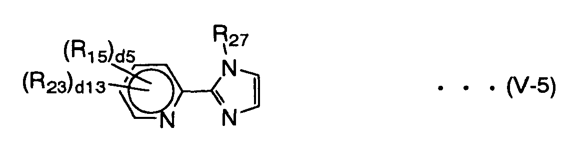 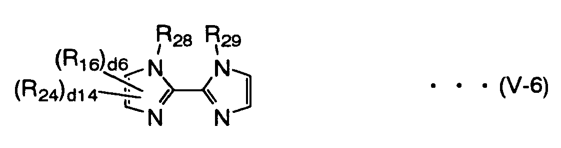 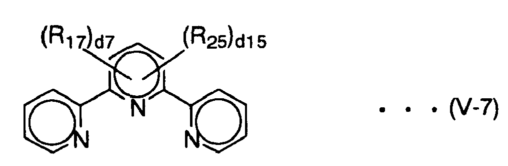 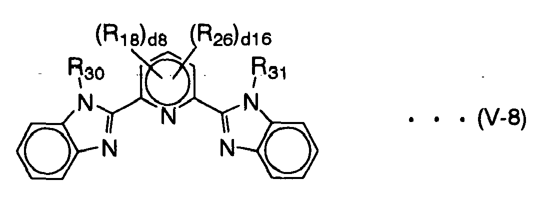 wherein R₁₁ to R₁₈ independently represent a carboxyl group, a sulfonic acid group, a hydroxyl group, a hydroxamic acid group, a phosphoryl group or a phosphonyl group, R₁₉ to R₂₆ independently represent a substituent, R₂₇ to R₃₁ independently represent an alkyl group, an alkenyl group, an aryl group or a hydrogen atom, R₁₁ to R₂₆ may be bonded to any carbon atom forming a ring, d1 to d8, d13, d14 and d16 independently represent an integer of 0 to 4, d9 to d12 and d15 independently represent an integer of 0 to 6, R₁₁ to R₁₈ may be the same or different groups when d1 to d8 are 2 or more, and R₁₉ to R₂₆ may be the same or different groups that may be bonded together to form a ring when d9 to d16 are 2 or more.
(5) LL₁ is more preferably represented by any one of the general formulae (V-1) to (V-6), particularly preferably represented by the general formulae (V-1), (V-3) or (V-6).
(6) It is preferable that R₁₁ to R₁₈ in the general formulae (V-1) to (V-8) are independently a carboxyl group or a phosphonyl group.
(7) It is preferable that R₁₉ to R₂₆ in the general formulae (V-1) to (V-8) independently represent an alkyl group, an alkenyl group, a cycloalkyl group, an aryl group, a heterocyclic group, an alkoxy group, an aryloxy group, an acyloxy group, an alkoxycarbonyl group, a carbamoyl group, an acylamino group, an amino group, an acyl group, a sulfonamido group, a cyano group, a hydroxyl group or a halogen atom.
(8) It is preferable that X₁ is a monodentate or bidentate ligand which coordinates to M₁ via one or two groups selected from the group consisting of an acyloxy group, an acylaminooxy group, an alkylthio group, an arylthio group, an alkoxy group and an aryloxy group, or a monodentate or bidentate ligand selected from the group consisting of ketones, thiocarbonamides; thioureas and isothioureas.
(9) It is preferable that at least one of X₁'s represents a bidentate ligand represented by any one of the following general formulae (VI-1) to (VI-5): 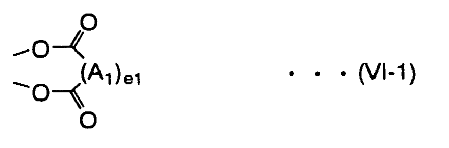 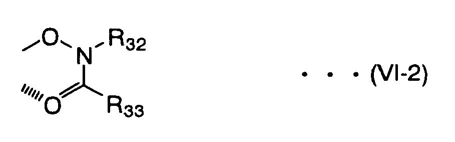 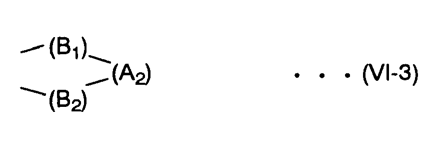 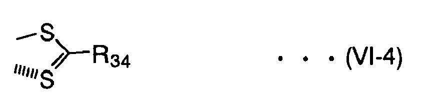 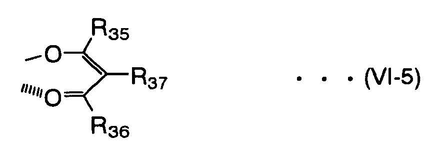 wherein A₁ represents a bidentate linking group, e1 represents 0 or 1, R₃₂ and R₃₃ independently represent an alkyl group, an alkenyl group, a cycloalkyl group, an aryl group, a heterocyclic group, an alkoxy group, an alkoxycarbonyl group, an amino group, an acyl group or a hydrogen atom, B₁ and B₂ independently represent an oxygen atom or a sulfur atom, A₂ represents an alkylene group or an arylene group, R₃₄ represents an alkyl group, an alkenyl group, a cycloalkyl group, an aryl group, a heterocyclic group, an alkoxy group, an aryloxy group, an alkylthio group or an arylthio group, R₃₅ and R₃₆ independently represent an alkenyl group, a cycloalkyl group, an aryl group, an alkoxy group, an amino group, a hydrogen atom, an alkyl group or a heterocyclic group, and R₃₇ represents an alkyl group, an alkenyl group, an aryl group, a halogen atom or a hydrogen atom.
(10) It is preferable that LL₁ and X₁ are bidentate, m1 being 2 and m2 being 1.
(11) It is preferable that the semiconductor particles are titanium oxide particles.

As for the first metal complex dye according to a particularly preferable embodiment of the present invention, in the general formula (I), M₁ is Ru, LL₁ is a bidentate or tridentate ligand represented by any one of the general formulae (V-1) to (V-8), X₁ is a bidentate ligand represented by any one of the general formulae (VI-1) to (VI-5), m1 is 1 or 2, LL₁'s may be the same or different ligands when m1 is 2, m2 represents an integer of 1 to 3, X₁'s may be the same or different ligands that may be bonded together when m2 is 2 or 3, and CI₁ represents a counter ion optionally contained to neutralize charge of the dye.

On the other hand, as a result of intense research in view of the above second object, the inventors have found that a metal complex dye comprising a metal atom, bidentate ligand(s) with a particular structure having nitrogen atoms for coordinating to the metal atom, and optional bidentate or tridentate ligand(s) having nitrogen atoms for coordinating to the metal atom and a monodentate or bidentate ligand(s) such as 1,3-diketones, etc. has a high absorbancy in not only at visible region but also at long wavelength region and can efficiently sensitize semiconductor particles, and that a photoelectric conversion device comprising the metal complex dye exhibits an excellent photoelectric conversion efficiency, so that it is useful for a photo-electrochemical cell. The second present invention has been accomplished by the findings.

Thus, in the second aspect of the present invention, there is provided the second photoelectric conversion device comprising semiconductor particles sensitized by the second metal complex dye represented by the following formula (II):

M₂(LL₂)m3(LL₃)m4(X₂)m5 .Cl₂ (II)

wherein M₂ represents a metal atom;
LL₂ represents a bidentate or tridentate ligand represented by the following general formula (III): 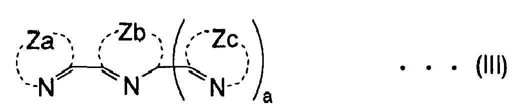 wherein Za, Zb and Zc independently represent nonmetallic atoms forming a 5- or 6-membered ring, *a* being 0 or 1;
LL₃ represents a bidentate ligand represented by the following general formula (IV): 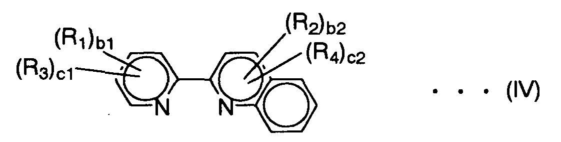 wherein R₁ and R₂ independently represent a carboxyl group, a sulfonic acid group, a hydroxyl group, a hydroxamic acid group, a phosphoryl group or a phosphonyl group, R₃ and R₄ independently represent a substituent, b1 and b2 independently represent an integer of 0 to 4, c1 represents an integer of 0 to 3, c2 represents an integer of 0 to 5, R₁'s may be the same or different groups when b1 is 2 or more, R₂'s may be the same or different groups when b2 is 2 or more, R₃'s may be the same or different groups that may be bonded together to form a ring when c1 is 2 or more, R₄'s may be the same or different groups that may be bonded together to form a ring when c2 is 2 or more, and R₃ and R₄ may be bonded to form a ring when both of c1 and c2 are 1 or more;
X₂ represents a monodentate or bidentate ligand which coordinates to M₂ via one or two groups selected from the group consisting of an acyloxy group, an acylthio group, an acylaminooxy group, a thioacyloxy group, a thioacylthio group, a thiocarbonate group, a dithiocarbonate group, a trithiocarbonate group, an alkylthio group, an arylthio group, an alkoxy group, an aryloxy group, a thiocarbamate group, a dithiocarbamate group, an acyl group, a thiocyanate group, an isothiocyanate group, a cyanate group, an isocyanate group and a cyano group, or a monodentate or bidentate ligand selected from the group consisting of ketones, carbonamides, thiocarbonamides, thioureas, isothioureas, halogen atoms and carbonyl;
m3 represents an integer of 0 to 2, and LL₂'s may be the same or different ligands when m3 is 2;
m4 represents an integer of 1 to 3, and LL₃'s may be the same or different ligands when m4 is 2 or 3;
m5 represents an integer of 0 to 3, and X₂'s may be the same or different ligands that may be bonded together when m5 is 2 or 3; and
CI₂ represents a counter ion optionally contained to neutralize charge of said metal complex dye.

The second photo-electrochemical cell of the present invention is characterized by the use of the above-mentioned second photoelectric conversion device.

With respect to the second metal complex dye, the second photoelectric conversion device and the second photo-electrochemical cell, the absorbancy at the long wavelength region and the photoelectric conversion efficiency are further improved by satisfying at least one of the following conditions (12) to (25).
(12) M₂ is preferably a metal atom that is able to form four- or six-coordinated complex, more preferably Ru, Fe, Os, Cu, W, Cr, Mo, Ni, Pd, Pt, Co, Ir, Rh, Mn or Zn, particularly preferably Ru, Fe, Os or Cu, most preferably Ru.
(13) It is preferable that the 5- or 6-membered rings formed by Za, Zb and Zc in the general formula (III) are independently an imidazole ring or a pyridine ring.
(14) It is preferable that LL₂ is a bidentate ligand, *a* in the general formula (III) being 0.
(15) It is preferable that LL₂ represents a bidentate or tridentate ligand represented by any one of the above general formulae (V-1) to (V-8).
(16) LL₂ is more preferably represented by the general formula (V-1), (V-2), (V-4) or (V-6), particularly preferably represented by the general formula (V-1) or (V-2).
(17) It is preferable that R₁₁ to R₁₈ in the general formulae (V-1) to (V-8) are independently a carboxyl group or a phosphonyl group.
(18) It is preferable that R₁₉ to R₂₆ in the general formulae (V-1) to (V-8) independently represent an alkyl group, an alkenyl group, a cycloalkyl group, an aryl group, a heterocyclic group, an alkoxy group, an aryloxy group, an acyloxy group, an alkoxycarbonyl group, a carbamoyl group, an acylamino group, an amino group, an acyl group, a sulfonamido group, a cyano group, a hydroxyl group or a halogen atom.
(19) It is preferable that the sum of b1 and b2 in the general formula (IV) is 1 to 4.
(20) It is preferable that b1 is 0 or 1 and that b2 is 1 or 2 in the general formula (IV).
(21) It is preferable that R₁ and R₂ in the general formula (IV) are independently a carboxyl group or a phosphonyl group.
(22) It is preferable that c1 is an integer of 0 to 2 and that c2 is an integer of 1 to 4 in the general formula (IV).
(23) It is preferable that the sum of c1 and c2 is 1 to 6, and R₃ and R₄ independently represent an alkyl group, an alkenyl group, a cycloalkyl group, an alkoxy group, an aryloxy group, an acylamino group, an amino group, a hydroxyl group or an alkynyl group in the general formula (IV).
(24) It is preferable that m3 is 0 or 1, m4 is 1 or 2 and m5 is an integer of 0 to 2, and it is particularly preferable that m3 is 0, m4 is 2 and m5 is 1 or 2, or that m3 is 1, m4 is 1 and m5 is 1 or 2.
(25) It is preferable that the semiconductor particles are titanium oxide particles.

As for the second metal complex dye according to a particularly preferable embodiment of the present invention, in the general formula (II), M₂ is Ru, LL₂ is a bidentate or tridentate ligand represented by any one of the general formulae (V-1) to (V-8), LL₃ is a bidentate ligand represented by the general formula (IV), X₂ represents a monodentate or bidentate ligand which coordinates to M₂ via one or two groups selected from the group consisting of an acyloxy group, an acylthio group, an acylaminooxy group, a thioacyloxy group, a thioacylthio group, a thiocarbonate group, a dithiocarbonate group, a trithiocarbonate group, an alkylthio group, an arylthio group, an alkoxy group, an aryloxy group, a thiocarbamate group, a dithiocarbamate group, an acyl group, a thiocyanate group, an isothiocyanate group, a cyanate group, an isocyanate group and a cyano group, or a monodentate or bidentate ligand selected from the group consisting of ketones, carbonamides, thiocarbonamides, thioureas, isothioureas, halogen atoms and carbonyl, m3 is 0 or 1, m4 represents 1 or 2, LL₃'s may be the same or different ligands when m4 is 2, m5 represents an integer of 0 to 2, X₂'s may be the same or different ligands that may be bonded together when m5 is 2, at least one of m3 and m5 is not 0, and CI₂ represents a counter ion optionally contained to neutralize charge of the metal complex dye.

### BRIEF DESCRIPTION OF THE DRAWINGS

Fig. 1 is a partial cross sectional view showing a preferable structure of a photoelectric conversion device of the present invention,
Fig. 2 is a partial cross sectional view showing a preferable structure of a photoelectric conversion device of the present invention,
Fig. 3 is a partial cross sectional view showing a preferable structure of a photoelectric conversion device of the present invention,
Fig. 4 is a partial cross sectional view showing a preferable structure of a photoelectric conversion device of the present invention,
Fig. 5 is a partial cross sectional view showing a preferable structure of a photoelectric conversion device of the present invention,
Fig. 6 is a partial cross sectional view showing a preferable structure of a photoelectric conversion device of the present invention,
Fig. 7 is a partial cross sectional view showing a preferable structure of a photoelectric conversion device of the present invention,
Fig. 8 is a partial cross sectional view showing a preferable structure of a photoelectric conversion device of the present invention,
Fig. 9 is a partial cross sectional view showing a preferable structure of a photoelectric conversion device of the present invention, and
Fig. 10 is a partial cross sectional view showing an example of a structure of a substrate-integrated type solar cell module comprising a metal complex dye of the present invention.

### DETAILED DESCRIPTION OF THE PREFERRED EMBODIMENTS

### [1] Metal complex dye

### (A) The first metal complex dye

The first metal complex dye for use in the first photoelectric conversion device of the present invention is represented by the following general formula (I).

M₁(LL₁)m1(X₁)m2 • Cl₁ (l)

Constitutional components of the dye will be described in detail below.

### (1) Metal atom M₁

M₁ represents a metal atom. M₁ is preferably a metal atom that is able to form four- or six-coordinated complex, more preferably Ru, Fe, Os, Cu, W, Cr, Mo, Ni, Pd, Pt, Co, Ir, Rh, Mn or Zn, particularly preferably Ru, Fe, Os or Cu, most preferably Ru.

### (2) Ligand LL₁

LL₁represents a bidentate or tridentate ligand represented by the following general formula (III). 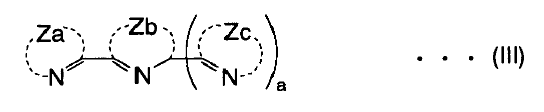 m1 indicating the number of LL₁ is 1 or 2. When m1 is 2, LL₁'s may be the same or different ligands, are preferably the same ligands. When LL₁ is a tridentate ligand, m1 is preferably 1. In the case where LL₁ is a bidentate ligand, it is preferable that m1 is 1 when M₁ is Cu, Pd, Pt or the like and that m1 is 2 when M₁ is another metal.

In the general formula (III), Za, Zb and Zc independently represent nonmetallic atoms forming a 5- or 6-membered ring. The 5- or 6-membered ring may be substituted or unsubstituted ring that may be a monocyclic or a condensed ring. Za, Zb and Zc are preferably composed of carbon, hydrogen, nitrogen, oxygen, sulfur, phosphorus and/or halogen atoms, respectively. They preferably form an aromatic ring. As for the aromatic ring, such rings as an imidazole ring, an oxazole ring, a thiazole ring and a triazole ring are preferred as a 5-membered ring, and such rings as a pyridine ring, a pyrimidine ring, a pyridazine ring and a pyrazine ring are preferred as a 6-membered ring. Of these rings, more preferred are an imidazole ring and a pyridine ring, and most preferred is a pyridine ring.

In the general formula (III), *a* represents 0 or 1. *a* is preferably 0, that is, LL₁ is preferably a bidentate ligand.

It is preferable that LL₁ represents a bidentate or tridentate ligand represented by any one of the following general formulae (V-1) to (V-8). 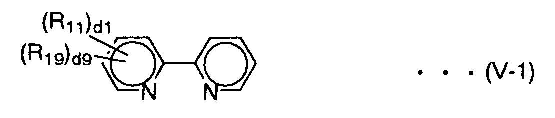 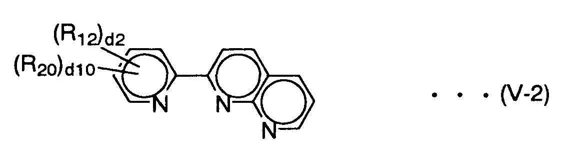 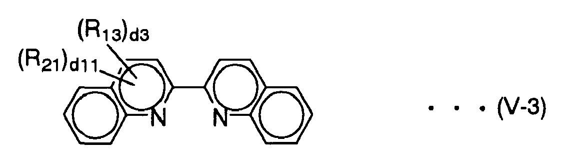 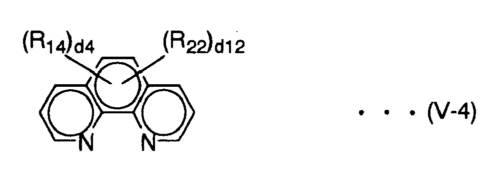 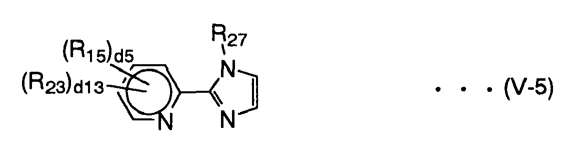 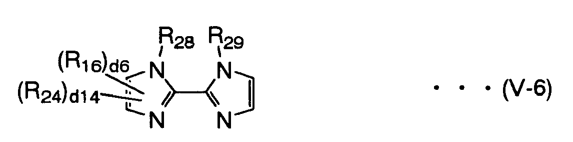 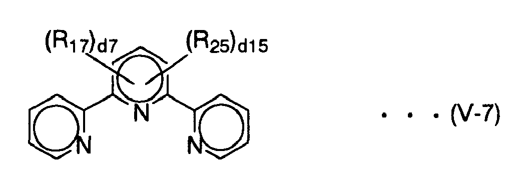 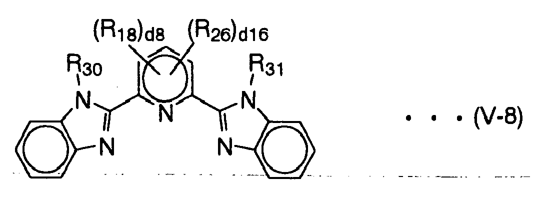 LL₁ is more preferably represented by any one of the general formulae (V-1) to (V-6), particularly preferably represented by the general formulae (V-1), (V-3) or (V-6).

In the general formulae (V-1) to (V-8), R₁₁ to R₁₈ independently represent a carboxyl group, a sulfonic acid group, a hydroxyl group, a hydroxamic acid group preferably having 1 to 20 carbon atoms such as - CONHOH, -CONCH₃OH, etc., a phosphoryl group such as -OP(O)(OH)₂, etc. or a phosphonyl group such as -P(O)(OH)₂, etc. Of these groups, preferred are a carboxyl group, a phosphonyl group and a phosphoryl group, more preferred are a carboxyl group and a phosphonyl group, and the most preferred is a carboxyl group.

In the general formulae (V-1) to (V-8), R₁₉ to R₂₆ independently represent a substituent. Preferred examples thereof include an alkyl group preferably having 1 to 20 carbon atoms such as a methyl group, an ethyl group, an isopropyl group, a t-butyl group, a pentyl group, a heptyl group, a 1-ethylpentyl group, a benzyl group, a 2-ethoxyethyl group, a 1-carboxymethyl group, etc., an alkenyl group preferably having 2 to 20 carbon atoms such as a vinyl group, an allyl group, an oleyl group, etc., a cycloalkyl group preferably having 3 to 20 carbon atoms such as a cyclopropyl group, a cyclopentyl group, a cyclohexyl group, a 4-methylcyclohexyl group, etc., an aryl group preferably having 6 to 26 carbon atoms such as a phenyl group, a 1-naphthyl group, a 4-methoxyphenyl group, a 2-chlorophenyl group, a 3-methylphenyl group, etc., a heterocyclic group preferably having 2 to 20 carbon atoms such as a 4-pyridyl group, a 1-imidazolyl group, a 2-benzoimidazolyl group, a 2-thiazolyl group, a 2-oxazolyl group, etc., an alkoxy group preferably having 1 to 20 carbon atoms such as a methoxy group, an ethoxy group, an isopropyloxy group, a benzyloxy group, etc., an aryloxy group preferably having 6 to 26 carbon atoms such as a phenoxy group, a 1-naphthyloxy group, a 2-naphthyloxy group, a 4-methoxyphenoxy group, a 3-methylphenoxy group, etc., an acyloxy group preferably having 1 to 20 carbon atoms such as an acetyloxy group, a benzoyloxy group, etc., an alkoxycarbonyl group preferably having 2 to 20 carbon atoms such as an ethoxycarbonyl group, a 2-ethylhexyloxycarbonyl group, etc., a carbamoyl group preferably having 1 to 20 carbon atoms such as an N,N-dimethylcarbamoyl group, an N-phenylcarbamoyl group, etc., an acylamino group preferably having 1 to 20 carbon atoms such as an acetylamino group, a benzoylamino group, etc., an amino group preferably having 0 to 20 carbon atoms such as an amino group, an N,N-dimethylamino group, an N,N-diethylamino group, an N-ethylamino group, an anilino group, etc., an acyl group preferably having 1 to 20 carbon atoms such as an acetyl group, a benzoyl group, etc., a sulfonamido group preferably having 0 to 20 carbon atoms such as an N,N-dimethylsulfonamido group, an N-phenylsulfonamido group, etc., a cyano group, a hydroxyl group, or a halogen atom such as a fluorine atom, a chlorine atom, a bromine atom, an iodine atom, etc. Among them, more preferred are an alkyl group, an alkenyl group, an aryl group, a heterocyclic group, an alkoxy group, an alkoxycarbonyl group, an acylamino group, an amino group and a halogen atom, and particularly preferred are an alkyl group, an alkenyl group, an alkoxy group, an alkoxycarbonyl group, an acylamino group and an amino group.

In the general formulae (V-1) to (V-8), R₂₇ to R₃₁ independently represent an alkyl group, an alkenyl group, an aryl group or a hydrogen atom. Preferable examples of these groups are equal to those of R₁₉ to R₂₆. R₂₇ to R₃₁ are preferably a branched alkyl group or an alkyl group having a carboxyl group, independently. Incidentally, when LL₁ contains an alkyl group, an alkenyl group,etc., they may be a substituted or unsubstituted group that may have a straight or branched structure. Further, when LL₁contains an aryl group, a heterocyclic group, etc., they may be a substituted or unsubstituted group that may have a monocyclic or condensed ring structure.

R₁₁ to R₂₆ may be bonded to any carbon atom forming a ring. d1 to d8, d13, d14 and d16 independently represent an integer of 0 to 4, and d9 to d12 and d15 independently represent an integer of 0 to 6. d1to d5 are preferably 1 or 2, more preferably 2. d6 is preferably an integer of 0 to 2, d7 is preferably an integer of 1 to 3, and d8 is preferably an integer of 0 to 3. Further, d9 to d16 are preferably an integer of 0 to 2.

When d1 to d8 are 2 or more, R₁₁ to R₁₈ may be the same or different group, respectively. When d9 to d16 are 2 or more, R₁₉ to R₂₆ may be the same or different groups that may be bonded together to form a ring, respectively. It is particularly preferable that R₁₉'s, R₂₀'s, R₂₁'s and R₂₅'s are independently an alkyl group or an alkenyl group, and they are bonded together to form a ring when d9, d10, d11 and d15 are 2 or more, respectively.

Specific examples L-1 to L-89 of the ligand LL₁ will be illustrated below without intention of restricting the scope of the present invention defined by the claims attached hereto.

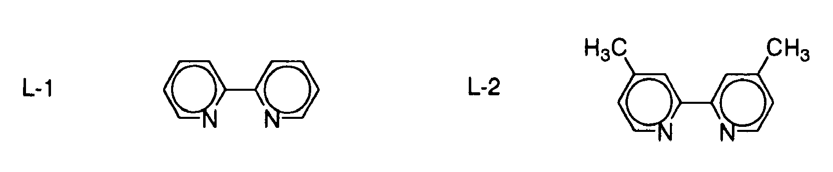

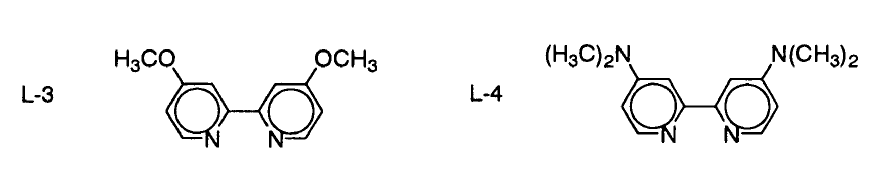

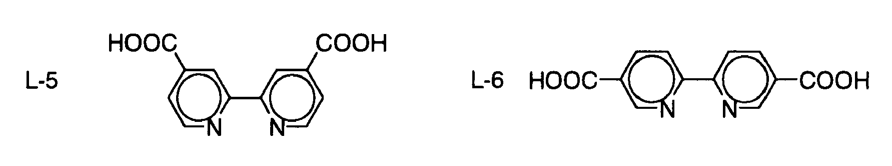

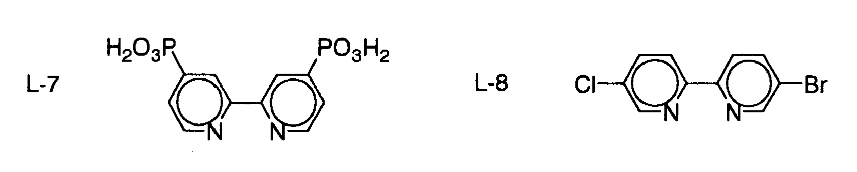

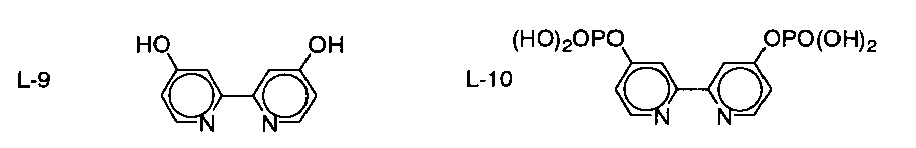

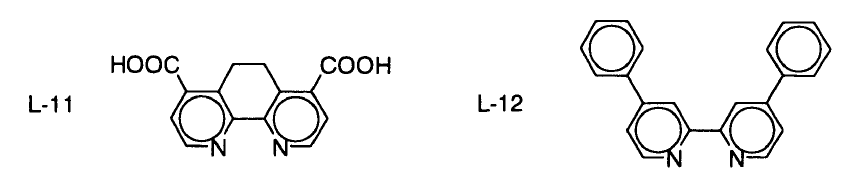

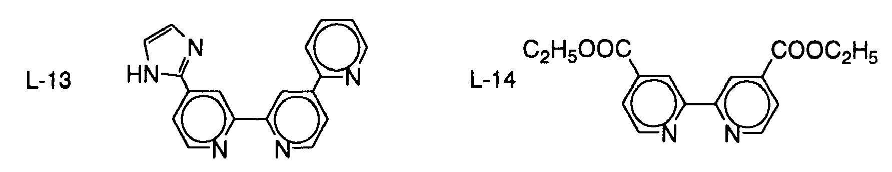

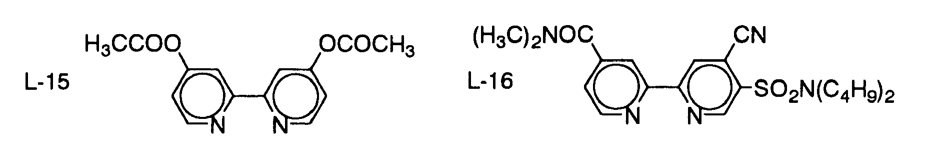

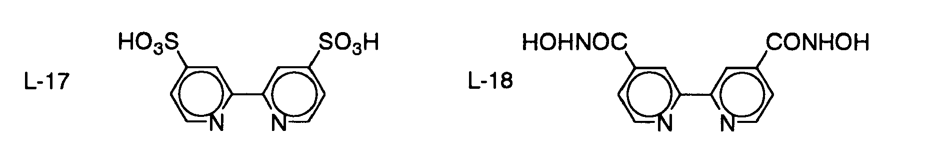

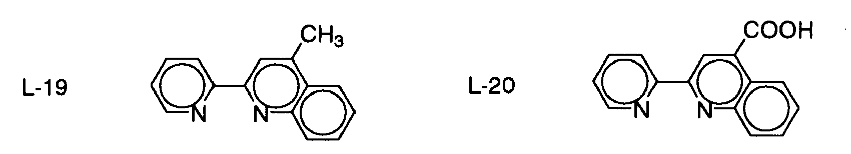

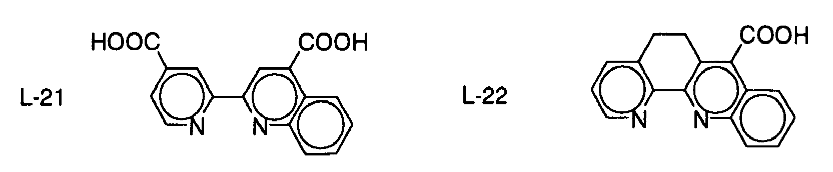

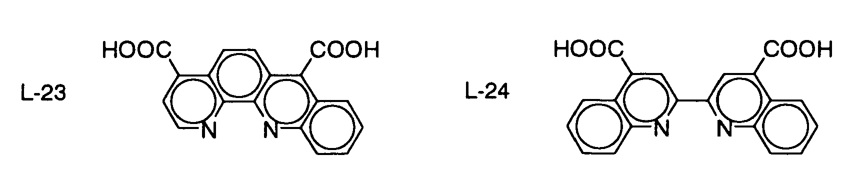

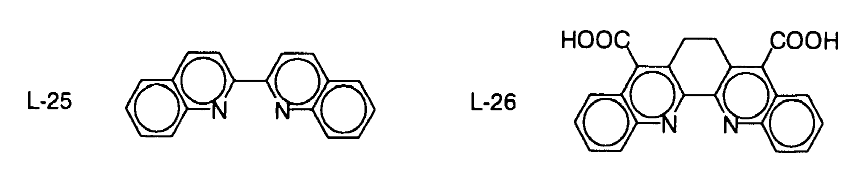

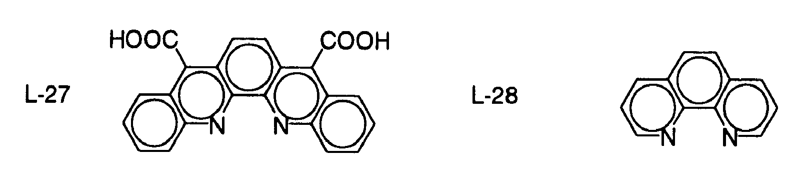

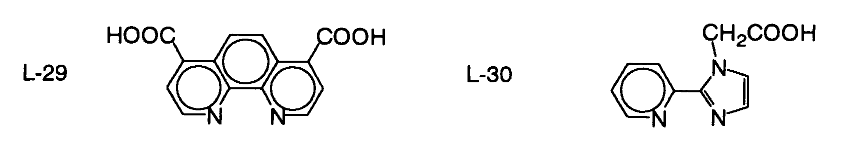

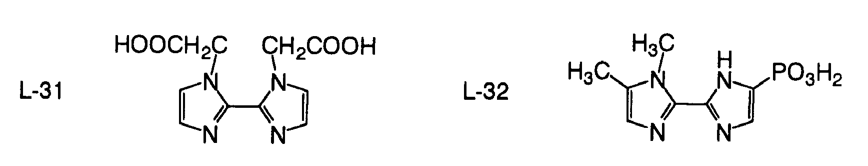

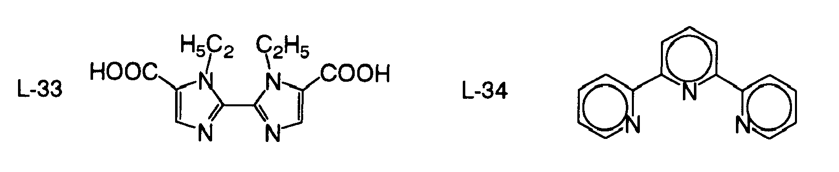

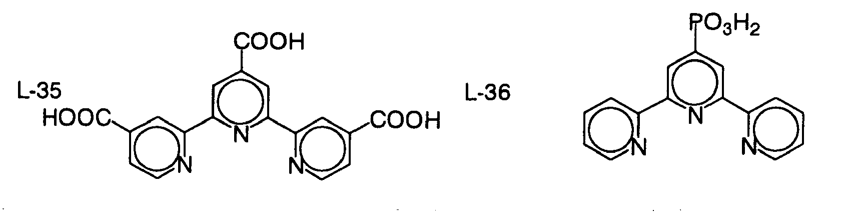

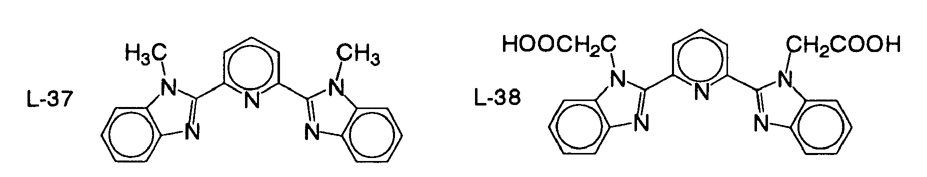

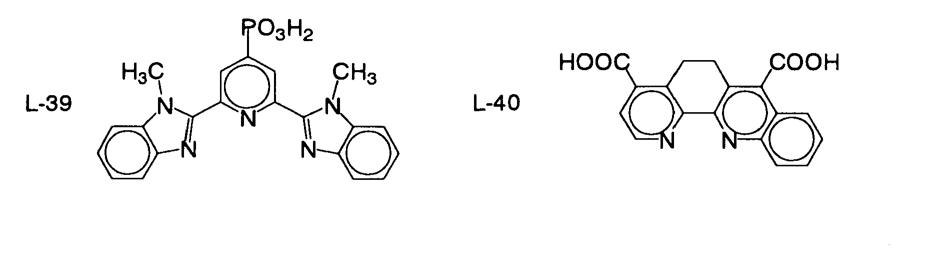

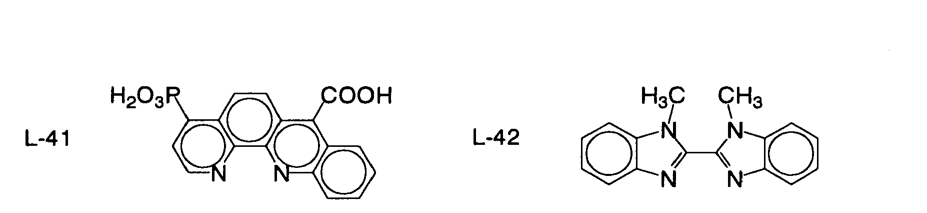

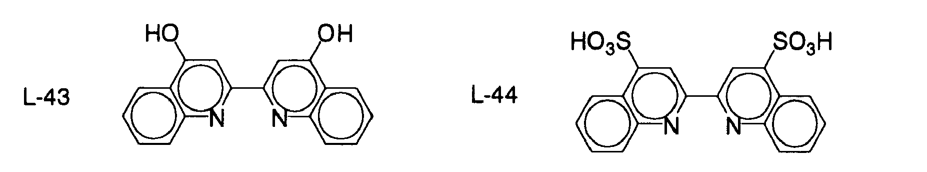

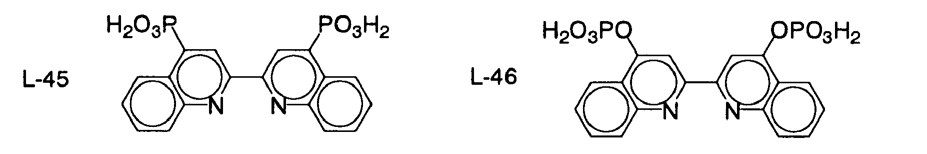

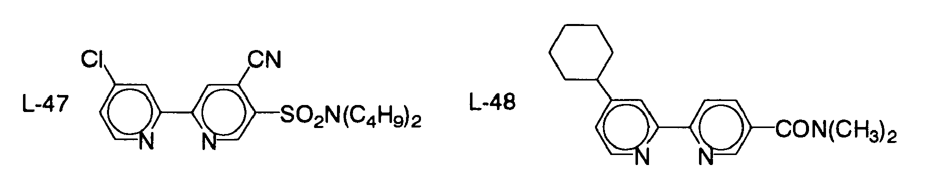

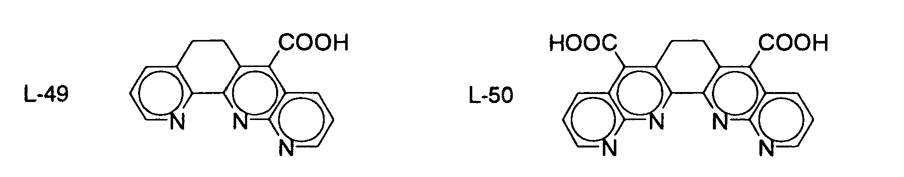

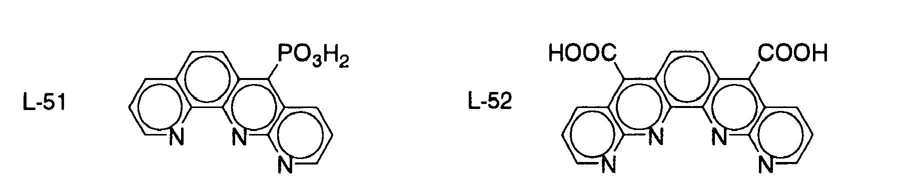

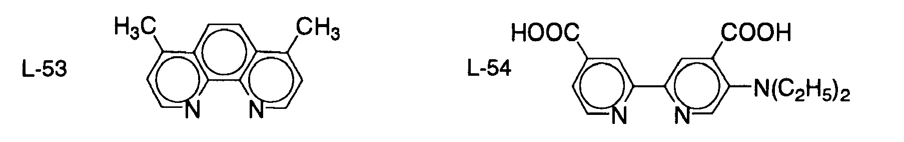

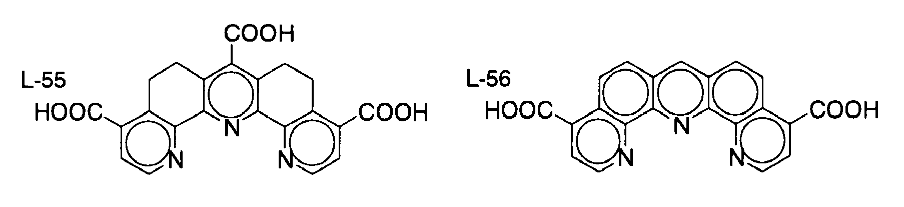

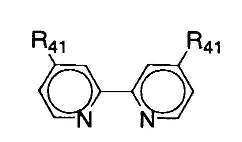

| | R₄₁ |
|---|---|
| L-57 | -OC₂H₅ |
| L-58 | -N(C₄H₉)₂ |
| L-59 | - Br |

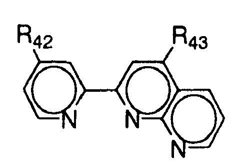

| | R₄₂ | R₄₃ |
|---|---|---|
| L-60 | H | -CH₃ |
| L-61 | H | -COOH |
| L-62 | -COOH | -COOH |
| L-63 | H | —PO₃H₂ |

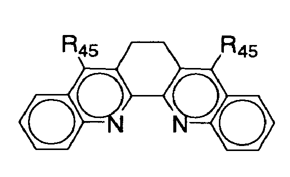

| | R₄₅ |
|---|---|
| L-64 | H |
| L-65 | —CH₃ |

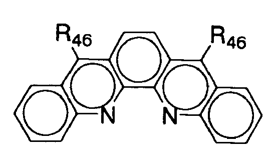

| | R₄₆ |
|---|---|
| L-66 | H |
| L-67 | ―CH₃ |
| L-68 | ―P0₃H₂ |

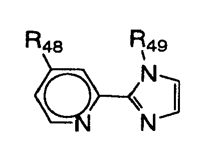

| | R₄₈ | R₄₉ |
|---|---|---|
| L-69 | H | —CH₃ |
| L-70 | —COOH | —CH₂COOH |

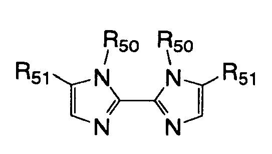

| | R₅₀ | R₅₁ |
|---|---|---|
| L-71 | H | H |
| L-72 | —CH₃ | H |
| L-73 | H | —COOH |
| L-74 | ―(CH₂)₂P0₃H₂ | H |

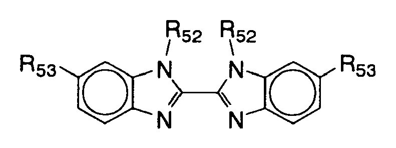

| | R₅₂ | R₅₃ |
|---|---|---|
| L-75 | H | H |
| L-76 | —C₄H₉ | —COOH |
| L-77 | —CH₂COOH | H |
| L-78 | —CH₂PO₃H₂ | H |

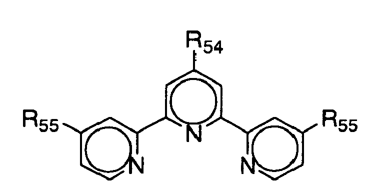

| | R₅₄ | R₅₅ |
|---|---|---|
| L-79 | —CH₃ | ―CH₃ |
| L-80 | 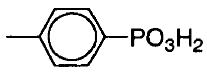 | H |
| L-81 | —OH | —OH |
| L-82 | —OPO₃H₂ | —OPO₃H₂ |
| L-83 | —COOH | ―OC₄H₉ |

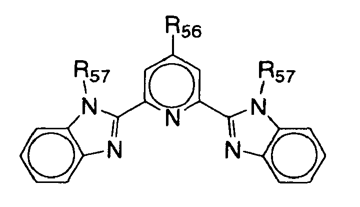

| | R₅₆ | R57 |
|---|---|---|
| L-84 | —COOH | —CH₂COOH |
| L-85 | 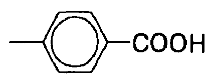 | H |

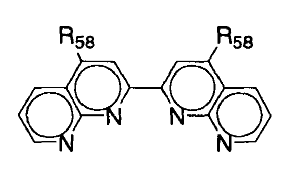

| | R₅₈ |
|---|---|
| L-86 | H |
| L-87 | —CH₃ |
| L-88 | —COOH |
| L-89 | ―P0₃H₂ |

### (3) Ligand X₁

In the general formula (I), X₁ represents a monodentate or bidentate ligand which coordinates to M₁ via one or two groups selected from the group consisting of an acyloxy group preferably having 1 to 20 carbon atoms such as an acetyloxy group, a benzoyloxy group, a glycyloxy group, an N,N-dimethylglycyloxy group, a salicyloyloxy group, a oxalylene group (-OC(O)C(O)O-), etc., an acylthio group preferably having 1 to 20 carbon atoms such as an acetylthio group, a benzoylthio group, etc., an acylaminooxy group preferably having 1 to 20 carbon atoms such as an N-methylbenzoylaminooxy group (PhC(O)N(CH₃)O-), an acetylaminooxy group (CH₃C(O)NHO-), etc., a thioacyloxy group preferably having 1 to 20 carbon atoms such as a thioacetyloxy group (CH₃C(S)O-), etc., a thioacylthio group preferably having 1 to 20 carbon atoms such as a thioacetylthio group (CH₃C(S)S-), a thiobezoylthio group (PhC(S)S-), etc., a thiocarbonate group preferably having 1 to 20 carbon atoms such as ethylthiocarbonate, etc., a dithiocarbonate group preferably having 1 to 20 such as an ethyldithiocarbonate group (C₂HₛOC(S)S-), a phenydithiocarbonate group (PhOC(S)S-), etc., a trithiocarbonate group preferably having 1 to 20 carbon atoms such as an ethyltrithiocarbonate group (C₂H₅SC(S)S-), a phenyltrithiocarbonate group (PhSC(S)S-), etc., an alkylthio group preferably having 1 to 20 carbon atoms such as a methylthio group, an ethylenedithio group, etc., an arylthio group preferably having 6 to 20 carbon atoms such as a phenylthio group, a 1,2-phenylenedithio group, etc., an alkoxy group preferably having 1 to 20 carbon atoms such as a methoxy group, an ethylenedioxy group, etc., and an aryloxy group preferably having 6 to 20 carbon atoms such as a phenoxy group, a 1,2-benzenedioxy group, an 8-quinolyloxy group, etc., or a monodentate or bidentate ligand selected from the group consisting of ketones preferably being dialkylketones or 1,3-diketones preferably having 3 to 20 carbon atoms such as dimethylketone ((CH₃)₂CO...), acetylacetone (CH₃C(O-)=CH-C(O...)CH₃), trifluoroacetylacetone (CF₃C(O-)=CH-C(O ...)CH₃), dipivaloylmethane (t-C₄H₉C(O-)=CH-C(O...)-t-C₄H₉), dibenzoylmethane (PhC(O-)=CH-C(O...)Ph), 3-chloroacetylacetone (CH₃C(O-)=CCI-C(O...)CH₃), etc., carbonamides preferably having 1 to 20 carbon atoms such as CH₃N=C(CH₃)O-, -OC(=NH)-C(=NH)0-, etc., thiocarbonamides preferably having 1 to 20 carbon atoms such as CH₃N=C(CH₃)S-, etc., thioureas preferably having 1 to 20 atoms such as ··· NH₂-C(S···)NH₂, ···N(CH₃)₂-C(S···)N(CH₃)₂, etc., and isothioureas preferably having 1 to 20 carbon atoms such as ··· NH=C(S-)NH₂, ··· N(CH₃)=C(S-)NHCH₃, etc. Incidentally, ··· indicates a coordinate bond. m2 indicating the number of X₁ is an integer of 1 to 3. When m2 is 2 or 3, X₁'s may be the same or different ligands that may be bonded together.

X₁ is preferably a monodentate or bidentate ligand which coordinates to M₁ via one or two groups selected from the group consisting of an acyloxy group, an acylaminooxy group, an alkylthio group, an arylthio group, an alkoxy group and an aryloxy group, or a monodentate or bidentate ligand selected from the group consisting of ketones, thiocarbonamides, thioureas and isothioureas, more preferably a ligand which coordinates to M₁ via one or two groups selected from the group consisting of an acyloxy group, an acylaminooxy group, an alkylthio group and an arylthio group, or a 1,3-diketone, particularly preferably a ligand which coordinates to M₁ via an acyloxy group or an acylaminooxy group, or a 1,3-diketone.

When X₁ contains an alkyl group, an alkenyl group, an alkynyl group, an alkylene group, etc., they may be a substituted or unsubstituted group that has a straight or branched structure. When X₁ contains an aryl group, a heterocyclic group, a cycloalkyl group, etc., they may be a substituted or unsubstituted group that may have a monocyclic or condensed ring structure.

X₁ is preferably a bidentate ligand, more preferably a bidentate ligand represented by any one of the following general formulae (VI-1) to (VI-5). 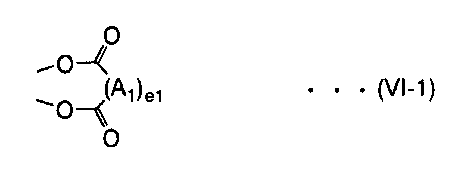 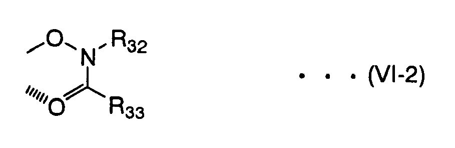 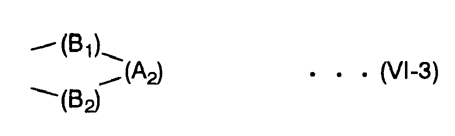 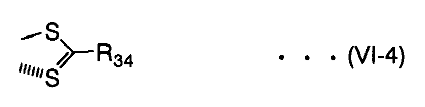 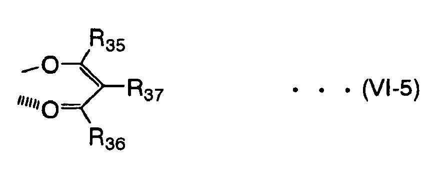 X₁ is furthermore preferably represented by any one of the general formulae (VI-1) to (VI-3) and (VI-5), particularly preferably represented by the general formulae (VI-1), (VI-2) or (VI-5), most preferably represented by the general formula (VI-5).

In general formula (VI-1), A₁ represents a bidentate linking group. A₁ is preferably a bidentate linking group having 0 to 20 carbon atoms such as a methylene group, an ethylene group, a buthylene group, a 1-octylmethylene group, a 1,2-phenylene group, -NH-, etc., more preferably a linking group having 1 to 4 carbon atoms. Among them, A₁ is particularly preferably a methylene group or an ethylene group. e1 is 0 or 1, preferably 0. When e1 is 0, the general formula (VI-1) represents an oxalylene group.

In the general formula (VI-2), R₃₂ and R₃₃ independently represent an alkyl group, an alkenyl group, a cycloalkyl group, an aryl group, a heterocyclic group, an alkoxy group, an alkoxycarbonyl group, an amino group, an acyl group or a hydrogen atom. Preferable examples of these groups are the same as those of R₁₉ to R₂₆. R₃₂ is preferably an alkyl group, an alkenyl group, a cycloalkyl group, an aryl group, a heterocyclic group, an alkoxy group or an amino group, more preferably an alkyl group or an aryl group. R₃₃ is preferably an alkyl group, an alkenyl group, an aryl group or a hydrogen atom, more preferably an alkyl group or a hydrogen atom.

In the general formula (VI-3), B₁ and B₂ independently represent an oxygen atom or a sulfur atom. Both of B₁ and B₂ are preferably the same atom, more preferably a sulfur atom. A₂ represents an alkylene group preferably having 1 to 20 carbon atoms such as a methylene group, an ethylene group, a propylene group, a 1-octylethylene group, etc. or an arylene group preferably having 6 to 20 carbon atoms such as a 1,2-phenylene group, a 4-octyloxy-1,2-phenylene group, etc., preferably an ethylene group, a propylene group or a 1,2-phenylene group optionally having substituents.

In the general formula (VI-4), R₃₄ represents any one of an alkyl group, an alkenyl group, a cycloalkyl group, an aryl group, a heterocyclic group, an alkoxy group and an aryloxy group with preferable examples being the same as those of R₁₉ to R₂₆, or an alkylthio group preferably having 1 to 20 carbon atoms such as a methylthio group, an isopropylthio group, etc. or an arylthio group preferably having 6 to 20 carbon atoms such as a phenylthio group, a 4-methylphenylthio group, etc. R₃₄ is preferably an alkyl group, an aryl group, an alkoxy group or aryloxy group, more preferably an alkoxy group or an aryloxy group, particularly preferably an alkoxy group.

In the general formula (VI-5), R₃₅ and R₃₆ independently represent any one of an alkenyl group, a cycloalkyl group, an aryl group, an alkoxy group and an amino group with preferable examples being the same as those of R₁₉ to R₂₆, or a hydrogen atom, an alkyl group preferably having 1 to 20 carbon atoms such as a methyl group, an ethyl group, a t-butyl group, a chloromethyl group, a trifluoromethyl group, a benzyl group, etc. or a heterocyclic group preferably having 1 to 20 carbon atoms such as a 2-thienyl group, a 3-thienyl group, a 2-pyrrolyl group, a 2-furanyl group, a 4-pyridyl group, a 2-imidazolyl group, etc. R₃₅ and R₃₆ preferably represent an aryl group, an alkyl group or a heterocyclic group, more preferably a phenyl group, a methyl group, a t-butyl group, a trifluoromethyl group or a 2-thienyl group, particularly preferably a methyl group, a t-butyl group or a trifluoromethyl group, respectively. It is most preferable that both R₃₄ and R₃₅ are a methyl group or a t-butyl group, or that R₃₄ is a trifluoromethyl group and R₃₅ is a methyl group.

In the general formula (VI-5), R₃₇ represents any one of an alkyl group, an alkenyl group, an aryl group and a halogen atom with preferable examples being the same as those of R₁₉ to R₂₆, or a hydrogen atom. R₃₇ preferably represents an alkyl group, a halogen atom or a hydrogen atom, more preferably an alkyl group or a hydrogen atom, and particularly preferably a hydrogen atom.

Specific examples X-1 to X-92 of the ligand X₁ will be illustrated below without intention of restricting the scope of the present invention defined by the claims attached hereto. Incidentally, chemical formulae shown below are just a limiting structure of possible resonance structures, and distinction between a covalent bond represented by ― and a coordinating bond represented by ••• is also just formal and therefore these bonds do not mean an absolute distinction.

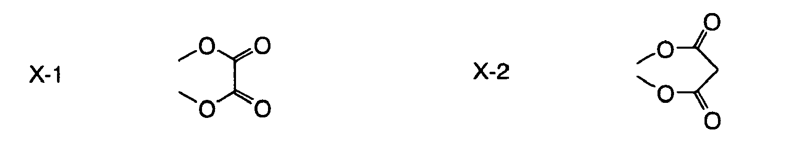

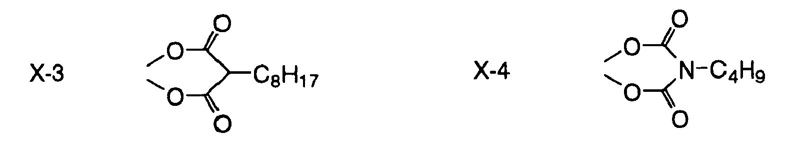

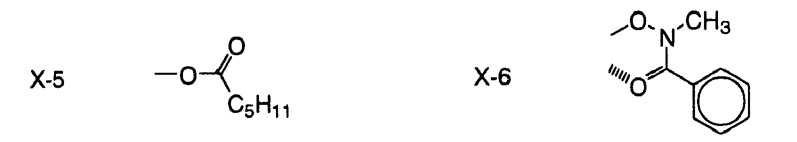

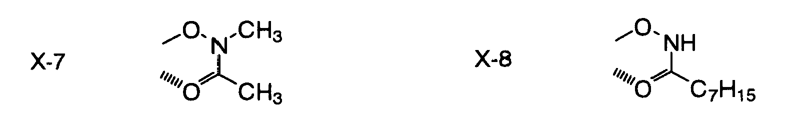

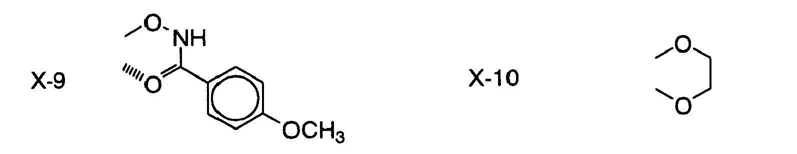

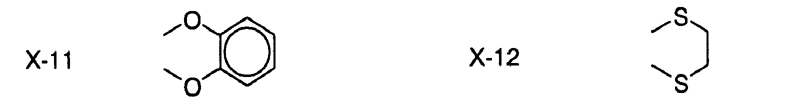

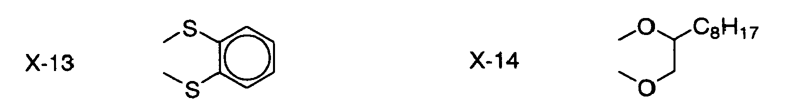

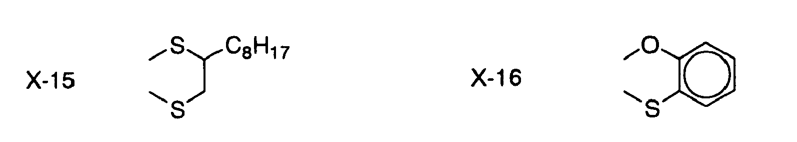

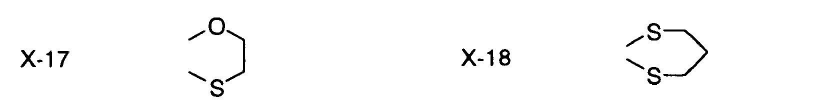

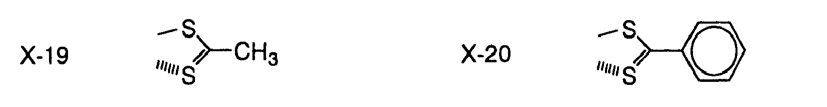

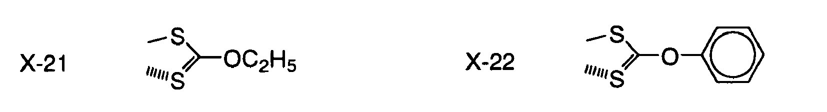

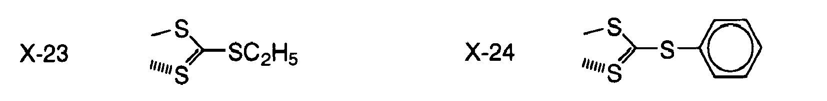

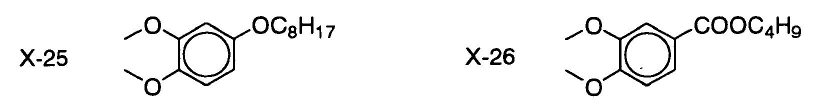

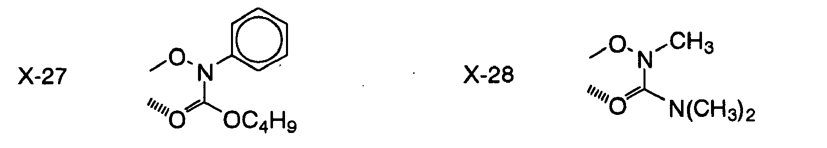

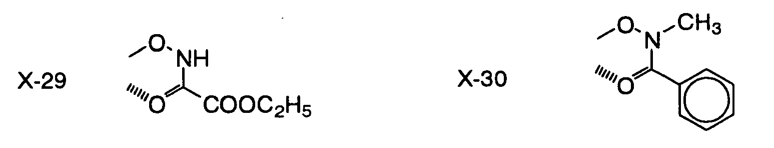

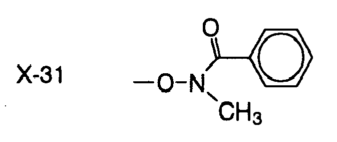

**X-32** -OCH₃

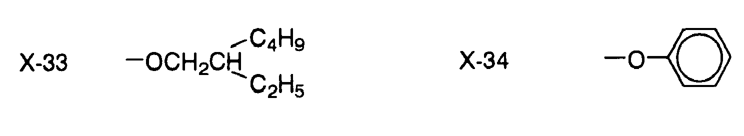

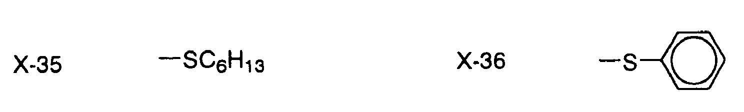

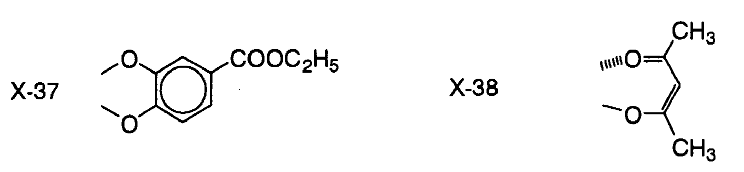

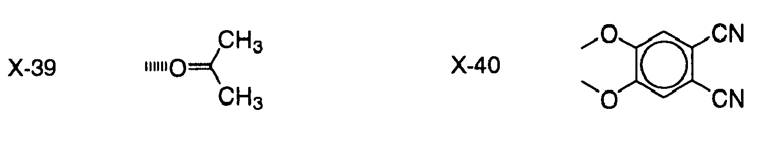

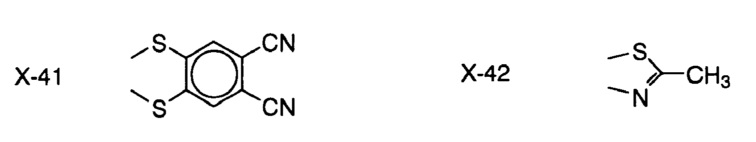

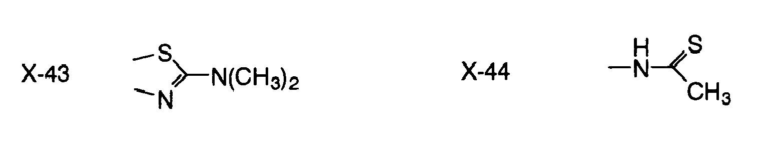

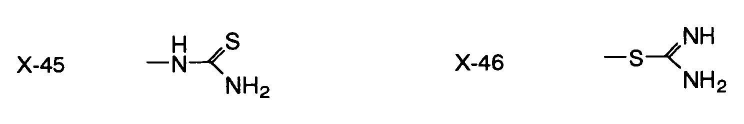

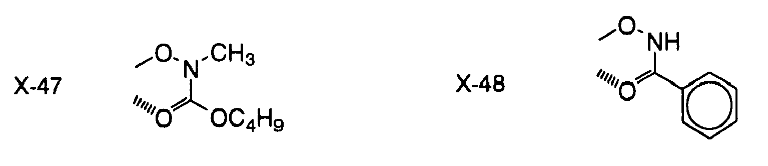

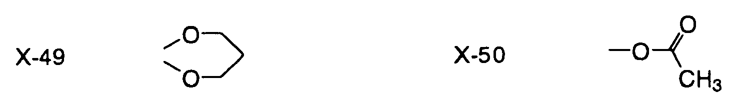

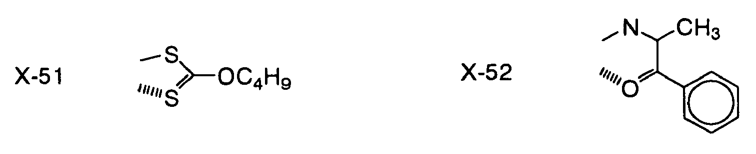

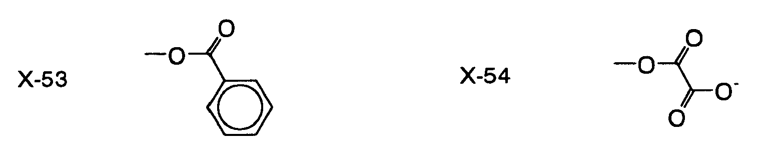

**X-55** -O(CH₂)₂OH

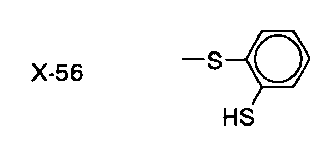

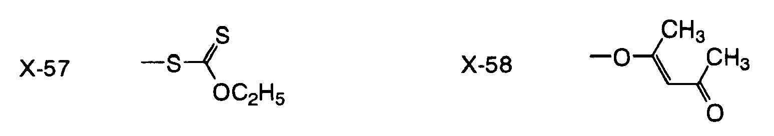

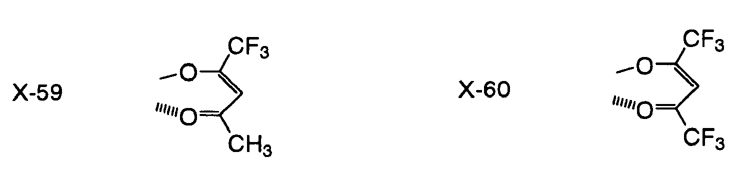

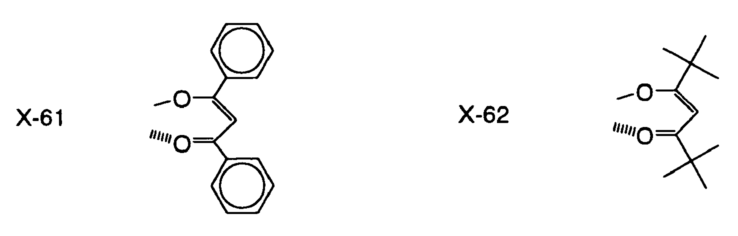

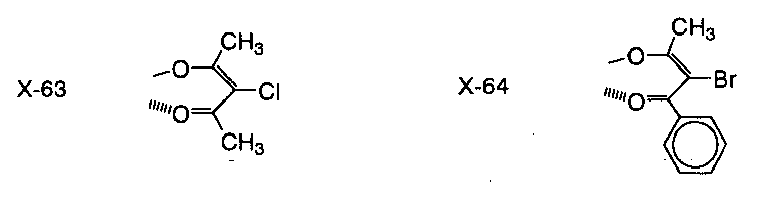

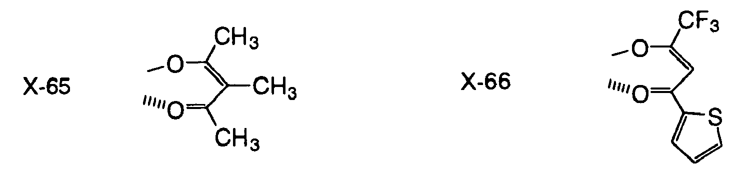

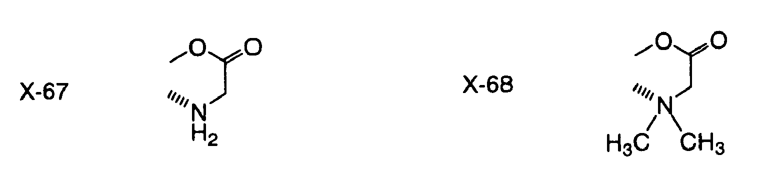

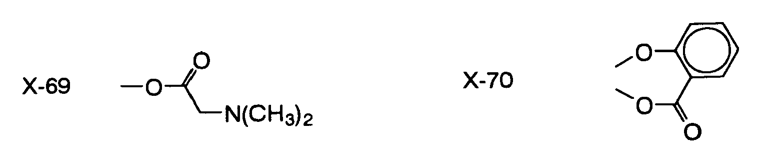

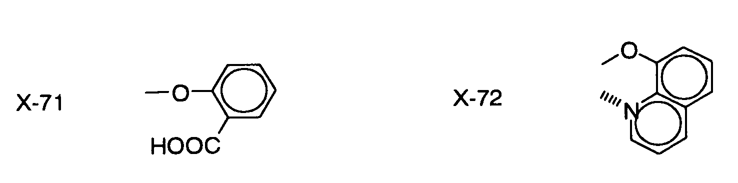

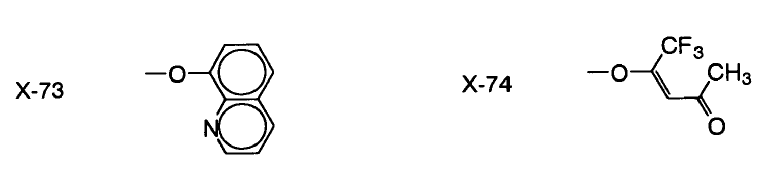

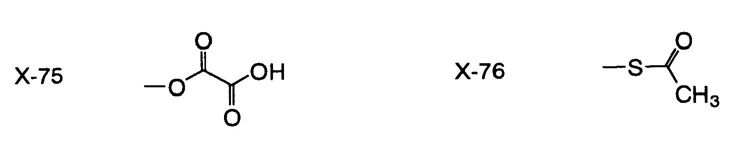

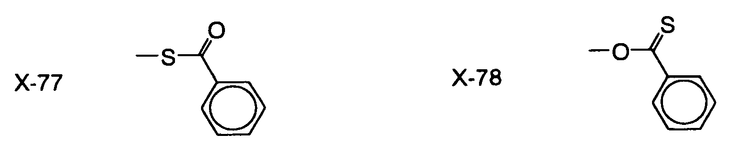

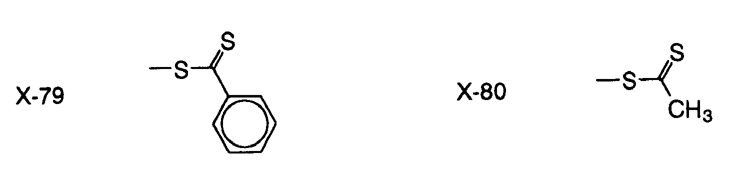

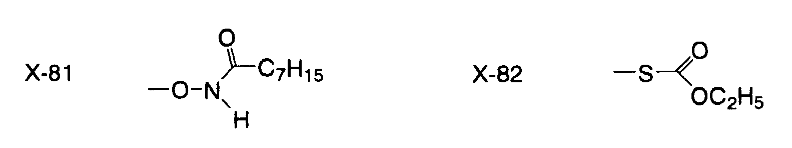

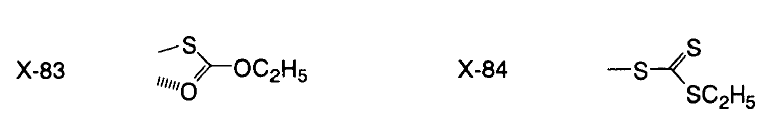

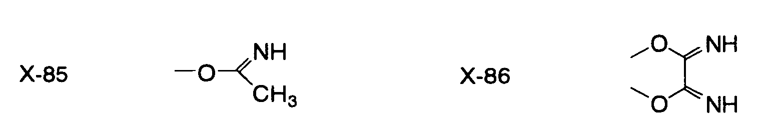

X-87 -SCH₃

X-88 -S(CH₂)₂SH

X-89 -S(CH₂)₃SH

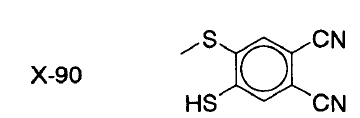

X-91 —O(CH₂)₃OH

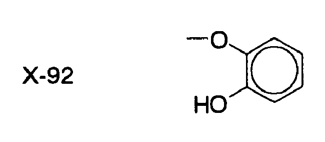

### (4) Counter ion CI₁

CI₁ represents a counter ion optionally contained in the metal complex dye to neutralize charge thereof. Whether the metal complex dye is a cation or an anion and whether the dye has the net ionic charge or not depends on a metal atom, ligands and substituents therein. When a substituent has a dissociative group, it may dissociate the group to have charge. In this case, the charge of the whole complex is also neutralized by the CI₁.

Typical positive counter ions are inorganic or organic ammonium ions such as a tetraalkyl ammonium ion, a pyridinium ion, etc., proton and alkali metal ions. On the other hand, negative counter ions may be inorganic or organic, and examples thereof include a halide ion such as a fluoride ion, a chloride ion, a bromide ion, an iodide ion, etc., a substituted aryl sulfonate ion such as a p-toluene sulfonate ion, a p-chlorobenzene sulfonate ion, etc., an aryl disulfonate ion such as a 1,3-benzene disulfonate ion, a 1,5-naphthalene disulfonate ion, a 2,6-naphthalene disulfonate ion, etc., an alkyl sulfate ion such as a methyl sulfate ion, etc., a sulfate ion, a thiocyanate ion, a perchlorate ion, a tetrafluoroborate ion, a hexafluorophosphate ion, a picrate ion, an acetate ion, a trifluoromethane sulfonate ion, etc. Further, ionic polymers or other dyes having an opposite charge to the dye may be also used as a charge-balancing counter ion. Alternatively metal complex such as bisbenzene-1,2-dithiolato nickel (III), etc. can be also used in the present invention.

### (5) Interlocking group

The dye represented by the general formula (I) has preferably at least one, more preferably 2 or more interlocking group suitable for the surface of semiconductor particles. Preferable interlocking groups are acidic groups having a dissociative proton such as a carboxyl group (-COOH), a sulfonic acid group (-S0₃H), a hydroxyl group (-OH), a phsphonyl group (-P(O)(OH)₂, etc.), a phosphoryl group (-OP(O)(OH)₂, etc.), a hydroxamic acid group (-CONHOH, etc.), etc.

### (6) Specific examples of the metal complex dye

As for the first metal complex dye according to a particularly preferable embodiment of the present invention, in the general formula (I), M₁ is Ru, LL₁ is a bidentate or tridentate ligand represented by any one of the general formulae (V-1) to (V-8), X₁is a bidentate ligand represented by any one of the general formulae (VI-1) to (VI-5), m1 is 1 or 2, LL₁'s may be the same or different ligands when m1 is 2, m2 represents an integer of 1 to 3, X₁'s may be the same or different ligands that may be bonded together when m2 is 2 or 3, and CI₁ represents a counter ion optionally contained to neutralize charge of the dye.

It is particularly preferable that LL₁ and X₁ are bidentate ligand, m1 being 2 and m2 being 1.

Specific examples D-1 to D-92 of the metal complex dye represented by the general formula (I) will be illustrated below without intention of restricting the scope of the present invention defined by the claims attached hereto. Incidentally, chemical formulae shown below are just a limiting structure of possible resonance structures, and distinction between a covalent bond represented by - and a coordinating bond represented by ... is also just formal and therefore these bonds do not mean an absolute distinction.

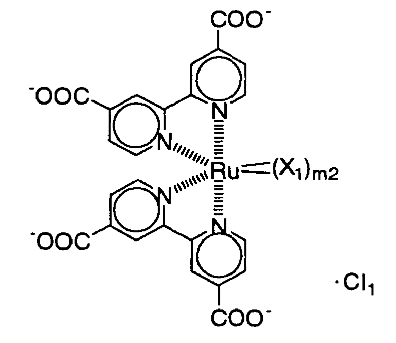

| | (X₁)m₂ | CI₁ |
|---|---|---|
| D-1 | X-1 | (HN⁺Et₃)₄ |
| D-2 | X-6 | (HN⁺Et₃)₃ |
| D-3 | X-7 | (HN⁺Et₃)₃ |
| D-4 | X-40 | (HN⁺Et₃)₄ |
| D-5 | X-13 | (HN⁺Et₃)₄ |
| D-6 | X-19 | (HN⁺Et₃)₃ |
| D-7 | X-21 | (HN⁺Et₃)₃ |
| D-8 | X-23 | (HN⁺Et₃)₃ |

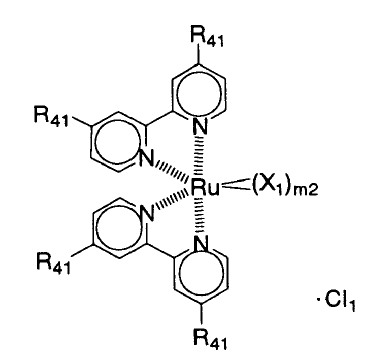

| | R₄₁ | (X₁)m2 | Cl₁ |
|---|---|---|---|
| D-9 | —PO₃H₂ | X-1 | — |
| D-10 | —P0₃H₂+—PO₃H⁻ | X-6 | — |
| D-11 | ―P0₃H₂ | X-13 | — |
| D-12 | ―OP0₃H₂ | X-1 | — |
| D-13 | ―S0₃H +-S0₃⁻ | X-6 | ― |
| D-14 | ―S0₃H | X-40 | — |
| D-15 | —CONHOH | X-1 | — |

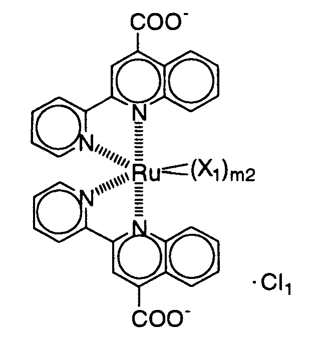

| | (X₁)m₂ | Cl₁ |
|---|---|---|
| D-16 | X-1 | (H⁺)₂ |
| D-17 | X-6 | HN⁺Et₃ |
| D-18 | X-41 | (H⁺)₂ |
| D-19 | X-21 | N^{+*n*}B_{U4} |

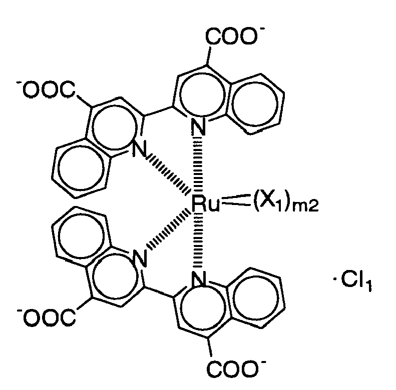

| | (X₁)m2 | Cl₁ |
|---|---|---|
| D-20 | X-1 | (N^{+*n*}BU₄)₄ |
| D-21 | X-30 | (N^{+*n*}BU₄)₃ |
| D-22 | X-13 | (N^{+*n*}BU₄)₄ |

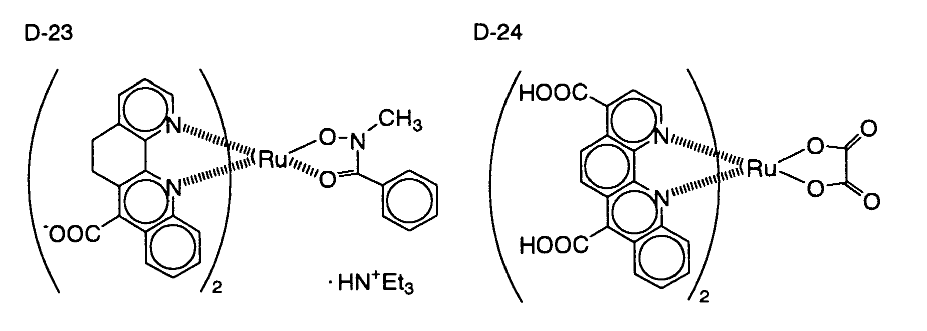

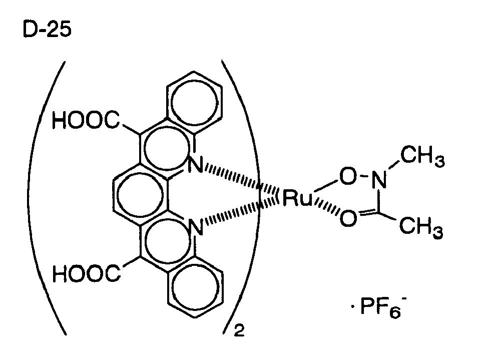

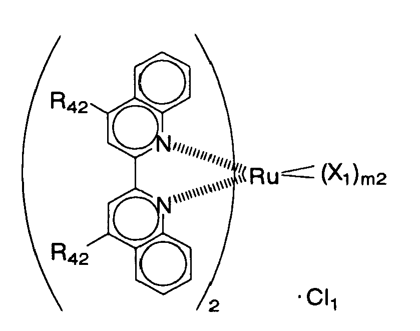

| | R₄₂ | (X₁)m2 | Cl₁ |
|---|---|---|---|
| D-26 | —SO₃H | X-1 — | |
| D-27 | —P0₃H₂ | X-1 | — |
| D-28 | -OC₄H₉ | X-1 — | |
| D-29 | -N(CH₃)₂ | X-6 | PF₆⁻ |

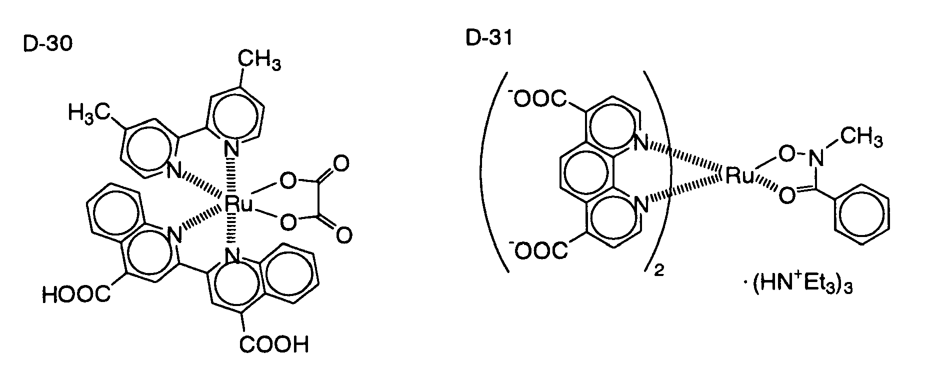

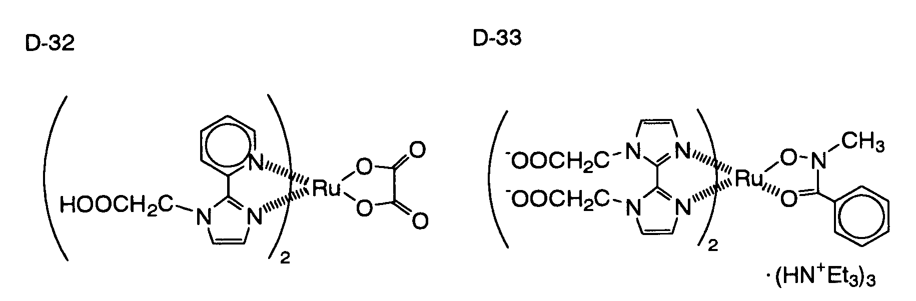

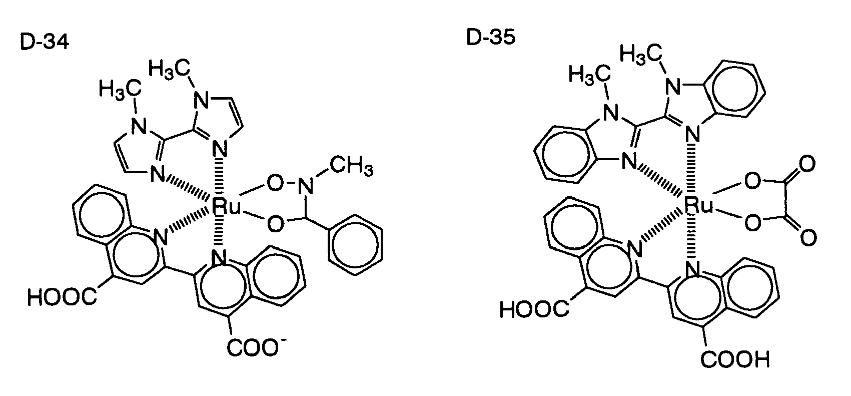

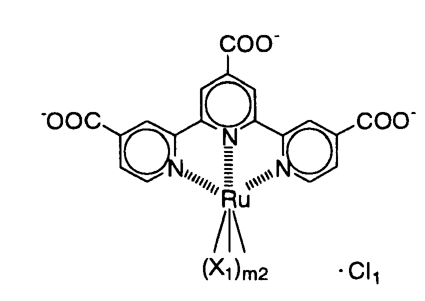

| | (X₁)m2 | Cl1 |
|---|---|---|
| D-36 | X-1 + X-54 | (HN⁺Et₃)₄ |
| D-37 | X-6 + X-31 | (HN⁺Et₃)₃ |

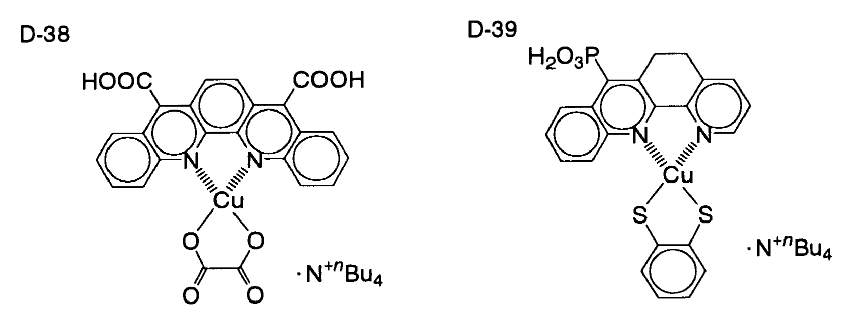

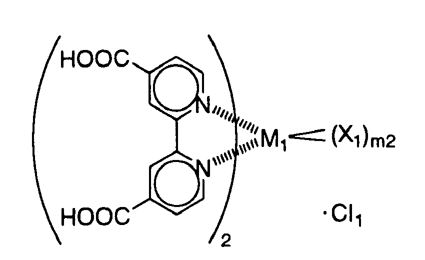

| | M₁ | (X₁)ₘ₂ | Cl₁ |
|---|---|---|---|
| D-40 | Fe | X-1 | (HN⁺Et₃)₄ |
| D-41 | Fe | X-6 | (HN⁺Et₃)₃ |
| D-42 | Fe | X-21 | (HN⁺Et₃)₃ |
| D-43 | Os | X-1 | (HN⁺Et₃)₄ |
| D-44 | Os | X-7 | (HN⁺Et₃)₃ |

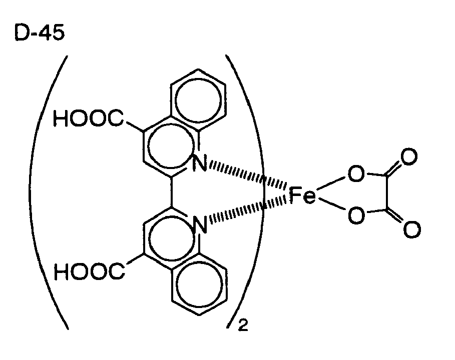

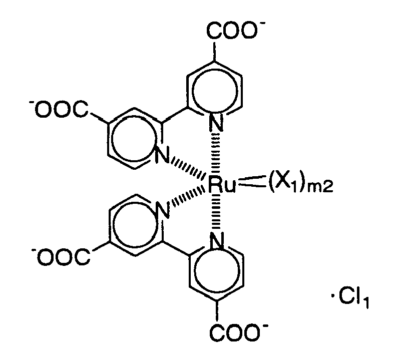

| | (X₁)m₂ | Cl₁ |
|---|---|---|
| D-46 | X-38 | (H⁺)₃ |
| D-47 | X-59 | (H⁺)₃ |
| D-48 | X-61 | (HN⁺Et₃)₃ |
| D-49 | X-62 | (H⁺)₃ |
| D-50 | X-66 | (H⁺)₃ |
| D-51 | X-68 | (H⁺)₃ |
| D-52 | X-70 | (H⁺)₄ |
| D-53 | X-72 | (H⁺)₃ |

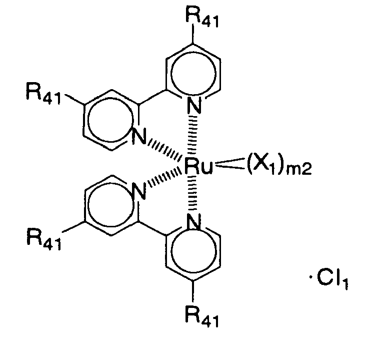

| | R₄₁ | (X₁)m2 | Cl₁ |
|---|---|---|---|
| D-54 | ―P0₃H₂ + ―P0₃H⁻ | X-38 | ― |
| D-55 | ―P0₃H₂ + ―P0₃H⁻ | X-59 | ― |
| D-56 | ―S0₃H + ―S0₃⁻ | X-38 | ― |

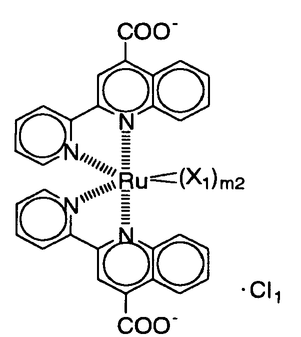

| | (X₁)m2 | Cl₁ |
|---|---|---|
| D-57 | X-38 | H⁺ |
| D-58 | X-59 | H⁺ |
| D-59 | X-68 | H⁺ |
| D-60 | X-70 | (H⁺)₂ |
| D-61 | X-72 | H⁺ |

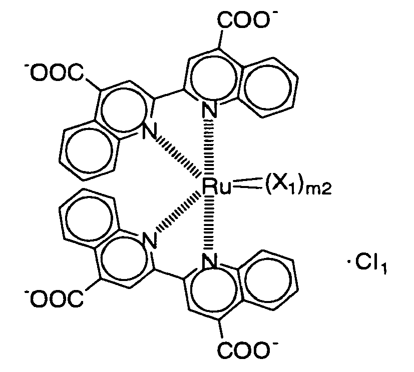

| | (X₁)m2 | Cl₁ |
|---|---|---|
| D-62 | X-38 | (H⁺)₃ |
| D-63 | X-59 | (H⁺)₃ |
| D-64 | X-70 | (N⁺ⁿBU₄)₄ |

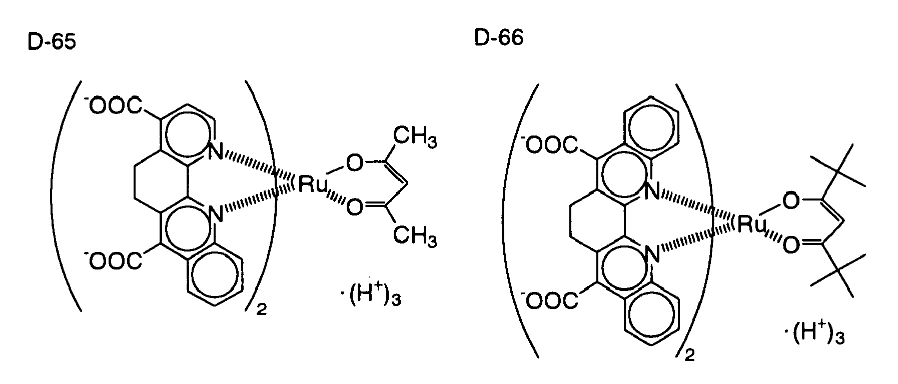

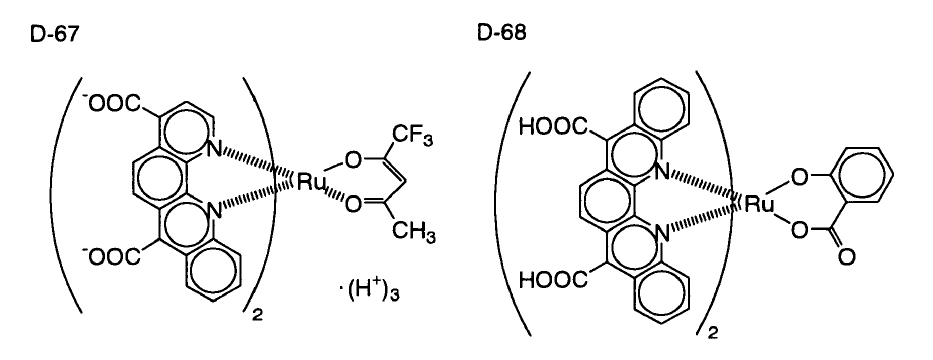

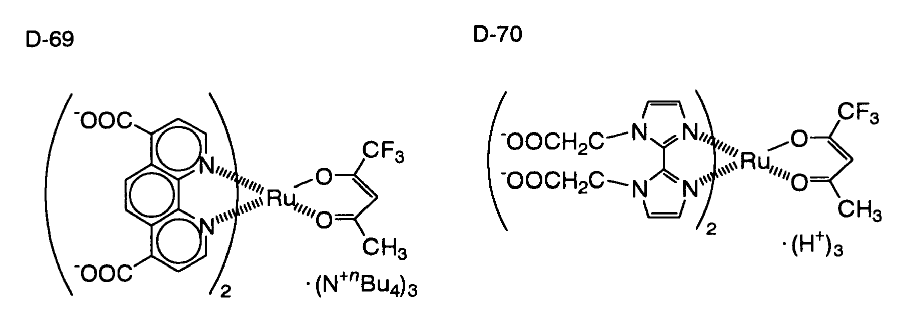

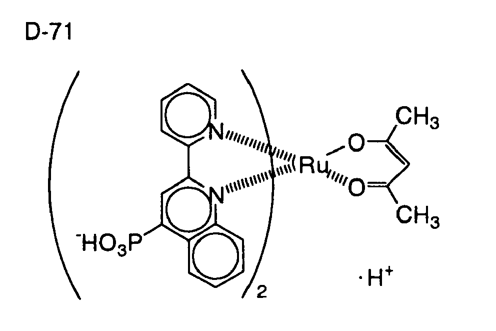

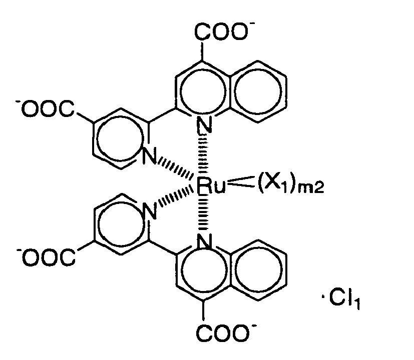

| | (X₁)m2 | Cl₁ |
|---|---|---|
| D-72 | X-38 | (H⁺)₃ |
| D-73 | X-59 | (H⁺)₃ |
| D-74 | X-62 | (N^{+*n*}B_{U4})₃ |
| D-75 | X-65 | (H⁺)₃ |
| D-76 | X-67 | (H⁺)₃ |
| D-77 | X-72 | (H⁺)₃ |
| D-78 | X-38 | (H⁺)₂ |
| D-79 | X-59 | (H⁺)₂ |
| D-80 | X-62 | (H⁺)₂ |
| D-81 | X-70 | (H⁺)₃ |
| D-82 | X-72 | (N^{+*n*}BU₄)₂ |

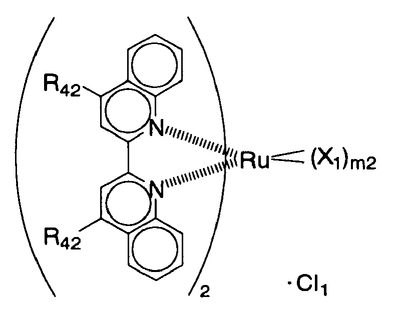

| | R₄₂ | (X₁)m2 | Cl₁ |
|---|---|---|---|
| D-83 | ―P0₃H₂ + ―P0₃H⁻ | X-38 | ― |
| D-84 | ―OP0₃H₂ + ―OP0₃H⁻ | X-38 | ― |

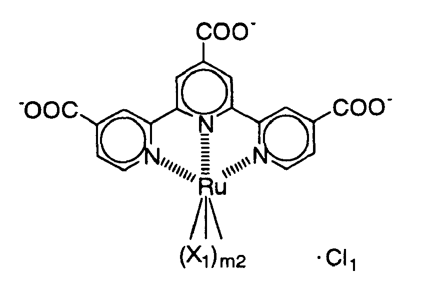

| | (X₁)m₂ | Cl₁ |
|---|---|---|
| D-85 | X-38 + X-58 | (HN⁺Et₃)₃ |
| D-86 | X-59 + X-74 | (HN⁺Et₃)₃ |

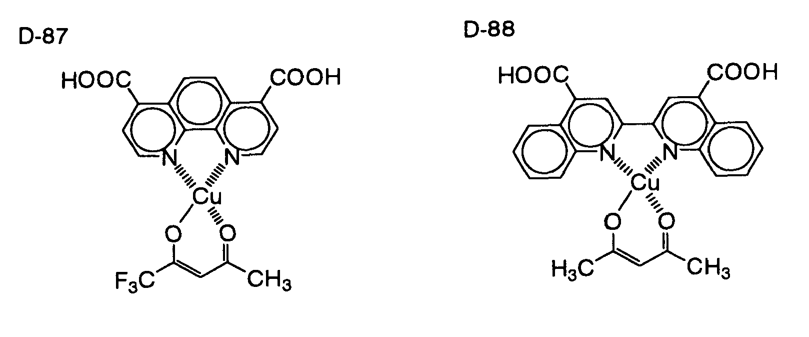

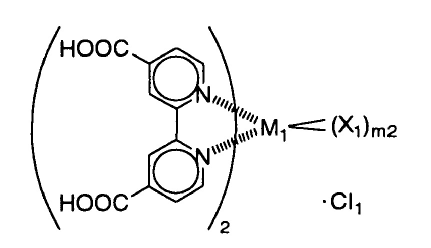

| | M₁ | (X₁)m2 | Cl₁ |
|---|---|---|---|
| D-89 | Fe | X-38 | (H⁺)₃ |
| D-90 | Fe | X-59 | (H⁺)₃ |
| D-91 | Os | X-38 | (H⁺)₃ |
| D-92 | Os | X-59 | (H⁺)₃ |

Synthesis of the metal complex dye represented by the general formula (I) according to the present invention can be carried out based on methods described in literatures such as J. Am. Chem. Soc., 115, 6382 (1993) and references therein, etc.

### (B) The second metal complex dye

The second metal complex dye for use in the second photoelectric conversion device of the present invention is represented by the following general formula (II).

M₂(LL₂)m3(LL₃)m4(X₂)m5 · Cl₂ (II)

Constitutional components of the dye will be described in detail below.

### (1) Metal atom M₂

M₂ represents a metal atom, being the same as M₁ above mentioned. Preferable embodiments of M₂ are equal to those of M₁.

### (2) Ligand LL₂

LL₂ represents a bidentate or tridentate ligand, preferably a bidentate ligand represented by the above general formula (III), the same as LL₁above mentioned. Preferable embodiments of Za, Zb and Zc in the general formula (III) are equal to those in the case of LL₁. m3 indicating the number of LL₂ represents an integer of 0 to 2, preferably 0 or 1. When m3 is 2, LL₂'s may be the same or different ligands.

It is preferable that LL₂ represents a bidentate or tridentate ligand represented by any one of the above general formulae (V-1) to (V-8). LL₂ is more preferably represented by the general formula (V-1), (V-2), (V-4) or (V-6), particularly preferably represented by the general formula (V-1) or (V-2).

Preferable embodiments of R₁₁ to R₁₈, R₁₉ to R₂₆ and R₂₇ to R₃₁ in the general formulae (V-1) to (V-8) are the same as those of LL₁, respectively. In the case of LL₂, d1 to d8 preferably represent an integer of 0 to 2 independently, d7 and d8 preferably represent an integer of 0 to 3 independently, and d9 to d16 preferably represent an integer of 0 to 3 independently. It is particularly preferable that R₂₀'s are bonded together on a pyridine ring to form a pyridine ring when d10 is 2 or more.

As specific examples of LL₂, those of LL₁ shown above may be given.

### (3) Ligand LL₃

LL₃ represents a bidentate ligand represented by the following general formula (IV). 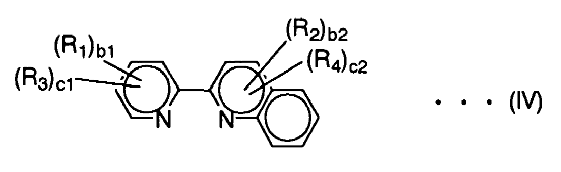 m4 indicating the number of LL₃ represents an integer of 1 to 3, preferably 1. or 2, more preferably 2. When m4 is 2 or 3, LL₃'s may be the same or different ligands.

In the general formula (IV), R₁ and R₂ independently represent a carboxyl group, a sulfonic acid group, a hydroxyl group, a hydroxamic acid group preferably having 1 to 20 carbon atoms such as -CONHOH, - CONCH₃0H, etc., a phosphoryl group such as -OP(O)(OH)₂, etc., or a phosphonyl group such as -P(O)(OH)₂, etc. Of these groups, preferred are a carboxyl group, a phosphoryl group and a phosphonyl group, more preferably a carboxyl group and a phosphonyl group, and most preferably a carboxyl group.

In the general formula (IV), R₃ and R₄ independently represent a substituent. Preferred examples thereof include an alkyl group, an alkenyl group, a cycloalkyl group, an aryl group, a heterocyclic group, an alkoxy group, an aryloxy group, an acyloxy group, an alkoxycarbonyl group, a carbamoyl group, an acylamino group, an amino group, an acyl group, a sulfonamido group and a halogen atom with preferable examples being the same as those of R₁₉ to R₂₆, and a cyano group, a hydroxyl group and an alkynyl group preferably having 2 to 20 of carbon atoms such as an ethynyl group, a butadiynyl group, a phenylethynyl group, etc.

R₃ and R₄ is more preferably an alkyl group, an alkenyl group, a cycloalkyl group, an alkoxy group, an aryloxy group, an acylamino group, an amino group, a hydroxyl group or an alkynyl group, particularly preferably an alkyl group, an alkenyl group, an alkoxy group, an acylamino group or an amino group, most preferably an alkyl group, an alkoxy group or an amino group, independently.

When LL₃ contains an alkyl group, an alkenyl group, etc., they may be a substituted or unsubstituted group having a straight or branched structure. When LL₃ contains an aryl group, a heterocyclic group, etc., they may be a substituted or unsubstituted group that may have a monocyclic or condensed ring structure.

In the general formula (IV), b1 and b2 independently represent an integer of 0 to 4. R₁'s may be the same or different groups when b1 is 2 or more, and R₂'s may be the same or different groups when b2 is 2 or more. R₁ may be bonded to any carbon atom in the pyridine ring, and R₂ may be bonded to any carbon atom in the quinoline ring. b1 is preferably an integer of 0 to 2, more preferably 0 or 1. b2 is preferably 1 or 2. The sum of b1 and b2 is preferably 1 to 4, more preferably 1 or 2.

In the general formula (IV), c1 represents an integer of 0 to 3, and c2 represents an integer of 0 to 5. R₃'s may be the same or different groups that may be bonded together to form a ring when c1 is 2 or more. R₄'s may be the same or different groups that may be bonded together to form a ring when c2 is 2 or more. R₃ and R₄ may be bonded together to form a ring when both of c1 and c2 are 1 or more. This ring formed by R₃ and R₄ is preferably a benzene ring, a cyclohexane ring or cyclopentane ring. R₃ may be bonded to any carbon atom in the pyridine ring, and R₄ may be bonded to any carbon atom in the quinoline ring.

c1 preferably represents an integer of 0 to 2, more preferably represents 0 or 1. c2 preferably represents an integer of 1 to 4, more preferably represents 1 or 2. The sum of c1 and c2 is preferably 1 to 6, more preferably 1 to 3.

As the specific examples of LL₃, L-20 to L-22 shown above, P-1 to P-47 illustrated below, etc. may be given. The scope of the present invention defined by the claims attached hereto is not restricted by the examples.

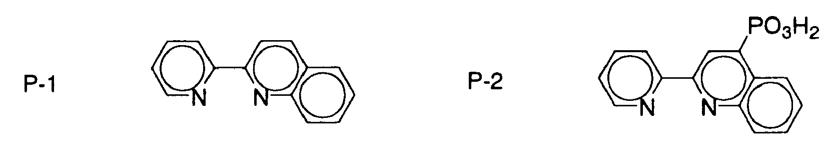

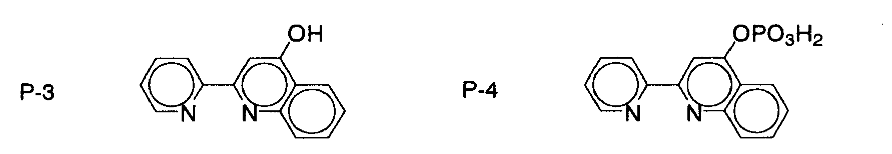

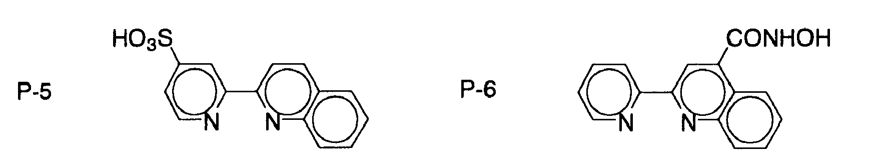

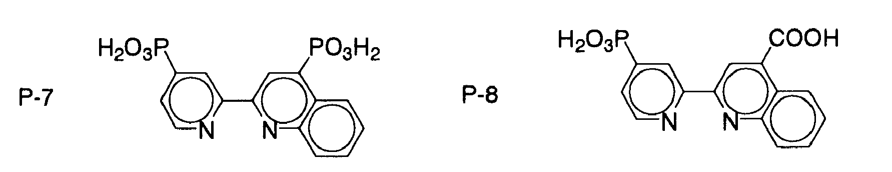

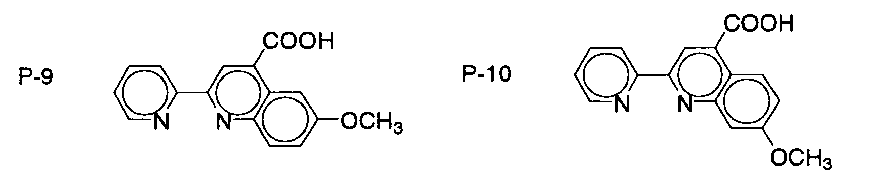

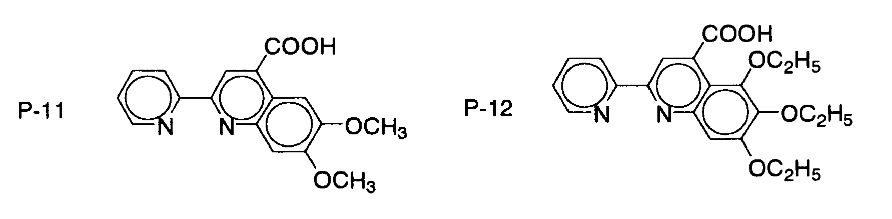

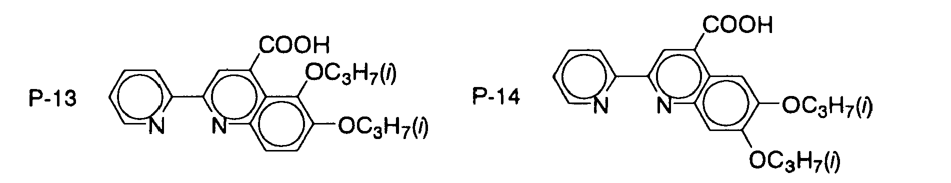

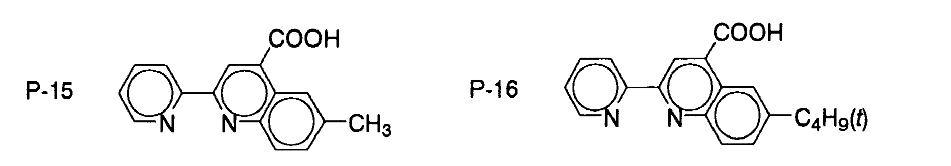

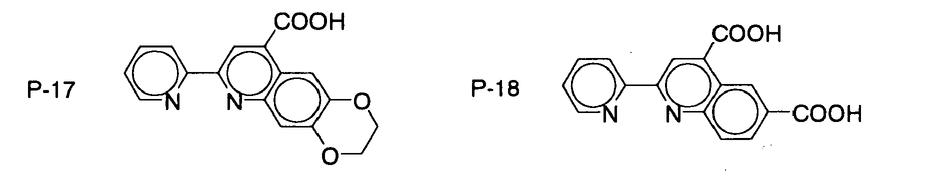

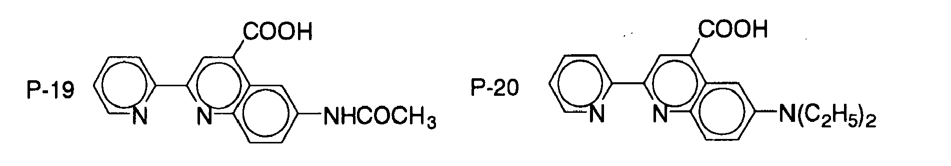

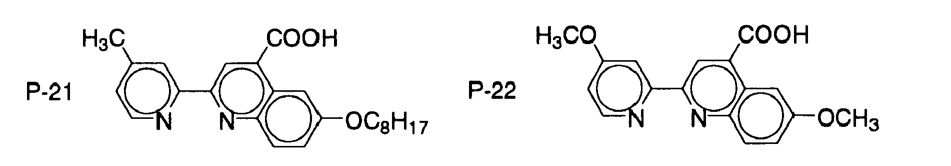

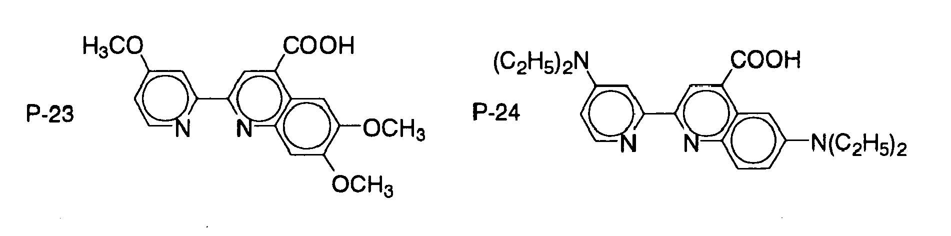

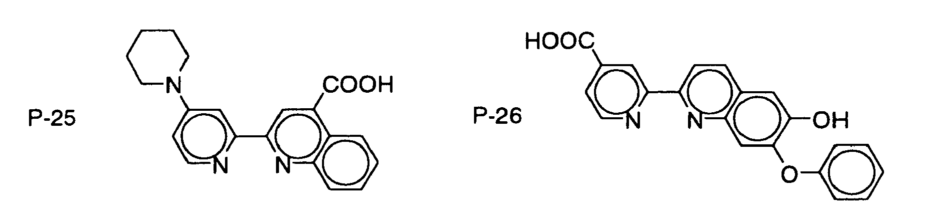

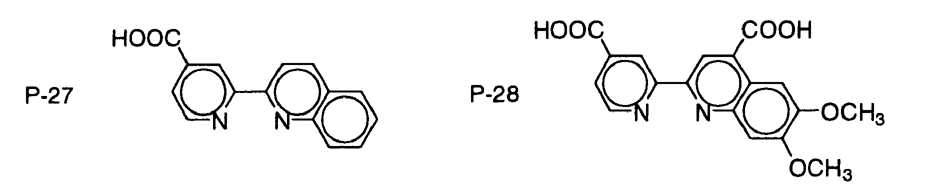

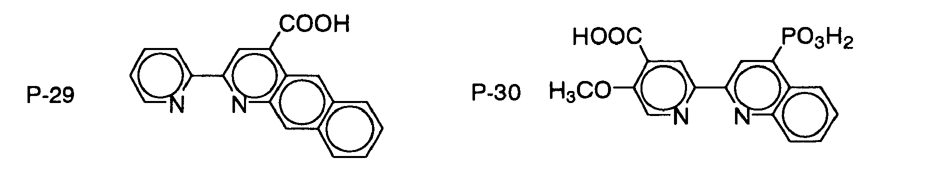

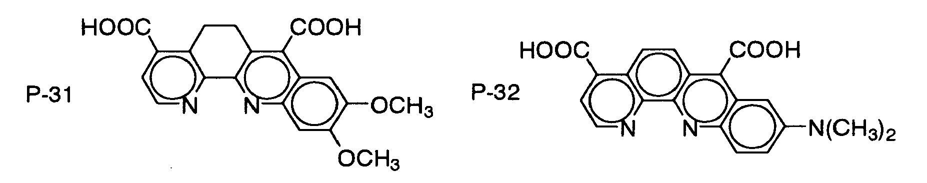

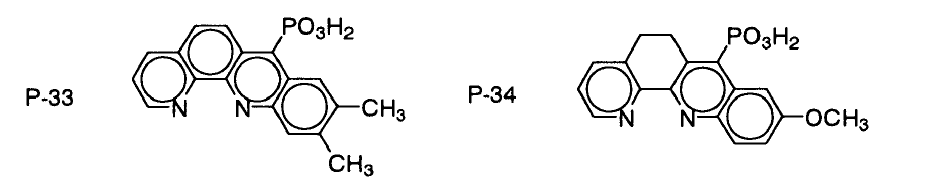

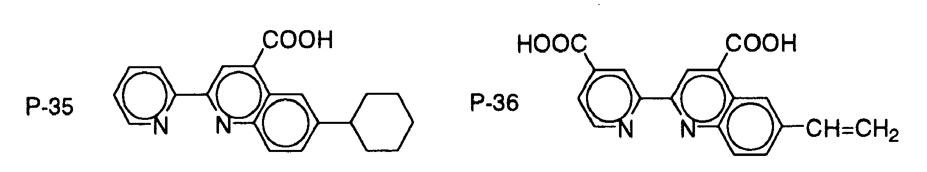

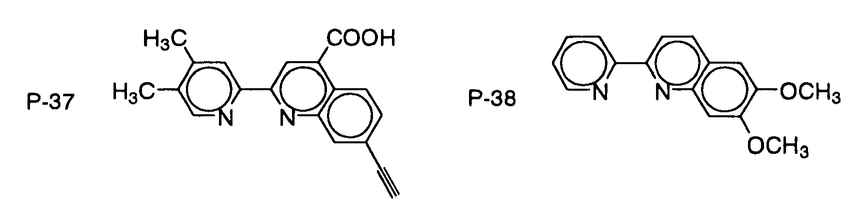

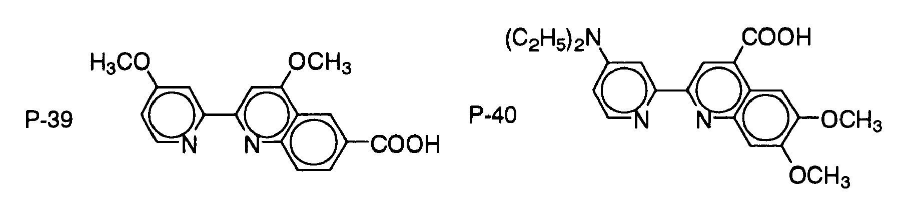

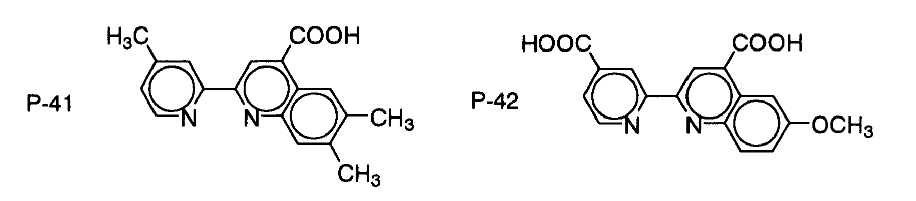

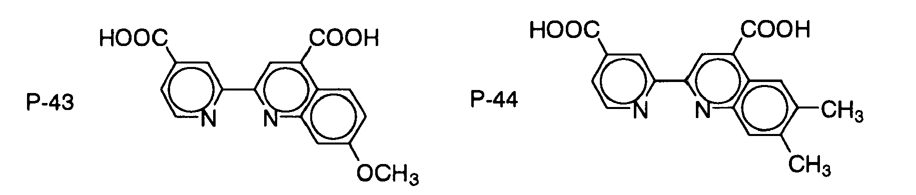

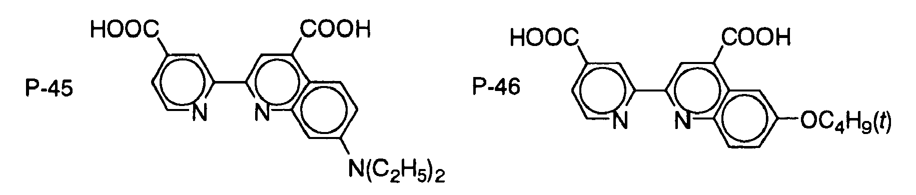

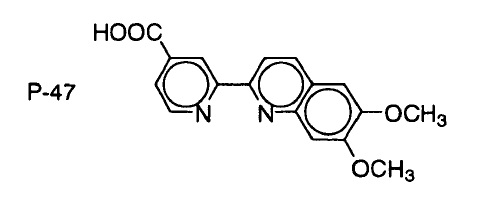

### (4) Ligand X₂

In the general formula (II), X₂ represents a monodentate or bidentate ligand which coordinates to M₂ via one or two groups selected from the group consisting of an acyloxy group, an acylthio group, an acylaminooxy group, a thioacyloxy group, a thioacylthio group, a thiocarbonate group, a dithiocarbonate group, a trithiocarbonate group, an alkylthio group, an arylthio group, an alkoxy group and an aryloxy group with preferable examples being the same as those of X₁, and a thiocarbamate group preferably having 1 to 20 carbon atoms such as an N,N-diethylthiocarbamate group, etc., a dithiocarbamate group preferably having 1 to 20 carbon atoms such as an N-phenyldithiocarbamate group, an N,N-dimethyldithiocarbamate group, an N,N-diethyldithiocarbamate group, an N,N-dibenzyldithiocarbamate group, etc., an acyl group preferably having 1 to 20 carbon atoms such as an acetyl group, a benzoyl group, etc., a thiocyanate group, an isothiocyanate group, a cyanate group, an isocyanate group and a cyano group, or a monodentate or bidentate ligand selected from the group consisting of ketones, carbonamides, thiocarbonamides, thioureas and isothioureas with preferable examples being the same as those of X₁, and halogen atoms such as a chlorine atom, a bromine atom, an iodine atom, etc. and carbonyl.

m5 indicating the number of X₂ represents an integer of 0 to 3. X₂'s may be the same or different ligands that may be bonded together when m5 is 2 or 3. m5 is preferably 0 to 2, more preferably 1 or 2. It is particularly preferable that m5 is 2 when X₂ is a monodentate ligand, and that m5 is 1 when X₂ is a bidentate ligand.

In the case where M₂ is a metal atom tend to form four-coordinated complex such as Cu, Pd, Pt, etc., it is preferred that m3 is 0 and m4 is 1 or 2. In this case, m5 is preferably 1 or 2 when m4 is 1, and m5 is preferably 0 when m4 is 2.

In the case where M₂ is a metal atom tend to form six-coordinated complex, m4 is preferably 1 or 2, more preferably 2. In this case, m3 is preferably 1 or 2, more preferably 1 when m4 is 1, m5 is preferably 1 or 2 when m3 is 1, and m5 is preferably 0 when m3 is 2. On the other hand, m3 is preferably 0 or 1, more preferably 0 when m4 is 2, m5 is preferably 1 or 2 when m3 is 0, and m5 is preferably 0 when m3 is 1. Further, when m4 is 3, both of m3 and m5 are preferably 0.

Preferred bidentate ligand X₂ is a ligand which coordinates to M₂ via one or two groups selected from the group consisting of an acyloxy group, an acylthio group, an acylaminooxy group, a thioacyloxy group, a thioacylthio group, a thiocarbonate group, a dithiocarbonate group, a trithiocarbonate group, an alkylthio group, an arylthio group, an alkoxy group, an aryloxy group, a thiocarbamate group, a dithiocarbamate group and an acyl group, or a ligand selected from the group consisting of 1,3-diketones, carbonamides, thiocarbonamides and thioureas. Preferred monodentate ligand X₂ is a ligand which coordinates to M₂ via one or two groups selected from the group consisting of an alkylthio group, an arylthio group, a thiocyanate group, an isothiocyanate group, a cyanate group, an isocyanate group and a cyano group, or a ligand selected from a member consisting of 1,3-diketones, carbonamides, thiocarbonamides, thioureas, halogen atoms and carbonyl.

X₂ is more preferably a ligand which coordinates to M₂ via one or two groups selected from the group consisting of an acyloxy group, an acylaminooxy group, a thioacylthio group, a dithiocarbonate group, a trithiocarbonate group, an alkylthio group, an arylthio group, an alkoxy group, an aryloxy group, a dithiocarbamate group, a thiocyanate group, an isothiocyanate group, a cyanate group, an isocyanate group and a cyano group, or a ligand selected from the group consisting of 1,3-diketones, thioureas, halogen atoms and carbonyl, furthermore preferably a ligand which coordinates to M₂ via one or two groups selected from the group consisting of an acyloxy group, an acylaminooxy group, an arylthio group, a dithiocarbamate group, a thiocyanate group, an isothiocyanate group, a cyanate group, an isocyanate group and a cyano group, or a ligand selected from the group consisting of 1,3-diketones, thioureas and halogen atoms, particularly preferably a ligand which coordinates to M₂ via one or two groups selected from the group consisting of a dithiocarbamate group, a thiocyanate group, an isothiocyanate group, a cyanate group and an isocyanate group, or a 1,3-diketone or a halogen atom, most preferably a ligand which coordinates to M₂ via a dithiocarbamate group, a thiocyanate group and/or an isothiocyanate group, or a 1,3-diketone.

When X₂ contains an alkyl group, an alkenyl group, an alkynyl group, an alkylene group, etc., they may be a substituted or unsubstituted group having a straight or branched structure. When X₂ contains an aryl group, a heterocyclic group, a cycloalkyl group, etc., they may be a substituted or unsubstituted group having a monocyclic or condensed ring structure.

As the specific examples of X₂, X-1 to X-92 shown above, and X-93 to X-111 illustrated below may be given. The scope of the present invention defined by the claims attached hereto is not restricted by the examples. Incidentally, chemical formulae shown below are just a limiting structure of possible resonance structures, and distinction between a covalent bond represented by ― and a coordinating bond represented by ··· is also just formal and therefore these bonds do not mean an absolute distinction.

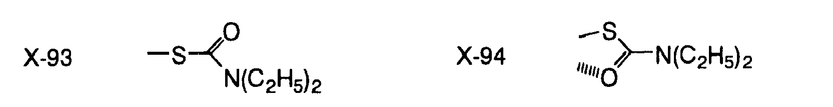

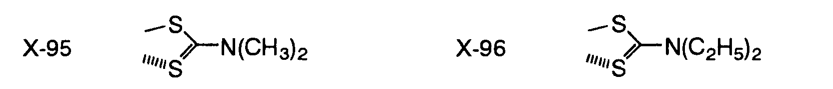

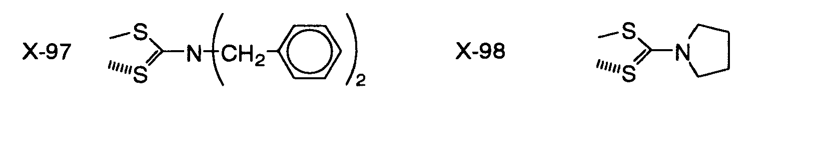

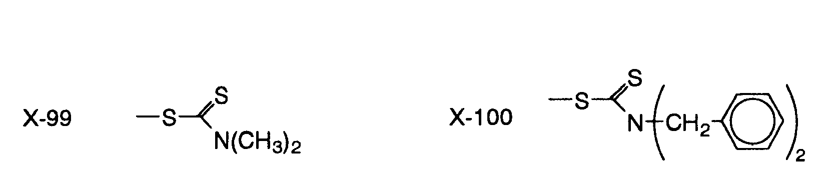

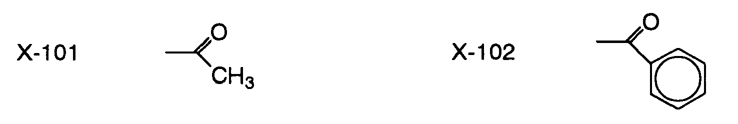

X-103 ''''''CO

X-104 —NCS

X-105 —SCN

X-106 —NCO

X-107 —OCN

X-108 —Cl

X-109 —Br

X-110 —I

X-111 —CN

### (5) Counter ion CI₂

C1₂ represents a counter ion optionally contained in the metal complex dye to neutralize charge thereof, being the same as CI₁ above mentioned. Examples and preferable embodiments of C1₂ are equal to those of CI₁.

### (6) Interlocking group

The dye represented by the general formula (II) has preferably at least one interlocking group suitable for the surface of semiconductor particles, being the same as the dye represented by the general formula (I) mentioned above. The number of the interlocking group in the dye represented by the general formula (II) is more preferably one to six, particularly preferably one to four.

In particular, it is preferable that LL₃ has at least one interlocking group, and it is more preferable that LL₂ and LL₃ have at least one interlocking group, respectively.

Preferable interlocking groups in the dye represented by the general formula (II) are the same as those in the dye represented by the general formula (I).

### (7) Specific examples of the metal complex dye

As for the second metal complex dye according to a particularly preferable embodiment of the present invention, in the general formula (II), M₂ is Ru, LL₂ is a bidentate or tridentate ligand represented by any one of the general formulae (V-1) to (V-8), LL₃ is a bidentate ligand represented by the general formula (IV), X₂ represents a monodentate or bidentate ligand which coordinates to M₂ via one or two groups selected from the group consisting of an acyloxy group, an acylthio group, an acylaminooxy group, a thioacyloxy group, a thioacylthio group, a thiocarbonate group, a dithiocarbonate group, a trithiocarbonate group, an alkylthio group, an arylthio group, an alkoxy group, an aryloxy group, a thiocarbamate group, a dithiocarbamate group, an acyl group, a thiocyanate group, an isothiocyanate group, a cyanate group, an isocyanate group and a cyano group, or a monodentate or bidentate ligand selected from the group consisting of ketones, carbonamides, thiocarbonamides, thioureas, isothioureas, halogen atoms and carbonyl, m3 is 0 or 1, m4 is 1 or 2, LL₃'s may be the same or different ligands when m4 is 2, m5 represents an integer of 0 to 2, X₂'s may be the same or different ligands that may be bonded together when m5 is 2, at least one of m3 and m5 is not 0, and CI₂ represents a counter ion optionally contained to neutralize charge of the metal complex dye.

As specific examples of the second dye represented by the general formula (II), above-mentioned D-16 to D-19, D-23, D-24, D-39, D-57 to D-61, D-65, D-67, D-71 to D-82, etc. may be given. Further specific examples D-93 to D-155 thereof will be illustrated below without intention of restricting the scope of the present invention defined by the claims attached hereto.

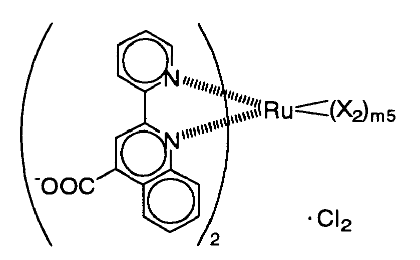

| | (X₂₎ₘ₅ | Cl₂ |
|---|---|---|
| D-93 | (X-104)₂ | (H⁺)₂ |
| D-94 | (X-104)₂ | (N^{+*n*}Bu₄)₂ |
| D-95 | X-96 | H⁺ |
| D-96 | (X-105)₂ | (H⁺)₂ |
| D-97 | (X-106)₂ | (H⁺)₂ |
| D-98 | (X-108)₂ | (H⁺)₂ |
| D-99 | (X-111)₂ | (H⁺)₂ |

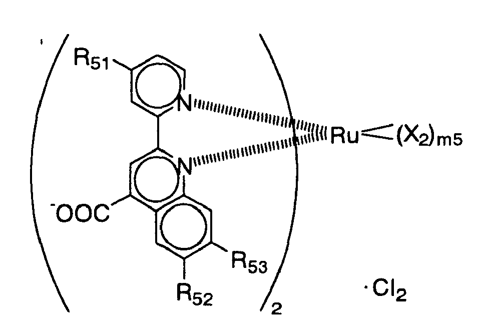

| | R₅₁ | R₅₂ | R₅₃ | (X₂)ₘ₅ | Cl₂ |
|---|---|---|---|---|---|
| D-100 | H | -OCH₃ | H | (X-104)₂ | (H⁺)₂ |
| D-101 | H | ―OCH₃ | H | X-38 | H⁺ |
| D-102 | H | -OCH₃ | H | X-70 | (H⁺)₂ |
| D-103 | H | -OCH₃ | -OCH₃ | (X-104)₂ | (H⁺)₂ |
| D-104 | H | -OCH₃ | -OCH₃ | X-59 | H⁺ |
| D-105 | H | -N(C₂H₅)₂ | H | (X-104)₂ | (H⁺)₂ |
| D-106 | H | ―C₄H₉(*t*) | H | (X-104)₂ | (H⁺)₂ |
| D-107 | H | H | -N(C₂H₅)₂ | X-72 | H⁺ |
| D-108 | -CH₃ | -CH₃ | -CH₃ | (X-104)₂ | (H⁺)₂ |
| D-109 | ―OCH₃ | ―OCH₃ | ―OCH₃ | (X-104)₂ | (H⁺)₂ |
| D-110 | -N(C₂H₅)₂ | -N(C₂H₅)₂ | H | (X-104)₂ | (H⁺)₂ |
| D-111 | H | ―NHCOCH₃ | H | (X-104)₂ | (H⁺)₂ |

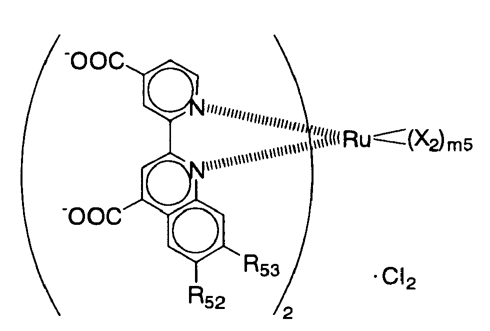

| | R₅₂ | R₅₃ | (X₂)ₘ₅ | Cl₂ |
|---|---|---|---|---|
| D-112 | H | H | (X-104)₂ | (H⁺)₂ |
| D-113 | H | H | X-96 | H⁺ |
| D-114 | -OCH₃ | -OCH₃ | (X-104)₂ | (H⁺)₂ |
| D-115 | -OCH₃ | -OCH₃ | X-38 | H⁺ |
| D-116 | -OCH₃ | H | X-70 | (H⁺)₂ |
| D-117 | -CH₃ | -CH₃ | (X-104)₂ | (H⁺)₂ |
| D-118 | ―CH=CH₂ | H | (X-104)₂ | (H⁺)₂ |
| D-119 | -N(C₂H₅)₂ | H | (X-104)₂ | (H⁺)₂ |
| D-120 | -N(C₂H₅)₂ | H | X-96 | H⁺ |

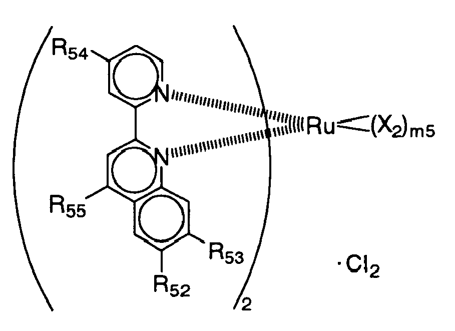

| | R₅₂ | R₅₃ | R₅₄ | R₅₅ | (X₂)ₘ₅ | Cl₂ |
|---|---|---|---|---|---|---|
| D-121 | H | H | H | -PO₃H₂ | (X-104)₂ ― | |
| D-122 | H | H | ―SO₃H | H | (X-104)₂ ― | |
| D-123 | H | H | -PO₃H₂ | -P0₃H₂ | (X-104)₂ ― | |

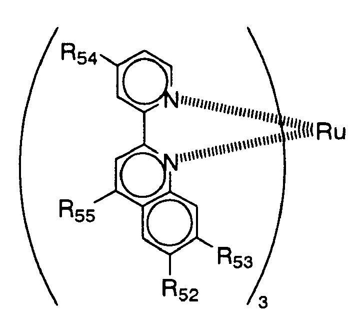

| | R₅₂ | R₅₃ | R₅₄ | R₅₅ |
|---|---|---|---|---|
| D-124 | H | H | H | ―COOH+ -COO- |
| D-125 | H | H | H | ―PO₃H₂ + ―PO₃H⁻ |
| D-126 | -OCH₃ | H | H | -COOH + ―COO⁻ |
| D-127 | —N(C₂H₅)₂ | —N(C₂H₅)₂ | H | —COOH + —COO⁻ |
| D-128 | —COOH | H | H | —COOH + —COO⁻ |
| D-129 | —COOH | —N(C₂H₅)₂ | H | —COOH + —COO⁻ |

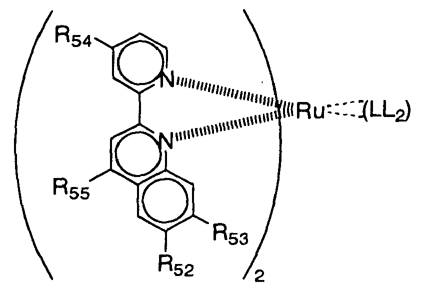

| | R₅₂ | R₅₃ | R₅₄ | R₅₅ | LL₂ |
|---|---|---|---|---|---|
| D-130 | H | H | H | —COO' | L-5 |
| D-131 | H | H | H | —COO⁻ | L-10 |
| D-132 | —OCH₃ | —OCH₃ | H | —COO' | L-5 |
| D-133 | —N(C₂H₅)₂ | H | H | —COO⁻ | L-5 |
| D-134 | —OCH₃ | —OCH₃ | H | —COO' | L-24 |
| D-135 | —OCH₃ | —OCH₃ | —COOH | —COO' | L-72 |

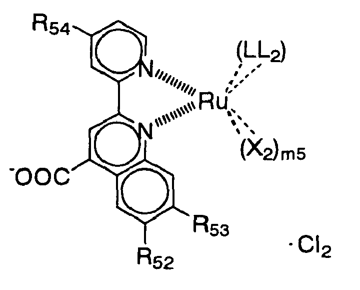

| | R₅₂ | R₅₃ | R₅₄ | LL₂ | (X₂)ₘ₅ | Cl₂ |
|---|---|---|---|---|---|---|
| D-136 | H | H | H | L-5 | (X-104)₂ | (H⁺)₂ |
| D-137 | H | H | H | L-5 | X-96 | H⁺ |
| D-138 | —OCH₃ | H | H | L-5 | (X-104)₂ | (H⁺)₂ |
| D-139 | —OCH₃ | —OCH₃ | H | L-5 | (X-104)₂ | (H⁺)₂ |
| | D-140 -N(C₂H₅)₂ | H | H | L-5 | (X-104)₂ | (H⁺)₂ |
| D-141 | —OCH₃ | —OCH₃ | H | L-88 | (X-104)₂ | (H⁺)₂ |

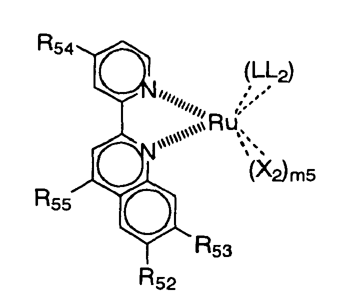

| | R₅₂ | R₅₃ | R₅₄ | R₅₅ | LL₂ | (X₂)ₘ₅ |
|---|---|---|---|---|---|---|
| D-142 | H | H | —COOH | —COO⁻ | L-5 | (X-104)₂ |
| D-143 | —COOH | H | H | —COO⁻ | L-5 | (X-104)₂ |
| D-144 | H | H | —COO⁻ | H | L-5 | (X-104)₂ |
| D-145 | —OCH₃ | —OCH₃ | —COOH | —COO⁻ | L-42 | (X-104)₂ |
| D-146 | —OCH₃ | —OCH₃ | —COOH | —COO⁻ | L-88 | (X-104)₂ |

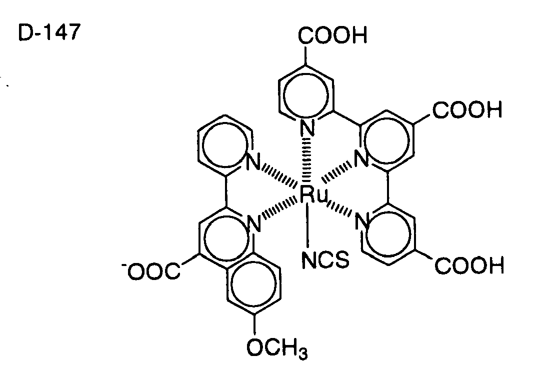

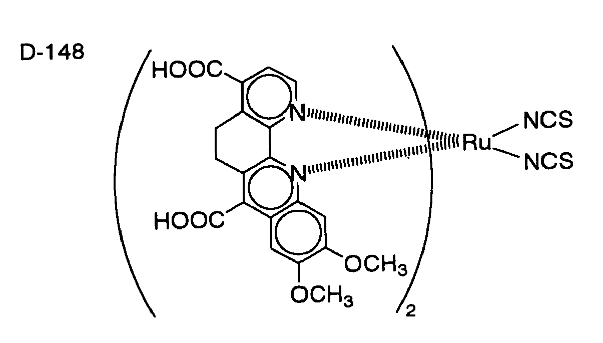

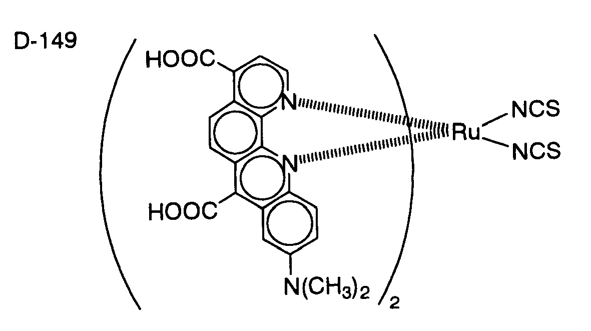

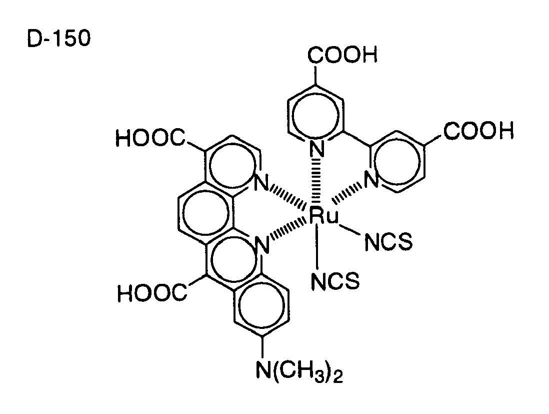

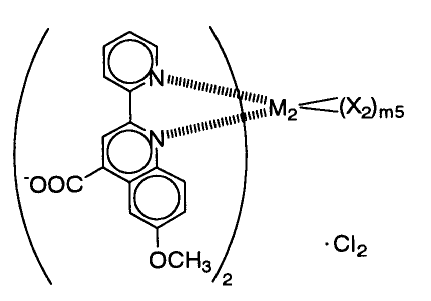

| | M₂ | (X₂)ₘ₅ | Cl₂ |
|---|---|---|---|
| D-151 | Fe | (X-104)₂ | (H⁺)₂ |
| D-152 | Os | (X-104)₂ | (H⁺)₂ |
| D-153 | Cu | — | H⁺ |

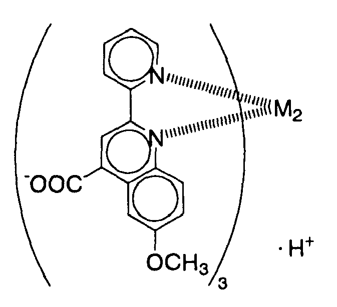

| | M₂ |
|---|---|
| D-154 | Fe |
| D-155 | Os |

Synthesis of the metal complex dye represented by the general formula (II) according to the present invention can be carried out based on methods described in literatures such as Chem. Phys. Lett., 85, 309 (1982), Chem. Phys. Lett., 71, 220 (1980), J. Am. Chem. Soc., 115, 6382 (1993) and references therein, etc. Ligands composing the dye can be synthesized referring to Synth. Commun., 27, 2165 (1997), Aust. J. Chem., 25, 1631 (1972), etc.

### [2] Photoelectric conversion device

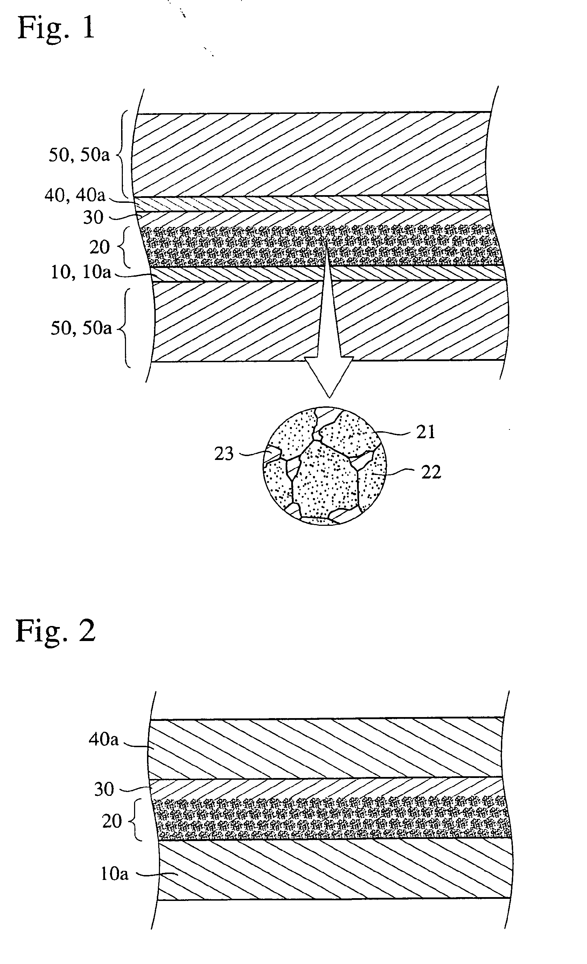

The photoelectric conversion device of the present invention comprises a photosensitive layer containing semiconductor particles sensitized by the above-described metal complex dye. The photoelectric conversion device preferably comprises an electrically conductive layer 10, a photosensitive layer 20, a charge transfer layer 30 and a counter electrically conductive layer 40 each laminated in this order as shown in Fig. 1. The photosensitive layer 20 comprises the semiconductor particles 21 sensitized by a metal complex dye 22 and charge-transporting materials 23 penetrated into voids among the semiconductor particles. The charge-transporting material 23 is composed of the same components as materials for use in the charge transfer layer 30. To improve the strength of the photoelectric conversion device, a substrate 50 may be set on the electrically conductive layer 10 or the counter electrically conductive layer 40. Hereinafter in this specification, a layer composed of the electrically conductive layer 10 and the substrate 50 optionally set thereon is referred to as "conductive support", and a layer composed of the counter electrically conductive layer 40 and the substrate 50 optionally set thereon is referred to as "counter electrode". An article comprising such a photoelectric conversion device connected to an outer circuit is a photo-electrochemical cell. The electrically conductive layer 10, the counter electrically conductive layer 40, and the substrate 50 shown in Fig. 1 may be a transparent electrically conductive layer 10a, a transparent counter electrically conductive layer 40a, and a transparent substrate 50a, respectively.

In the photoelectric conversion device of the present invention shown in Fig. 1, light injected to the photosensitive layer 20 excites the metal complex dye 22, etc., electrons with high energy therein are transferred to a conduction band of the semiconductor particles 21, and they are diffused to reach to the electrically conductive layer 10. At this time, the dye 22, etc. are in the form of the oxidation product. In the photo-electrochemical cell, the electrons in the electrically conductive layer 10 are returned to the oxidation product of the dye 22 etc. through the counter electrically conductive layer 40 and the charge transfer layer 30 while working in the outer circuit, so that the dye 22 is regenerated. The photosensitive layer 20 acts as an anode. In a boundary of each layer such as a boundary between the electrically conductive layer 10 and the photosensitive layer 20, a boundary between the photosensitive layer 20 and the charge transfer layer 30, a boundary between the charge transfer layer 30 and the counter electrically conductive layer 40, etc., components of each layer may be diffused and mixed each other. Each layers are explained in detail below.

### (A) Conductive support

The conductive support is composed of: (1) a single layer of the electrically conductive layer; or (2) two layers of the electrically conductive layer and the substrate. The substrate is not necessary in the case where the electrically conductive layer has sufficient strength and can fully seal the photoelectric conversion device.

In the case (1), the electrically conductive layer is made of a material having a sufficient strength and an electrical conductivity such as a metal, etc.

In the case (2), as the conductive support may be used the substrate having thereon the electrically conductive layer comprising an electrically conductive agent at the photosensitive layer side.

Preferable examples of the electrically conductive agent include metals such as platinum, gold, silver, copper, aluminum, rhodium, indium, etc., carbon and electrically conductive metal oxides such as indium-tin composite oxides, tin oxides doped with fluorine, etc. The thickness of the electrically conductive layer is preferably 0.02 to 10 µm.

It is preferable that the surface resistance of the conductive support is as low as possible. The surface resistance is preferably 100 Ω/square or less, more preferably 40 Ω/square or less. The lowest limit of the surface resistance is not limited in particular, generally approximately 0.1 Ω/square.

When a light is irradiated from the side of the conductive support, it is preferred that the conductive support is substantially transparent. The "substantially transparent" conductive support has a light transmittance of 10 % or more in the present invention. The light transmittance is preferably 50 % or more, particularly preferably 70 % or more.

The transparent conductive support preferably composed of the transparent substrate such as a glass substrate, a plastic substrate, etc. and a transparent electrically conductive layer comprising an electrically conductive metal oxide formed by coating or vapor depositing on the surface thereof. Of such supports, an electrically conductive glass in which an electrically conductive layer comprising a tin oxide doped with fluorine is deposited on a transparent substrate made of a low-cost soda-lime float glass is preferred. As for a low-cost and flexible photoelectrical conductive device or solar cell, a transparent polymer film having an electrically conductive layer thereon is preferably used as the transparent conductive support. Examples of materials for the transparent polymer include tetraacetylcellulose (TAC), polyethyleneterephthalate (PET), polyethylenenaphthalate (PEN), syndiotactic polystyrene (SPS), polyphenylenesulfide (PPS), polycarbonate (PC), polyarylate (PAr), polysulfone (PSF), polyestersulfone (PES), polyetherimide (PEI), cyclic polyolefin, brominated phenoxy, etc. To secure a sufficient transparency, it is preferable that the coating amount of the electrically conductive metal oxide is 0.01 to 100 g per 1 m² of a glass or plastic support.

It is preferable to use a metal lead to reduce a resistance of the transparent conductive support. Material of the metal lead is preferably a metal such as aluminum, copper, silver, gold, platinum, nickel, etc., particularly preferably aluminum or silver. It is preferable that the metal lead is applied onto the transparent substrate by vapor deposition, sputtering, or the like, and the transparent electrically conductive layer composed of a tin oxide doped with fluorine or ITO film is applied thereon. It is also preferable that the transparent electrically conductive layer is formed on the transparent substrate, and then the metal lead is applied onto the transparent electrically conductive layer. The reduction in quantity of incident light owing to the metal lead is preferably 10 % or less, more preferably 1 to 5 %.

### (B) Photosensitive layer

In the photosensitive layer containing the semiconductor particles sensitized by the metal complex dye of the present invention, the semiconductor particles act as a so-called photosensitive substance. The semiconductor particles absorb a light to conduct a charge separation, thereby generating electrons and positive holes. In the dye-sensitized semiconductor particles, light-absorption and the generation of electrons and positive holes are primarily caused in the dye, and the semiconductor particles receive and then convey the electrons.

### (1) Semiconductor particles

As the semiconductor particles, simple substances such as silicone and germanium, III-V series compound semiconductors, metal chalcogenides such as oxides, sulfides and selenides, compounds with perovskite structure such as strontium titanate, calcium titanate, sodium titanate, barium titanate and potassium niobate, etc. may be used.

Preferable examples of the metal chalcogenide include oxides of titanium, tin, zinc, iron, tungsten, zirconium, hafnium, strontium, indium, cerium, yttrium, lanthanum, vanadium, niobium or tantalum; sulfides of cadmium, zinc, lead, silver, antimony or bismuth; selenides of cadmium or lead; and cadmium telluride. Examples of other semiconductor compounds include phosphides of zinc, gallium, indium and cadmium; selenides of gallium-arsenic or copper-indium; and copper-indium sulfide, etc.

Preferable specific examples of the semiconductor used in the present invention include Si, TiO₂, SnO₂, Fe₂O₃, WO₃, ZnO, Nb₂O₅, CdS, ZnS, PdS, Bi₂S₃, CdSe, CdTe, GaP, InP, GaAs, CuInS₂, CuInSe₂, etc. Among these semiconductors, more preferred are TiO₂, ZnO, SnO₂, Fe₂O₃, WO₃, Nb₂O₅, CdS, PdS, CdSe, InP, GaAs, CuInS₂ and CuInSe₂, particularly preferred are TiO₂ and Nb₂O₅, and most preferred is TiO₂.

The semiconductor for use in the present invention may be a single crystal or a poly crystal. The single crystal semiconductor is preferred from a viewpoint of a conversion efficiency, while the poly crystal semiconductor is preferred from a viewpoints of a production cost, security of raw materials, a period of energy-payback time, etc.

The particle size of the semiconductor particles is generally in the nm to µm level. The mean size of primary particles, which is obtained from a diameter of a circle equivalent to a projected area, is preferably 5 to 200 nm, more preferably 8 to 100 nm. Further, the mean size of the secondary semiconductor particles in a dispersion is preferably 0.01 to 100 µm.

Two or more kinds of particles having a different particle size distribution from each other, may be mixed to use in the photosensitive layer. In this case, the average particle size of the smaller particles is preferably 5 nm or less. To improve a light-capturing rate by scattering a ray of light, semiconductor particles each having a large particle size, e.g. approximately 300 nm, may be added to the mixture used for composing the semiconductor layer.

Preferred as a method for producing the semiconductor particles are sol-gel methods described in Sumio Sakka, Science of a sol-gel method, Agune Shofusha (1998), Technical information Association, Thin film-coating technology by a sol-gel method (1995), etc. and gel-sol methods described in Tadao Sugimoto, Synthesis of mono-dispersion particles and control of their size and form by a novel gel-sol method, and MATERIA, Vol. 35, No. 9, pp. 1012 to 1018 (1996). Further, the method developed by Degussa Company, which comprises preparing oxides by subjecting chlorides to a high temperature hydrolysis in an oxyhydrogen salt is also preferred.

In the case where titanium oxide is used as the semiconductor particles, any of the above-described sol-gel method, gel-sol method and high temperature hydrolysis method may be preferably used, and further a sulfuric acid method and a chlorine method described in Manabu Seino, Titanium oxide — properties and applied technique, Gihodo Shuppan, (1997) may be used. Also preferred as a sol-gel method are a method described in Christophe J. Barb'e, et al, Journal of American Ceramic Society, Vol. 80, No. 12, pp. 3157 to 3171 (1997) and a method described in Burnside, et al, Chemistry of Materials, Vol. 10, No. 9, pp. 2419 to 2425.

### (2) Semiconductor particle layer

The semiconductor particles may be coated on the conductive support by a method where a dispersion liquid or a colloid solution containing the particles is coated on the electrically conductive layer, the above-mentioned sol-gel method, etc. A wet-type film production method is relatively advantageous for the mass production of the photoelectric conversion device, improvement of properties of semiconductor particles and adaptability of the conductive support, etc. As such a wet-type film production method, a coating method and a printing method are typical examples.

As a method for preparing a dispersion solution containing the semiconductor particles, the sol-gel method mentioned above may be used. Further, the dispersion solution may be prepared by crushing the semiconductor in a mortar, dispersing the semiconductor while grinding in a mill, or precipitating the semiconductor particles in a solvent when the semiconductor is synthesized.

As a dispersion solvent, water or various kinds of organic solvents such as methanol, ethanol, isopropyl alcohol, dichloromethane, acetone, acetonitrile, ethyl acetate, etc. may be used. At the time of dispersion, a polymer, a surfactant, an acid or a chelating agent may be used as a dispersing agent, if necessary.

Preferred coating methods are a roller method and a dip method as an application series, an air-knife method and a blade method as a metering series, etc. Further, preferable as a method where an application and metering can be performed at the same time are a wire-bar method disclosed in JP-B-58-4589, a slide-hopper method described in United States Patent Nos. 2,681,294, 2,761,419, 2,761,791, etc., an extrusion method, a curtain method, etc. Further, as for a wide use, a spin method and a spray method are preferred. As a wet-type printing method, three major printing methods comprising a relief printing, an offset printing and a gravure printing, and an intaglio printing, a gum-printing, a screen printing, etc. are preferred. A preferable film-production method is selected from the above-mentioned methods in accordance with viscosity of the solution and a wet thickness.

The viscosity of the dispersion solution materially depends on the kind and dispersion property of the semiconductor particles, the kind of a solvent and additives such as a surfactant and a binder. For a high viscosity solution (e.g. 0.01 to 500 Poise), an extrusion method, a cast method, a screen-printing method, etc. are preferably used. On the other hand, for a low viscosity solution (e.g. 0.1 Poise or less), a slide-hopper method, a wire-bar method and a spin method are preferably used to form a uniform film. In the case of the low viscosity solution, an extrusion method may be used if the solution is coated to some extent. A wet-type film-production method may be properly selected in accordance with the viscosity of a coating solution, a coating amount, a support, a coating speed and so on.

The layer of the semiconductor particles is not limited to a single layer. The dispersion solutions of semiconductor particles, each of which dispersion has a different particle size may be subjected to a multi-layer coating. Further, alternatively coating solutions each containing different kinds of semiconductor particles (or different kinds of binder, or additives) may be subjected to a multi-layer coating.
When a film-thickness is insufficient by coating once, a multi-layer coating is also effective. An extrusion method or a slide-hopper method is suitable for the multi-layer coating. Further, when a multi-layer coating is carried out, multi-layers may be coated at the same time, or alternatively they may be coated one over the other from several times to ten-several times. In the latter case, a screen method is also preferably used.

Generally, in the case where the thickness of the semiconductor particle layer, same as the thickness of a photosensitive layer, becomes thicker, the amount of a dye incorporated therein per unit of the projected area increases, thereby making the light capturing rate higher. However, because a diffusion distance of the generated electrons increases in such a case, a loss owing to recombination of electric charges also increases. Consequently, a preferable thickness of the semiconductor particle layer is 0.1 to 100 µm. When the photoelectric conversion device comprising the semiconductor particle layer is utilized for a photo-electrochemical cell, the thickness of the semiconductor particle layer is preferably 1 to 30 µm, more preferably 2 to 25 µm. A coating amount of the semiconductor particles per 1 m² of the support is preferably 0.5 to 400 g, more preferably 5 to 100 g.

After coating the semiconductor particles on the conductive support, the particles are preferably subjected to a heat treatment to electronically contact them with each other, and to increase a coating strength and an adherence thereof with the support. A heating temperature at the heat treatment is preferably 40 °C or more but less than 700 °C, more preferably 100 to 600 °C. A heating time is approximately 10 minutes to 10 hours. It is not preferred that a support having a low melting point or softening point such as a polymer film is subjected to a high temperature treatment because such a support tends to be deteriorated thereby. The heat treatment is preferably carried out at a temperature as low as possible from a viewpoint of the cost. The practice at such a low temperature can be realized by a combination use with the above-described small semiconductor particles having a size of 5 nm or less, a heat treatment in the presence of a mineral acid, etc.

After a heat treatment, a chemical metal-plating using an titanium tetrachloride aqueous solution, etc. or an electrochemical metal-plating using an titanium trichloride aqueous solution may be carried out to increase a surface area of the semiconductor particles, or to enhance a purity in the vicinity of the semiconductor particles, thereby improving an efficiency of electron injection into the semiconductor particles from a dye.

It is preferable that the semiconductor particles have a large surface area, so that they can adsorb lots of dyes. Therefore, the surface area in the state that the semiconductor particle layer have been coated on the support is preferably 10 times or more, more preferably 100 times or more of the projected area. The highest limit, even though it is not limited in particular, is generally a level of 1000 times.

### (3) Adsorption of metal complex dye onto semiconductor particles

The metal complex dye may be adsorbed onto the semiconductor particles by soaking the conductive support having thereon the well-dried semiconductor particle layer in a solution of the metal complex dye, or by coating a solution of the metal complex dye onto the semiconductor particle layer. In the former case, a soaking method, a dipping method a roller method, an air-knife method, etc. may be used. In the soaking method, the dye may be adsorbed at a room temperature or while refluxing as described in JP-A-7-249790. As a coating method of the latter, a wire-bar method, a slide-hopper method, an extrusion method, a curtain method, a spin method, a spray method, etc. may be used. Further, as a printing method, a relief printing, an offset printing, a gravure printing, a screen-printing, etc. may be used. A solvent therefor may be properly selected in accordance with the solubility of the metal complex dye. Examples of the solvent include alcohols such as methanol, ethanol, t-butanol, benzyl alcohol, etc., nitriles such as acetonitrile, propionitrile, 3-methoxypropionitrile, etc., nitromethane, halogenated hydrocarbons such as dichloromethane, dichloroethane, chloroform, chlorobenzene, etc., ethers such as diethylether, tetrahydrofuran, etc., dimethylsulfoxide, amides such as N,N-dimethylformamide, N,N-dimethylacetamide, etc., N-methylpyrrolidone, 1,3-dimethylimidazolidinone, 3-methyloxazolidinone, esters such as ethylacetate, butylacetate, etc., carbonates such as diethyl carbonate, ethylene carbonate, propylene carbonate, etc., ketones such as acetone, 2-butanone, cyclohexanone, etc., hydrocarbons such as hexane, petroleum ether, benzene, toluene, etc., water, and mixture thereof.

Similar to the case of forming the semiconductor particle layer, various kinds of coating methods can be also selected in accordance with the viscosity of the metal complex dye solution. For a high viscosity solution (e.g. 0.01 to 500 Poise), an extrusion method, and various kinds of printing methods are suitable. On the other hand, for a low viscosity solution (e.g. 0.1 Poise or less), a slide-hopper method, a wire bar method and a spin method are suitable. A uniform film can be made by any of them.

Thus, adsorption method of the dye may be properly selected in accordance with the viscosity of the coating solution of the metal complex dye, the coating amount, the conductive support, the coating speed, etc. It is preferable that the time which is required to adsorb the dye after coating is as short as possible from a viewpoint of mass production.

Because the unadsorbed metal complex dye causes disturbance of efficiency of the device, it is preferable that they are removed by washing immediately after adsorption. The washing is preferably carried out using a wet-type washing bath with a polar solvent such as acetonitrile, or an organic solvent such as an alcohol-based solvent. To enhance the adsorption amount of the dye, it is preferable to carry out a heat treatment before adsorption. After the heat treatment, it is preferable that the dye is quickly adsorbed at 40 to 800 °C without cooling to a room temperature in order to prevent adsorption of water onto the surface of the semiconductor particles

The total amount of the metal complex dye to be used is preferably 0.01 to 100 mmol per the unit surface area (1 m²) of the conductive support. Further, the amount of the dye to be adsorbed onto semiconductor particles is preferably 0.01 to 1 mmol per g of the semiconductor particles. Such an adsorption amount of the metal complex dye effects a sufficient sensitization to the semiconductors. In contrast, if the amount of the dye is too small, the sensitization effect is not enough. On the other hand, if excessive, the dye unadsorbed onto the semiconductor particles floats, thereby reducing sensitization effect.

With regard to the photoelectric conversion device of the present invention, two or more kinds of dyes may be mixed and used therein to extend the wave range of the photoelectric conversion and to increase a conversion efficiency. In this case, the dyes and their proportion is preferably selected in accordance with the wavelength region and the intensity distribution of a light source. Specifically, two or more kinds of the metal complex dyes of the present invention may be used in combination, or the dye of the present invention and a prior art metal complex dye and/or a polymethine dye may be used in combination.

A colorless compound may be co-adsorbed on the semiconductor particles together with the metal complex dye to weaken an interaction between the metal complex dyes, such as association. Examples of the hydrophobic compounds for the co-adsorption include steroid compounds having a carboxyl group such as chenodeoxycholic acid, etc. Further, an UV-absorbing agent may be used together therewith.

The surface of the semiconductor particles may be treated with amines after adsorbing the metal complex dye to accelerate to remove an excessive metal complex dye. Preferable examples of the amines include pyridine, 4-t-butylpyridine, polyvinylpyridine, etc. The amine may be used as it is when it is liquid, and used as a solution with an organic solvent.

### (C) Charge transfer layer

The charge transfer layer replenishes electrons to the oxidized metal complex dye. Typical examples of materials for use in the charge transfer layer include a an electrolysis solution having a redox coupler dissolved in an organic solvent, a so-called gel electrolyte where a liquid composed of an organic solvent and a redox coupler dissolved therein is penetrated into a polymer matrix, a fused salt containing redox couple, etc. Further, a solid electrolyte and a hole-transporting material may be used for the charge transfer layer.

The electrolysis solution used in the present invention preferably comprises an electrolyte, a solvent and additives. The electrolyte may be: (a) a combination of I₂ and iodides (e.g. metal iodides such as LiI, NaI, CsI, CaI₂, quaternary ammonium iodides such as tetraalkyl ammonium iodide, pyridinium iodide, imidazolium iodide, etc.); (b) a combination of Br₂ and bromides (e.g. metal bromides such as LiBr, NaBr, KBr, CsBr, CaBr₂, quaternary ammonium bromides such as tetraalkyl ammonium bromide, pyridinium bromide, etc.); (c) metal complexes comprising a ferrocyanide-ferricyanide, a ferrocene-ferricinium ion, etc.; (d) sulfur compounds such as sodium polysulfide, alkylthiol-alkyldisulfide, etc.; and (e) viologen dye, hydroquinone-quinone, etc. Among them, a combination of I₂ and iodide such as LiI and quaternary ammonium iodide is preferably used. The above-described electrolytes may be used as a mixture thereof. Further, fused salts described in EP 718288, WO 95/18456, J. Electrochem. Soc., Vol. 143, No. 10, 3099 (1996), Inorg. Chem., 35, 1168 to 1178 (1996), etc. may be used as an electrolyte. When the fused salts are used as an electrolyte, no solvent is necessary to use, generally.

The density of electrolyte in the electrolysis solution is preferably 0.1 to 15 M, more preferably 0.2 to 10 M. When iodine is added to an electrolyte, the iodine density therein is preferably 0.01 to 0.5 M.

It is desirable that used as a solvent for the electrolyte is a compound which exhibits an excellent ionic conductibility. Such a compound exhibits a low viscosity and a high ionic mobility, and/or exhibits a high permittivity and a high actual carrier concentration. The following compounds are given as examples of the above-mentioned solvents.

### (a) Carbonates

Ethylene carbonate, propylene carbonate, vinylene carbonate, butylene carbonate, dimethyl carbonate, diethyl carbonate, methylethyl carbonate, and dipropyl carbonate are preferred examples.

### (b) Lactones

γ-butyrolactone, γ-valerolactone, γ-capryrolactone, crotolactone, γ-caprolactone, and δ-valerolactane are preferred examples.

### (c) Ethers

Ethyl ether, 1,2-dimethoxyethane, diethoxyethane, trimethoxymethane, ethyleneglycol dimethylether, polyethyleneglycol dimethylether, 1,3-dioxolan, and 1,4-dioxan are preferred examples.

### (d) Alcohols

Methanol, ethanol, ethyleneglycol monomethylether, propyleneglycol monoethylether, polyethyleneglycol monoalkylether, and polypropyleneglycol monoalkylether are preferred examples.

### (e) Glycols

Ethyleneglycol, propyleneglycol, polyethyleneglycol, polypropylene glycol, and glycerin are preferred examples.

### (f) Glycol ethers

Ethyleneglycol dialkylether, propyleneglycol dialkylether, polyethyleneglycol dialkylether, and polypropyleneglycol dialkylether are preferred examples.

### (g) Tetrahydrofurans

Tetrahydrofuran, and 2-methyltetrahydrofuran are preferred examples.

### (h) Nitriles

Acetonitrile, glutarodinitrile, propionitrile, methoxyacetonitrile, and benzonitrile are preferred examples.

### (i) Carboxylates

Methyl formate, methyl acetate, ethyl acetate, and methyl propionate are preferred examples.

### (j) Phosphoric acid triesters

Trimethyl phosphate and triethyl phosphate are preferred examples. (k) Heterocyclic compounds

N-methyl pyrrolidone, 4-methyl-1,3-dioxane, 2-methyl-1,3-dioxolan, 3-methyl-2-oxazolidinone, 1,3-propansultone, and sulfolane are preferred examples.

### (1) Others

Aprotic organic solvents such as dimethylsulfoxide, formamide, N,N-dimethylformamide, nitromethane, etc. and water are preferred examples.

Of these compounds, carbonates, nitriles, and heterocyclic compounds are preferred as solvents. Mixed solvent composed of two or more kinds of the solvents may be used if necessary.

In the present invention, a basic compound such as t-butylpyridine, 2-pycoline, 2,6-lutidine, etc. as described in J. Am. Ceram. Soc., 80 (12), 3157 to 3171 (1997) may be added. The concentration of the basic compound is preferably 0.05 to 2 M.

An electrolyte may be gelled (solidified). Gelation may be carried out by: adding a polymer or an oil-gelling agent; polymerization of multifunctional monomers added to the electrolysis solution; or a cross-linking reaction with a polymer. When the electrolyte is gelled by adding the polymer, compounds described in Polymer Electrolyte Reviews-1,2, (edited by J. R. MacCaLLum and C. A. Vincent, ELSEIVER APPLIED SCIENCE) may be used, and polyacrylonitrile or poly(vinylidene fluoride) is particularly preferably used. When the electrolyte is gelled by adding the oil-gelling agent, compounds described in J. Chem. Soc. Japan, Ind. Chem. Soc., 46, 779 (1943), J. Am. Chem. Soc., 111, 5542 (1989), J. Chem. Soc., Chem. Commun., 1993, 390, Angew. Chem. Int. Ed. Engl., 35, 1949 (1996), Chem. Lett., 1996, 885, J. Chem. Soc., Chem. Commun., 545 (1997), etc. may be used as the oil-gelling agent. Among them, preferred are those having an amide structure.

In the case where a gel electrolyte is formed by polymerization of multifunctional monomers co-existing with the electrolyte, the electrolysis solution comprising the multifunctional monomers, a polymerization initiator, the electrolyte and a solvent is prepared, and coated on the dye-sensitized semiconductor particle layer (photosensitive layer 20) according to a method such as a casting method, a coating method, a soaking method and an impregnation method. In this case, the electrolysis solution is preferably gelled by filling voids among the semiconductor particles 21 with the solution in a sol state to form a sol electrolyte layer on the photosensitive layer 20 as shown in Fig. 1, followed by a radical polymerization.

It is preferable that the multifunctional monomer has two or more ethylenycally unsaturated groups. Preferable examples thereof include divinyl benzene, ethyleneglycol diacrylate, ethyleneglycol dimethacrylate, diethyleneglycol diacrylate, diethyleneglycol dimethacrylate, triethyleneglycol diacrylate, triethyleneglycol dimethacrylate, pentaerythritol triacrylate and trimethylolpropane triacrylate.

The gel electrolyte may contain unifunctional monomers together with the above-described multifunctional monomers. Preferable examples of the unifunctional monomers include esters or amides derived from an acrylic acid or an α-alkylacrylic acid such as methacrylic acid (e.g. N-isopropyl acrylamide, acrylamide, 2-acrylamido-2-methylpropane sulfonic acid, acrylamidopropyl trimethylammonium chloride, methyl acrylate, hydroxyethyl acrylate, N-propylacrylate, N-butylacrylate, 2-methoxyethylacrylate, cyclohexylacrylate, etc.), vinyl esters (e.g. vinyl acetate, etc.), maleate or fumarate (e.g. dimethyl maleate, dibutyl maleate, diethyl fumarate, etc.), organic acid salts (e.g. sodium salts of maleic acid, fumaric acid or p-styrene sulfonic acid, etc.), nitriles (e.g. acrylonitrile, methacryronitrile, etc.), dienes (e.g. butadiene, cyclopentadiene, isoprene, etc.), aromatic vinyl compounds (e.g. styrene, p-chlorostyrene, sodium styrene sulfonate, etc.), vinyl compounds having a nitrogen-containing heterocyclic ring, vinyl compounds having a quaternary ammonium salt, N-vinylformamide, N-vinyl-N-methylformamide, vinyl sulfonic acid, sodium vinylsulfonate, vinylidene fluoride, vinylidene chloride, vinyl alkyl ethers (e.g. methyl vinyl ether, etc.), olefins (e.g. ethylene, propylene, 1-butene, isobutene, etc.), and N-phenyl maleimide.
The weight ratio of the multifunctional monomer to the total of the monomers is preferably 0.5 to 70 weight %, more preferably 1.0 to 50 weight %.

The above-described monomers for a gelation can be polymerized by a general radical polymerization method described in Takayuki Otsu and Masaetsu Kinoshita, Kobunshi Gosei no Jikkenho (Kagaku Dojin), Takayuki Otsu, Koza Jugo Hannoron 1 Rajikaru Jugo (I) (Kagaku Dojin), etc. Radical polymerization of the monomers for a gelation can be carried out by heating, light, an ultraviolet ray or electron ray, or by an electrochemical method. Radical polymerization by heating is particularly preferred.

In the case where a cross-linking polymer is formed by heating, preferable examples of the polymerization initiator include azo initiators such as 2,2'-azobis(isobutyronitrile), 2,2'-azobis(dimethylvaleronitrile) and dimethyl 2,2'-azobis(2-methylpropionate), and peroxide initiators such as benzoyl peroxide, etc. The weight ratio of the initiator is preferably 0.01 to 20 weight %, more preferably 0.1 to 10 weight %, based on the total amount of monomers.

The weight ratio of the monomers accounting for the gel electrolyte is preferably in the range of 0.5 to 70 weight %, more preferably 1.0 to 50 weight %.

In the case where the gelation of the electrolyte is accomplished by a cross-linking reaction of polymers, it is desired to use a polymer having a group with a cross-linking reactivity, in combination with a cross-linking agent. Preferable examples of the group with a cross-linking reactivity include nitrogen-containing groups having heterocyclic structure such as a pyridine ring, an imidazole ring, a thiazole ring, an oxazole ring, a triazole ring, a morpholine ring, a piperidine ring, a piperazine ring, etc. Preferable examples of the cross-linking agent include bi- or multifunctional electrophilic agents to be reacted with the nitrogen such as alkyl halide, aralkyl halide, sulfonate, acid anhydride, isocyanate, etc.).

Organic hole-transporting materials and/or inorganic hole-transporting materials may be used in place of the electrolyte. Preferable examples of the organic hole-transporting material include the following compounds.

### (a) Aromatic amines

N,N'-diphenyl-N,N'-bis(4-methoxyphenyl)-(1,1'-biphenyl)-4,4'-diamine described in J. Hagen et al., Synthetic Metal, 89, 215 to 220 (1997), 2,2',7,7'-tetrakis(N,N'-di-p-methoxyphenylamine)-9,9'-spirobifluorene described in Nature, Vol. 395, 8 Oct. 1998, pp. 583 to 585 and WO 97/10617, aromatic diamine compounds composed of linked tertiary aromatic amine units of 1,1'-bis{4-(di-p-tolylamino)phenyl} cyclohexane described in JP-A-59-194393, aromatic amines having 2 or more of tertiary amino groups in which 2 or more of condensed aromatic rings are bonded to nitrogen atom(s), such as 4,4'-bis((N-1-naphthyl-N-phenylamino)] biphenyl described in JP-A-5-234681, aromatic triamines derived from triphenyl benzene, having a starburst structure described in United States Patent No. 4,923,774 and JP-A-308688, aromatic diamines such as N,N'-diphenyl-N,N'-bis(3-methylphenyl)-(1,1'-biphenyl)-4,4'-diamine described in United States Patent No. 4,764,625, α,α,α',α'-tetramethyl-α,α'-bis{4-(di-p-tolylamino)phenyl}-p-xylene described in JP-A-3-269084, p-phenylenediamine derivatives, asymmetric triphenylamine derivatives described in JP-A-4-129271, compounds having a pyrenyl group substituted by a plurality of aromatic diamino groups described in JP-A-4-175395, aromatic diamines where tertiary aromatic amine units are linked via ethylene groups described in JP-A-4-2641 89, aromatic diamines having a styrene moiety described in JP-A-4-290851, benzylphenyl compounds described in JP-A-4-364153, tertiary amines linked via a fluorene moiety described in JP-A-5-25473, triamine compounds described in JP-A-5-239455, bis(dipyridylamino)biphenyl described in JP-A-5-320634, N,N,N-triphenylamine derivatives described in JP-A-6-1972, aromatic diamines having a phenoxazine structure described in JP-A-7-138562, diaminophenylphenanthridine derivatives described in JP-A-7-252474, etc.

### (b) Oligothiophene compounds

α-octylthiophene and α,ω-dihexyl-α-octylthiophene described in Adv. Mater., Vol. 9, No. 7, 5578 (1997), hexadodecyldodecythiophene described in Angew. Chem. Int. Ed. Engl., 34, No. 3, 303 to 307 (1995), 2,8-dihexylanthra[2,3-b:6,7-b'] dithiophene described in JACS, Vol. 120, No. 4, 664 to 672 (1998), etc.

### (c) Conductive polymers

Polypyrrole (K. Murakoshi et al., Chem. Lett., 1997, p. 471), polyacetylene and derivatives thereof, poly(p-phenylene) and derivatives thereof, poly(p-phenylenevinylene) and derivatives thereof, polythienylenevinylene and derivatives thereof, polythiophene and derivatives thereof, polyaniline and derivatives thereof, and polytoluidine and derivatives thereof described in Handbook of Organic Conductive Molecules and Polymers, Vol. 1 to 4 (edited by NALWA, published by WILEY), etc.

As described in Nature, Vol. 395, 8 Oct. 583 to 585 (1998), to the organic hole-transporting material may be added a compound containing cation radical such as tris(4-bromophenyl)aminium hexachloroantimonate to control a dopant level, and/or a salt such as Li[(CF₃S0₂)₂N] to carry out a potential-control of surface of the oxide semiconductor thereby compensating a space-charge layer.

The organic hole-transporting materials may be introduced into the electrodes by a vacuum deposition method, a casting method, a coating method, a spin-coating method, a soaking method, an electrolytic polymerization method, a photo electrolytic polymerization method, etc. When the hole-transporting material is used in place of the electrolysis solution, it is preferable that a titanium dioxide thin layer is coat as an undercoating layer to be shortproof by a spray pyrolysis described in Electrochim. Acta., 40, 643 to 652 (1995), etc.

In the case of an inorganic solid compound is used in place of the electrolyte, copper iodide (p-Cul) described in J. Phys. D:Appl. Phys., 31, 1492 to 1496 (1998), copper thiocyanide described in Thin Solid Films, 261, 307 to 310 (1995), J. Appl. Phys., 80(8), 15 October 1996, 4749 to 4754, Chem. Mater., 10, 1501 to 1509 (1998) and SemiCond. Sci. Technol., 10, 1689 to 1693, and the like may be introduced into the electrode by a casting method, a coating method, a spin-coating method, a soaking method, an electrolytic metal plating method, etc.

In order to form the charge transfer layer, two methods as described below may be used. One is a method comprising the steps of laminating a counter electrode on the semiconductor particle layer through a spacer, and dipping open-ends of both layers into the electrolysis solution to spread the electrolysis solution into the interior of the semiconductor particle layer and voids between the semiconductor particle layer and the counter electrode. Another is a method comprising the steps of coating the electrolyte solution onto the semiconductor particle layer, thereby spreading the solution into the semiconductor particle layer and forming the charge transfer layer thereon, and setting the counter electrode on the charge transfer layer.

In the former case, may be used as a method for spreading the electrolyte solution into the voids between the semiconductor particle layer and the counter electrode are a normal pressure method utilizing a capillarity, and a reduced pressure method which comprises pumping up the solution from the upper open-ends between the semiconductor particle layer and the counter electrode, not soaked in the solution.

In the latter case, an wet-type charge transfer layer may be applied the counter electrode thereon before drying, and then a treatment for preventing liquid-leakage is carried out at the edges thereof. On the other hand, charge transfer layer comprising a gel electrolyte may be coated in a liquid state, gelled by polymerization, etc., and applied the counter electrode thereon, or may be gelled after the application of the counter electrode thereon. Examples of a method for forming a charge transfer layer comprising an wet-type organic hole transporting material or a gel electrolyte include a soaking method, a roller method, a dip method, an air-knife method, an extrusion method, a slide-hopper method, a wire-bar method, a spin method, a spray method, a cast method, various printing methods, etc. similarly to the case of forming the semiconductor particle layer, or adsorbing a dye mentioned above. A charge transfer layer comprising a solid electrolyte or a solid hole transporting material may be formed by a dry film-forming method such as a vacuum deposition method and a CVD method, and followed by applying the counter electrode thereon.

In the case of forming the charge transfer layer comprising an electrolysis solution or a wet-type hole transporting material that is difficult to be solidified, it is preferable that the edges of the layer is sealed rapidly after coating. On the other hand, in the case of forming the charge transfer layer comprising a hole transporting material which is able to be solidified, it is preferable that the hole transfer layer according to a wet-type application, and then the material is solidified by photo-polymerization, thermal radical polymerization, etc. As mentioned, a method for forming the charge transfer layer may be properly selected in accordance with physical properties of the electrolyte and production conditions.

The water content of the charge transfer layer is preferably 10,000 ppm or less, more preferably 2,000 ppm or less, and particularly preferably 100 ppm or less.

### (D) Counter electrode

When the photoelectric conversion device of the present invention is applied to a photo-electrochemical cell, the counter electrode acts as an anode of the cell. The counter electrode may be a single layer structure of a counter conductive layer comprising an electrically conductive material, or composed of the counter electrically conductive layer and a support, similarly to the above-described conductive support. Examples of the material for the counter electrically conductive layer include metals such as platinum, gold, silver, copper, aluminum, rhodium and indium, carbon, electrically conductive metal oxides such as indium-tin composite oxides, fluorine-doped tin oxides, etc. The substrate for the counter electrode is preferably made of glass or plastic, and the electrically conductive layer is coated or vapor-deposited thereon. The thickness of the counter electrically conductive layer is not limited in particular, preferably 3 nm to 10 µm. In the case of the metal counter electrically conductive layer, the thickness thereof is preferably 5 µm or less, more preferably 5 nm to 3 µm.

Because any one or both of the conductive support and the counter electrode may be irradiated, at least one of them may be substantially transparent to have light reached to the photosensitive layer. From a viewpoint of improving an electric generation efficiency, the conductive support is preferably transparent, and light is irradiated from the side thereof. In this case, the counter electrode preferably has a light-reflective property. Such a counter electrode may be made of glass or plastic having vapor-deposited metal or electrically conductive oxides thereon, or a metal.

The counter electrode may be (i) applied on the charge transfer layer formed beforehand, or (ii) placed on the semiconductor particle layer through a spacer before forming the charge transfer layer. In the case (i), the electrically conductive material may be coated, metal-plated, or vapor-deposited (PVD, CVD, etc.) directly on the charge transfer layer, or the electrically conductive layer composing the counter electrode may be laminated on the charge transfer layer. In the case (ii), the counter electrode may be settled on the semiconductor particle layer through the spacer, and the open ends between the electrode and the semiconductor layer is soaked in an electrolysis solution. The electrolysis solution penetrates into the voids between the counter electrode and the semiconductor particle layer, utilizing capillarity or reduced pressure. The electrolyte molecules may be cross-linked by heating, etc., if necessary. Similar to the case of the conductive support, it is preferable to use the metal lead for reducing resistance of the electrode particularly in the case where the counter electrode is transparent. Further, preferable materials of the metal lead, preferable methods for setting the metal lead, preferable reduced-degree of the incident light amount caused by the metal lead, etc. are the same as the case of the conductive support, mentioned above.

### (E) Other Layers

Functional layers such as a protective layer and a reflection-preventing layer may be formed on one of or both of the conductive support and the counter electrode each acting as the electrode. In the case where such functional layers are formed in a fashion of multi-layers, they may be formed by a simultaneous multi-layer coating method or a successive coating method. The simultaneous multi-layer coating method is preferred from a viewpoint of productivity. A slide-hopper method and an extrusion method are suitable from the viewpoint of both productivity and homogeneity of a coated film for the simultaneous multi-layer coating method. The functional layers may be formed by a vapor-deposition method and a sticking method, and these methods may be selected in accordance with the materials for the layer.

### (F) Specific examples of interior structure of photoelectric conversion device

As described above, the photoelectric conversion device may have various interior structures in accordance with an end of use. These structures are classified into two major forms composed of a structure allowing incidence of light from both faces, and a structure allowing it from only one face. Fig. 2 to 9 illustrate examples of the interior structure of the photoelectric conversion device which can be preferably used in the present invention.

Fig. 2 illustrates a preferable structure of a photoelectric conversion device of the present invention, where a photosensitive layer 20 and a charge transfer layer 30 formed between a transparent electrically conductive layer 10a and a transparent counter electrically conductive layer 40a. This structure allows incidence of light from both faces of the photoelectric conversion device.

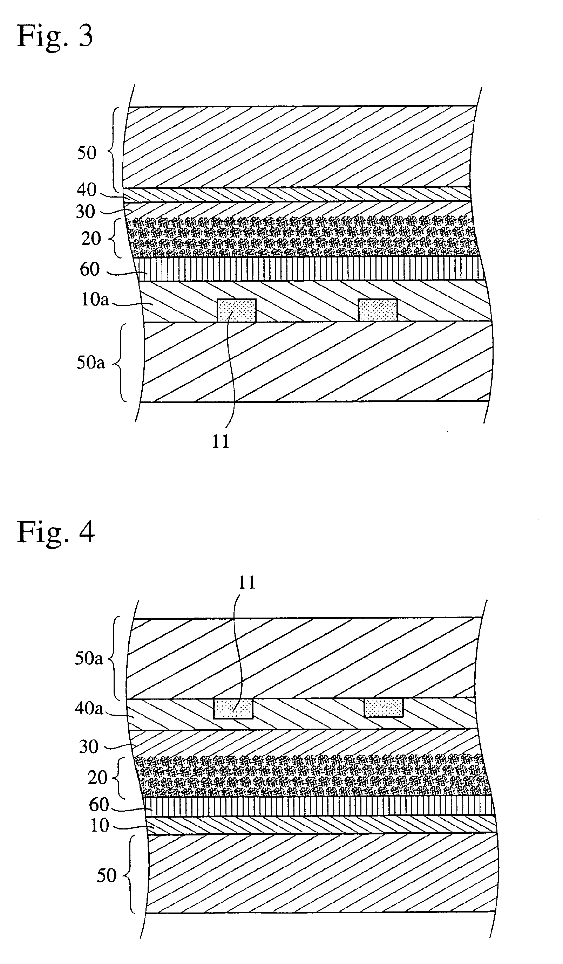

Fig. 3 illustrates a preferable structure of a photoelectric conversion device of the present invention, where on a transparent substrate 50a partially having a metal lead 11 is formed a transparent electrically conductive layer 10a, an undercoating layer 60, a photosensitive layer 20, a charge transfer layer 30 and a counter electrically conductive layer 40 are laminated thereon in this order, and a substrate 50 is further set thereon. This structure allows incidence of light from the electrically conductive layer side.

Fig. 4 illustrates a preferable structure of a photoelectric conversion device of the present invention, where a photosensitive layer 20 is applied on a substrate 50 having an electrically conductive layer 10 thereon through an undercoating layer 60, a charge transfer layer 30 and a transparent counter electrically conductive layer 40a are formed thereon, and further a transparent substrate 50a locally having a metal lead 11 thereon is placed so that the metal lead 11 side orients -inward. This structure allows incidence of light from the counter electrode side.

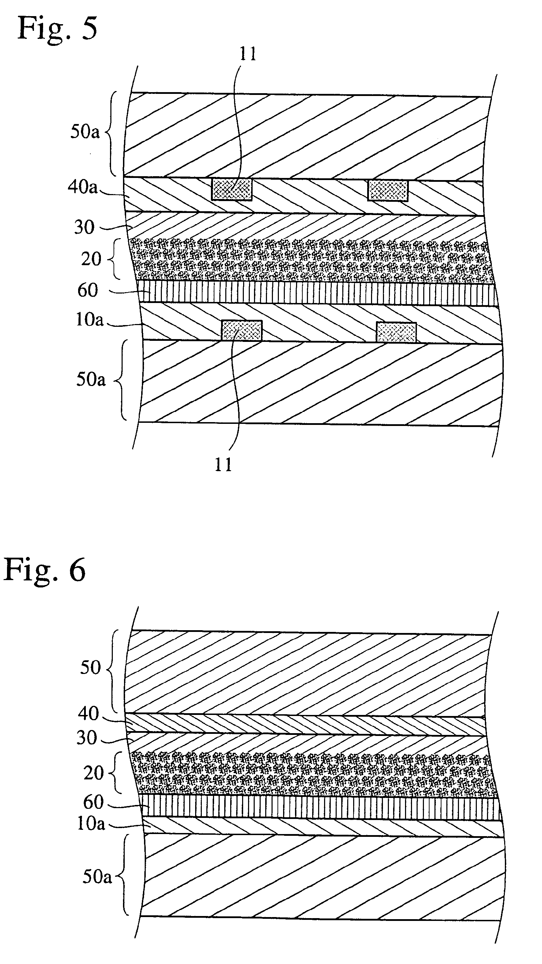

Fig. 5 illustrates a preferable structure of a photoelectric conversion device of the present invention, where on two transparent substrates 50 each having a metal lead 11 partially are formed a transparent electrically conductive layer 10a or a transparent counter electrically conductive layer 40a, respectively, and an undercoating layer 60, a photosensitive layer 20 and a charge transfer layer 30 placed between the conductive layers. This structure allows incidence of light from both faces of the photoelectric conversion device.

Fig. 6 illustrates a preferable structure of a photoelectric conversion device of the present invention, where on a transparent substrate 50a having a transparent electrically conductive layer 10a thereon is formed a photosensitive layer 20 through an undercoating layer 60, a charge transfer layer 30 and a counter electrically conductive layer 40 are applied thereon, and further a substrate 50 is placed thereon. This structure allows incidence of light from the electrically conductive layer side.

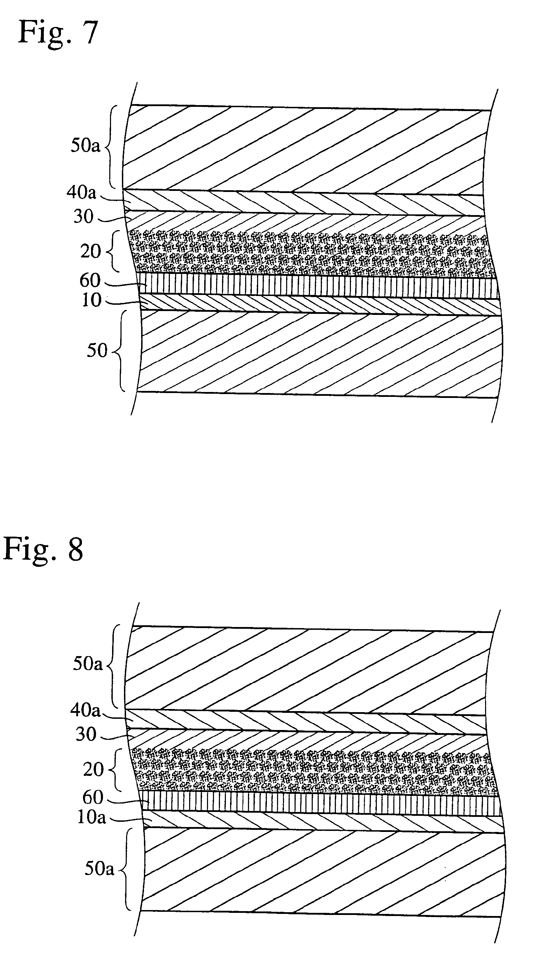

Fig. 7 illustrates a preferable structure of a photoelectric conversion device of the present invention, where on a substrate 50 having an electrically conductive layer 10 thereon is applied a photosensitive layer 20 through an undercoating layer 60, a charge transfer layer 30 and a transparent counter electrically conductive layer 40a are applied thereon, and further a transparent substrate 50a is placed thereon. This structure allows incidence of light from the counter electrode side.

Fig. 8 illustrates a preferable structure of a photoelectric conversion device of the present invention, where on a transparent substrate 50a having a transparent electrically conductive layer 10a thereon is applied a photosensitive layer 20 through an undercoating layer 60, a charge transfer layer 30 and a transparent counter electrically conductive layer 40a are applied thereon, and further a transparent substrate 50a is placed thereon. This structure allows incidence of light from both faces of the photoelectric conversion device.

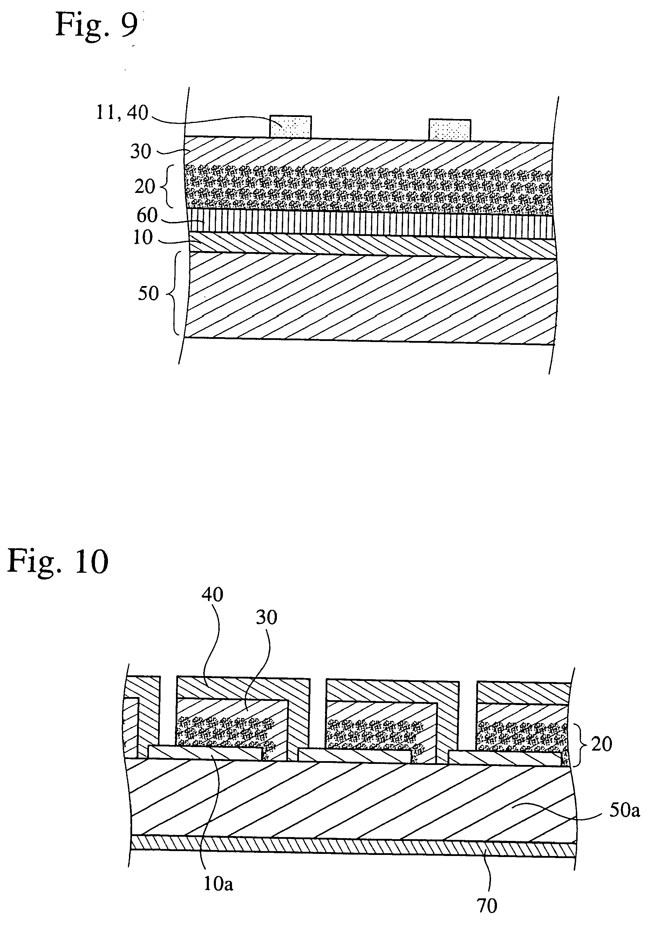

Fig. 9 illustrates a preferable structure of a photoelectric conversion device of the present invention, where on a substrate 50 having an electrically conductive layer 10 thereon is applied a photosensitive layer 20 through an undercoating layer, a solid charge transfer layer 30 is applied thereon, and further a counter electrically conductive layer 40 or a metal lead 11 is locally applied thereon. This structure allows incidence of light from the counter electrode side.

### [3] Photo-electrochemical cell

The photo-electrochemical cell of the present invention comprises the above-described photoelectric conversion device that is designed to work in the outer circuit. The side face of the photo-electrochemical cell is preferably sealed with a polymer or an adhesive agent, etc. to prevent deterioration of the compositions thereof and volatility of the content in the cell. The outer circuit is connected to the conductive support and the counter electrode via a lead. Various known circuits may be used in the present invention.

### [4] Dye-sensitized solar cell

In the case where the photoelectric conversion device of the present invention is applied to a so-called solar cell, the interior structure of the photoelectric conversion device may be essentially the same as above. Module structures of the solar cell comprising the photoelectric conversion device of the present invention will be explained below.

The dye-sensitized solar cell of the present invention may have essentially the same module structure as that of prior art solar cells. The solar cell module generally has a structure where a cell is formed on a substrate made of metal, ceramic, etc., they are covered with a packing resin, a protective glass, etc., and light is introduced from an opposite side of the substrate. In addition, the solar cell module may have a structure where a cell is formed on a substrate made of a transparent material such as a tempered glass, and light is introduced from the transparent substrate side. Specifically known as a module structure are structures that are called "superstraight type", "substrate type" or "potting type", substrate-integrated type structure used for an amorphous silicon solar cell, etc. The dye-sensitized solar cell of the present invention may have a module structure properly selected from the above structures in accordance with ends, places and environment at use.

The super straight type modules and the substrate type modules generally have a structure where cells are set at a regular intervals between substrates, adjoining cells are connected by a metal lead, a flexible wirering, etc., and collector electrodes are set at the outer marginal portion so that a generated electric power can be delivered to the outside. One or both side of the substrates are transparent and subjected to a reflection-preventing treatment. Various kinds of plastic material such as ethylene vinyl acetate (EVA) may be contained between the substrate and the cell to protect the cell or to improve a collector efficiency. Such a plastic material is may be used in a form of a film or a packing resin. In the case of the solar cell used at a place where the surface of the cell is not necessarily covered with a hard material, such as a place without a shock from the outside, the substrate of one side can be omitted by forming a surface protective layer composed of a transparent plastic film, or by hardening the above-described packing resin to give a protection function. To seal the interior of the cell and to secure rigidity of a module, the periphery of the substrates may be sandwiched and fixed by metallic flames, and the substrates and the flames may be sealed with a sealant. Further, flexible materials may be used for the cell proper, the substrate, the packing agent and the sealant to constructing the solar cell on a curved surface.

For example, the super straight type solar cell module may be manufactured by the following steps of: placing cells on a front substrate sent out from a substrate-supplying device together with lead lines for connecting a sealant to the cells and a sealant for back surface while carrying the front substrate by a belt conveyer, etc.; placing a back substrate or a back cover thereon; and setting flames at the outer edge portion.

The substrate type solar cell may be manufactured by the following steps of: placing cells on a substrate sent out from a substrate-supplying device together with lead lines for connecting the cells and a sealant, etc. while carrying the substrate by a belt conveyer, etc.; placing a front cover thereon; and setting flames at the outer edge portion.

Fig. 10 shows structure of an embodiment of the substrate-integrated type solar cell produced by modularizing a photoelectric conversion device of the present invention. The solar cell shown in Fig. 10 has a structure where cells having a transparent electrically conductive layer 10a, a photosensitive layer 20 containing dye-adsorbed TiO₂, a solid charge transfer layer 30 and a metal counter electrically conductive layer 40 are modularized on one surface of a transparent substrate 50a, and a reflection-preventing layer 70 is applied on the other surface of the substrate. In such a structure, it is preferable to increase an area ratio of the photosensitive layer 20 observed from the substrate 50a side for enhancing an efficiency of utilizing incident light.

As for the solar cell shown in Fig. 10, a desired module structure can be obtained by patterning according to a semiconductor process technique such as selective metal plating, selective etching, CVD, PVD, etc., or a mechanical method such as laser scribing, plasma CVM, polishing, etc. so that the transparent electrically conductive layers, the photosensitive layers, the charge transfer layers and the counter electrode etc. are three-dimensionally arranged at a regular interval on the substrate. The plasma CVM is described in Solar Energy Materials and Solar Cells, 48, p 373 to 381, etc.

Other materials and processes used in the cell of the present invention will be described in detail below.

As a material for the sealant, various materials such as a liquid EVA (ethylene vinyl acetate), an EVA film, a mixture of fluorinated vinylidene copolymer and an acrylic resin, etc. may be used in accordance with objects such as application of weather-resistance or electric insulation, improvement in light-condensing efficiency, protection of a cell (improvement in impact resistance), etc. The outer edge of the module and the frame surrounding the fringe are preferably sealed with the sealant having high weather-resistance and moisture permeability. The strength and light transmittance of the sealed cell can be enhanced by adding a transparent filter into the sealant.

When the sealant is fixed on the cell, a method suited to a property of the sealant is preferably used. Various methods therefor may be used such as roll pressurization followed by thermal adherence, vacuum pressurization followed by thermal adherence, etc. for the film sealant, and roll coat, bar coat, spray coat, screen printing, etc. for the liquid or paste sealant.

It is preferable that a flexible material such as PET and PEN is used for a substrate, because after constructing the cells on a roll-like support, the sealing layer can be successively laminated according to the above-described methods to obtain a high productivity.

To increase a production efficiency of electric power, the light-taking surface of the substrate, generally a tempered glass substrate, of the module may be subjected to a reflection-preventing treatment.
The reflection-preventing treatment may comprise laminating a reflection-preventing film, coating a reflection-preventing layer, etc.

The surface of the solar cell may be grooved or textured, thereby enhancing efficiency of utilizing incident light.

To increase a production efficiency of electric power, it is most important to taking light in the module without a loss, and it is also important to reflect light reached to the inside of the solar cell through a photoelectric conversion layer, and return effectively to the layer.
The light reflectance may be increased by vapor-depositing or metal-plating the substrate with Ag, A1, etc. after a mirror plane-polishing, applying a layer comprising an Al-Mg alloy, an Al-Ti alloy, etc. as reflective layer at the lowest layer in the solar cell, making the lowest layer to a texture structure by annealing.

To increase the production efficiency of electric power, it is important to minimize a resistance of connection between cells, thereby preventing reduction in an inner voltage. The cells are generally connected each other by a wire bonding method or using an electrically conductive flexible sheet. In addition, the cells may be connected by methods such as electrically connecting while fixing the cells by an electrically conductive adhesives, adhesive tapes, etc., and pattern-coating an electrically conductive hot melt at an intended position.

A solar cell comprising a flexible support made of a polymer film, etc. may be manufactured by a method comprising the steps: forming cells in the same manner as described above while sending out a roll-like support; cutting it to an intended size; and sealing the marginal portion thereof with a flexible, moisture permeable material. The solar cell may have a module structure called "SCAF" described in Solar Energy Materials and Solar Cells, 48, p 383 to 391. Further, the solar cell comprising the flexible support may be-used while adhered and fixed to a curved glass, etc.

As described above in detail, the solar cells comprising the photoelectric conversion device of the present invention may have various kinds of forms and functions in accordance with ends of use and environment of use.

### EXAMPLES

The present invention will be explained in more detail with reference to examples below. The present invention is not restricted by these examples.

### EXAMPLE 1

The first metal complex dye, photoelectric conversion device and photo-electrochemical cell

### 1. Synthesis of metal complex dye

Specific methods for synthesizing the first metal complex dyes of the present invention will be explained below.

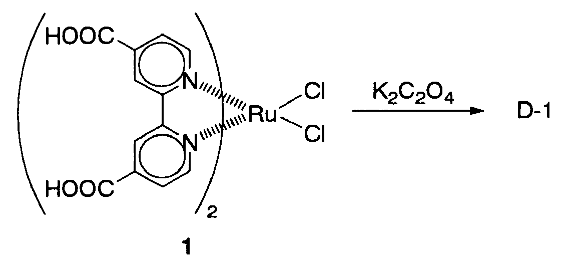

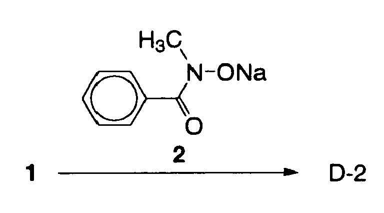

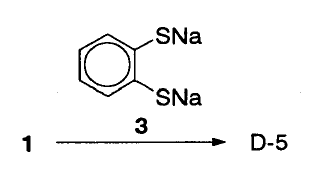

### (A) Synthesis of D-1

In a mixed solvent composed of 10 ml of ethanol and 10 ml of water were dissolved 0.66 g (1 mmol) of complex **1** synthesized by a method described in J. Am. Chem. Soc., 115, 6382 (1993) and 1.68 g (10 mmol) of potassium oxalate. The resultant solution was refluxed for 6 hours under nitrogen, and then cooled. To this was added triethylamine to adjust the pH value thereof to 10, and concentrated. Residue was purified by column chromatography using Sephadex column LH-20 (developing solvent: methanol) to obtain 0.36 g of the metal complex dye D-1 (crystal, 50% yield). The structure of the product was identified by NMR spectra and MS spectra.

### (B) Synthesis of D-2

The metal complex dye D-2 was synthesized in the same manner as synthesis of D-1 except for using sodium hydroxamate **2** in place of potassium oxalate in the same molar amount. The structure of the product was identified by NMR spectra and MS spectra.

### (C) Synthesis of D-5

The metal complex dye D-5 was synthesized in the same manner as synthesis of D-1 except for using sodium 1,2-phenylenesulfide **3** in place of potassium oxalate in the same molar amount. The structure of the product was identified by NMR spectra and MS spectra.

### (D) Syntheses of other dyes

The first metal complex dyes of the present invention other than the above-described dyes can be also easily synthesized by using suitable ligands in a similar method to above.

### 2. Evaluation of thermal stability of dye in solution

3-methoxypropionitrile solutions -each comprising 1x10⁻⁴ mol/l of the first metal complex dye D-1, D-2, D-5, D-46 or D-47, or a comparative dye 1 illustrated below were prepared. The thermal stability of each dye was evaluated by a retention (%) of maximum absorbance in the solutions after leaving the solution for 100 hours at 80 °C. The results are shown in Table 1.

**Table 1**

| | Retention of Maximum Absorbance (%) |
|---|---|
| D-1 | 98 |
| D-2 | 97 |
| D-5 | 93 |
| D-46 | 98 |
| D-47 | 98 |
| Comparative Dye 1 | 77 |

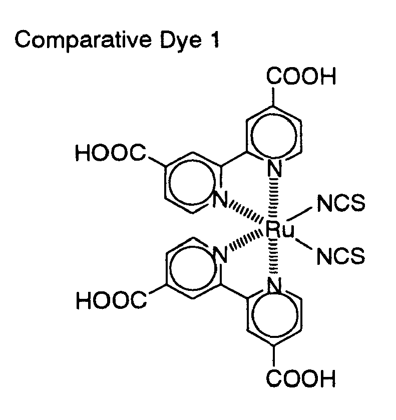

As shown in Table 1, while the comparative dye 1 exhibited significant reduction of the maximum absorbance by de-sulfurized decomposition, each metal complex dyes of the present invention exhibited an excellent thermal stability with little reduction of the maximum absorbance.

### 3. Preparation of titanium dioxide dispersion

A stainless steel vessel coated with Teflon inside and having an inner volume of 200 ml was charged with 15 g of titanium dioxide Degussa P-25 manufactured by Nippon Aerosil K.K., 45 g of water, 1 g of a dispersant Triton X-100 manufactured by Aldrich, and 30 g of zirconia beads having a diameter of 0.5 mm manufactured by Nikkato K.K. These contents were subjected to a dispersion treatment at 1500 rpm for 2 hours by means of a sand-grinder mill manufactured by Imex K.K. The zirconia beads were removed from the resulting dispersion by filtration to obtain the titanium dioxide dispersion. The average particle diameter of the titanium dioxide particles in the dispersion was 2.5 µm. Incidentally, the particle diameter was measured by Master Sizer manufactured by MALVERN.

### 4. Preparation of dye-adsorbed TiO₂ electrode

The above-described dispersion was coated on an electrically conductive surface of a conductive glass having a fluorine-doped tin oxide layer thereon by a glass bar. Used as the conductive glass was 20 mm × 20 mm of TCO Glass-U manufactured by Asahi Glass K.K. with surface resistance of approximately 30 Ω/square. A coating amount of the semiconductor particles was 20 g/m². Herein, on the eight glasses were coated the dispersion at once after adhesive tape was attached to a part of the conductive surface (3 mm from the edge) of each conductive glass as a spacer, and the glasses were arranged so that the adhesive tapes come to both edges thereof. The coated glasses were air-dried for one day at a room temperature after peeling the adhesive tapes. Next, the glasses were placed in an electric furnace (muffle furnace FP-32, manufactured by Yamato Science K.K.), followed by calcinating at 450 °C for 30 minutes to obtain TiO₂ electrodes. After the electrodes were taken out of the furnace and cooled, they were immersed in the methanol solutions each comprising the metal complex dye of the present invention or the comparative dye 1 for 15 hours to absorbing the dyes. The concentration of the dye in the methanol solution was 3 × 10⁻⁴ mol/l. The dye-adsorbed TiO₂ electrodes were further immersed in 4-t-butylpyridine for 15 minutes, then washed with ethanol and air-dried. The thickness of thus-obtained photosensitive layer was 10 µm.

### 5. Preparation of photo-electrochemical cell

The 20 mm × 20 mm of dye-sensitized TiO₂ electrode glass substrate prepared as described above was put on platinum-vapor deposited glass having the same size as the TiO₂ electrode. Next, an electrolysis solution composed of 3-methoxypropionitrile, and 0.65 mol/l of 1-methyl-3-hexylimidazolium iodide and 0.05 mol/l of iodine as an electrolyte was permeated into a crevice between the glasses through capillarity to be introduced into the TiO₂ electrode, thereby obtaining a photo-electrochemical cell. According to this example, the photo-electrochemical cell as shown in Fig. 1 was manufactured, where the conductive support of the electrically conductive glass comprising the transparent substrate 50a of glass and the electrically conductive layer 10a applied thereon, the photosensitive layer 20 of the dye-sensitized TiO₂, the charge transfer layer 30 of the above-described electrolysis solution, the counter electrically conductive layer 40 of platinum, and the transparent substrate 50a of glass were laminated in this order, and sealed with an epoxy-based sealant.

### 6. Measurement of photoelectric conversion efficiency, and stability to heat and light

A simulated sunlight was irradiated to the photo-electrochemical cell, and the electricity generated in the cell was measured by current-voltage tester Keithley SMU238. The simulated sunlight was obtained by passing light of a 500 W xenone lamp manufactured by Ushio K.K. through an AM 1.5 filter manufactured by Oriel Co. and a sharp cut filter Kenko L-42. The simulated sunlight was free of an ultraviolet radiation and had intensity of 86 mW/cm². This measurement was carried out with respect to the photo-electrochemical cell each comprising the metal complex dyes shown in Table 2. The photoelectric conversion efficiency (η) of each cell is also shown in Table 2. Further, retention (%) of the photoelectric conversion efficiency after a continuous irradiation of the simulated sunlight for 720 hours at 80 °C is also shown in Table 2.

**Table 2**

| Metal Complex Dye | Photoelectric Conversion Efficiency (%) | Retention of Photoelectric Conversion Efficiency (%) |
|---|---|---|
| D-1 | 5.6 | 95 |
| D-2 | 5.5 | 95 |
| D-7 | 4.2 | 90 |
| D-16 | 6.1 | 95 |
| D-17 | 6.0 | 94 |
| D-20 | 5.7 | 96 |
| D-22 | 4.8 | 92 |
| D-25 | 5.8 | 95 |
| D-30 | 5.9 | 95 |
| D-34 | 6.0 | 94 |
| D-36 | 5.2 | 87 |
| D-37 | 5.1 | 86 |
| D-46 | 6.0 | 98 |
| D-47 | 6.2 | 98 |
| D-48 | 5.9 | 97 |
| D-55 | 6.2 | 98 |
| D-84 | 5.2 | 89 |
| Comparative Dye 1 | 5.9 | 74 |

Table 2 showed that the first photo-electrochemical cell containing the first dye of the present invention exhibited the photoelectric conversion efficiency equal or superior to that of the cell containing the comparative dye 1. In addition, the first cell of the present invention exhibited much superior stability to heat and light, as compared with the cell containing the comparative dye 1.

As explained above in detail, the first metal complex dye of the present invention has a high stability to heat and light, and can effectively sensitize semiconductor particles. Consequently, the first photoelectric conversion device using the first dye exhibits a high stability to heat and light and an excellent photoelectric conversion efficiency. The first photo-electrochemical cell comprising the first device of the present invention is extremely useful as a solar cell.

### EXAMPLE 2

The second metal complex dye, photoelectric conversion device and photo-electrochemical cell

### 1. Synthesis of metal complex dye

Specific methods for synthesizing the second metal complex dyes D-100, D-138, D-93, D-136, D-95 and D-137 of the present invention will be explained below.

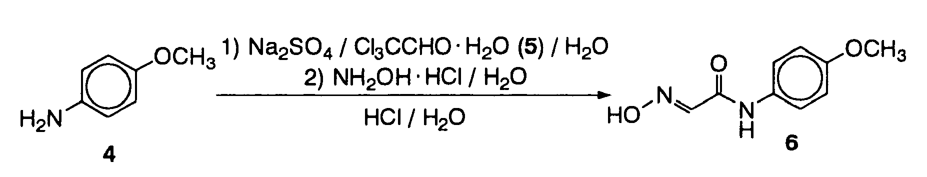

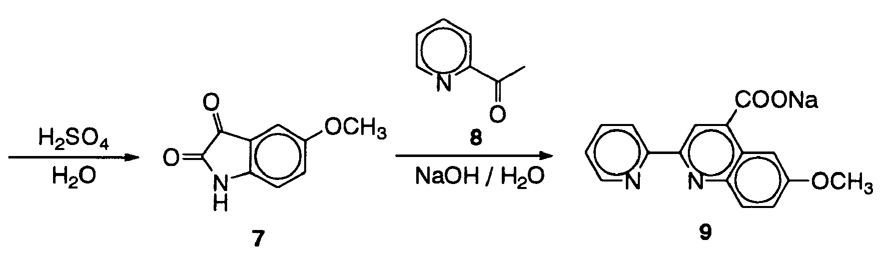

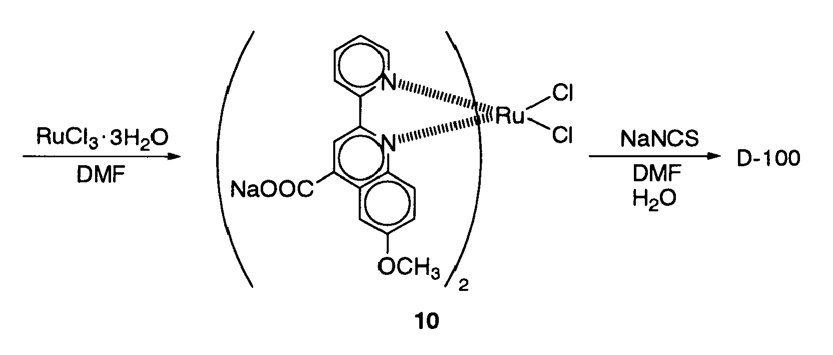

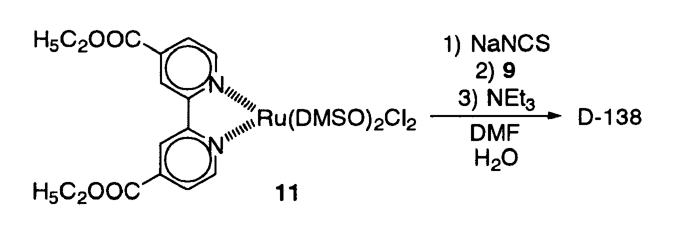

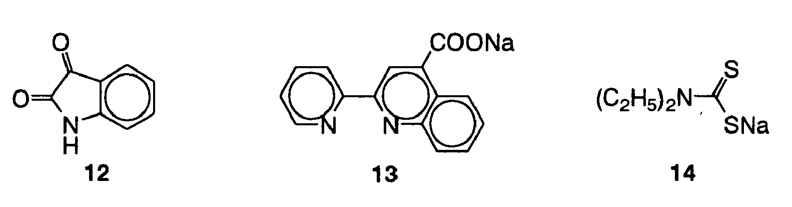

### (A) Synthesis of D-100

24.6 g (0.2 mol) of p-anisidine **4** and 20 ml of conc. HCl were dissolved in 150 ml of water, and to this was added an aqueous solution prepared by adding 39.7 g (0.24 mol) of chloral hydrate **5** and 250 g of sodium sulfate to 850 ml of water. To the resulting solution was added aqueous solution prepared by adding 49.7 g (0.71 mol) of hydroxylamine hydrochloride to 600 ml of water. After 10 minutes of reflux, the aqueous solution was cooled, filtered, and washed with water to obtain 33.7 g of oxime 6 (brown crystal, 87% yield).

17.5 g (90 mmol) of oxime **6** was dissolved in 100 ml of 90 % sulfuric acid, and the resultant solution was stirred for 10 minutes at 80 °C. The solution was cooled, stirred in 2 L of water to generate crystal, and filtered. The crystal was washed with water to obtain 5.0 g of methoxyisatin **7** (31 % yield).

To a mixture of 1.95 g (11 mmol) of methoxyisatin **7** and 1.21 g (10 mmol) of acetylpyridine **8** was added 5.5 g of NaOH 33 % aqueous solution dropwise at 5 °C. The solution was stirred for 1 hour at 5 °C and for 1 hour at 60 °C, and added 10 ml of iced water to. The resultant was filtered, and washed with iced water and acetone to obtain 1.12 g of pyridylquinoline **9** (crystal, 31 % yield).

0.60 g (2 mmol) of pyridylquinoline **9** and 0.26 g (1 mmol) of ruthenium chloride trihydrate were dissolved in 15 ml of dry N,N-dimethylformamide (DMF). The solution was refluxed for 8 hours under nitrogen in the dark, and distilled under a reduced pressure. Residue was dispersed in acetonitrile and filtered to obtain 0.77 g of ruthenium complex **10** (crystal, 99% yield).

0.143 g (0.2 mmol) of ruthenium complex 10 and 0.18 g (2.2 mmol) of sodium thiocyanate were dissolved in a mixed solvent-composed of 10 ml of DMF and 3 ml of water. The solution was refluxed for 6 hours under nitrogen in the dark, and distilled under reduced pressure. Residue was dissolved in water and to this was added dilute nitric acid, thereby depositing precipitates. The solution was filtered and washed with water, and residue was purified by column chromatography using Sephadex column LH-20 (developing solvent: methanol) to obtain 0.072 g of the metal complex dye D-100 (50% yield). The structure of the product was identified by NMR spectra.

### (B) Synthesis of D-138

0.12 g (0.2 mmol) of ruthenium complex **11** synthesized referring to J. Chem. Soc., Dalton, 1973, 204 and 0.032 g (2.4 mmol) of sodium thiocyanate were dissolved in a mixed solvent composed of 30 ml of N,N-dimethylformamide and 10 ml of water, and the solution was refluxed for 2 hours under nitrogen in the dark. To this was added 0.06 g (0.2 mmol) of pyridylquinoline **9**, and the resultant solution was refluxed for 6 hours and further for 6 hours after adding 15 ml of triethylamine thereto. The reaction mixture was concentrated, and residue was dissolved in methanol and purified by column chromatography using Sephadex column LH-20 (developing solvent: methanol). Fractions of desired product were concentrated, and residue was dissolved in water. To this was added dilute nitric acid for depositing crystal, and the resultant solution was filtered to obtain 0.060 g of the metal complex dye D-138 (41 % yield). The structure of the product was identified by NMR spectra.

### (C) Synthesis of D-93 and D-136

Pyridylquinoline **13** was synthesized in the same manner as synthesis of pyridylquinoline **9** except for using the commercially available isatin **12** in place of methoxyisatin **7** in the same molar amount. The metal complex dye D-93 and D-136 were synthesized in the same manners as syntheses of D-100 and D-138 except for using the pyridylquinoline **13** in place of the pyridylquinoline **9**, respectively. The structures of the products were identified by NMR spectra.

### (D) Synthesis of D-95 and D-137

The metal complex dye D-95 and D-137 were synthesized in the same manners as in syntheses of D-93 and D-136 except for using sodium dithiocarbamate **14** in place of sodium thiocyanate in 1/2 molar amount, respectively. The structures of the products were identified by NMR spectra.

### (E) Syntheses of other dyes

The second metal complex dyes of the present invention other than the above-described dyes can be also easily synthesized by using suitable ligands in a similar method to above. Ligands in the second dyes of the present invention are commercially available, or can be easily synthesized referring to Synth. Commun., 27, 2165 (1997), Aust. J. Chem., 25, 1631 (1972), etc. or references therein.

### 2. Measurement of absorption spectrum

With regards to D-93, D-95, D-100, D-136, D-137, D-138 and the comparative dye 1, absorption spectra were measured. A maximum absorption wavelength and a long wavelength side absorption edge according to the dyes were shown in Table 3.

**Table 3.**

| Metal Complex Dye | Maximum Absorption Wavelength (in MeOH, nm) | Long Wavelength Side Absorption Edge (nm) |
|---|---|---|
| D-93 | 580 | 850 |
| D-95 | 605 | 900 |
| D-100 | 565 | 850 |
| D-136 | 555 | 850 |
| D-137 | 560 | 900 |
| D-138 | 550 | 840 |
| Comparative Dye 1 | 532 | 800 |

As shown in Table 3, the second metal complex dye of the present invention had a maximum absorption wavelength longer than that of the comparative dye 1. In addition, the absorption spectrum of the second dye of the present invention was broader than that of the comparative dye 1. Accordingly, the photo-electrochemical cell utilizing the second metal complex dye of the present invention can efficiently convert light in longer wavelength region into electricity as compared with a prior art metal complex dye.

### 3. Preparation of photo-electrochemical cell

The photo-electrochemical cells each comprising the second metal complex dye represented by the above general formula (II) or the comparative dye 1 were prepared in the same manner as EXAMPLE 1.

### 4. Measurement of photoelectric conversion efficiency

With respect to the photo-electrochemical cells, the photoelectric conversion efficiency to light at 800 nm was measured by IPCE (Incident Photon to Current Conversion Efficiency) measuring instrument manufactured by Optel Co. The results are shown in Table 4.

**Table 4.**

| Metal Complex Dye | IPCE (800nm, %) |
|---|---|
| D-93 | 7 |
| D-95 | 5 |
| D-100 | 13 |
| D-101 | 9 |
| D-103 | 21 |
| D-104 | 17 |
| D-105 | 20 |
| D-109 | 23 |
| D-112 | 8 |
| D-114 | 22 |
| D-115 | 16 |
| D-119 | 21 |
| D-120 | 14 |
| D-121 | 7 |
| D-136 | 4 |
| D-137 | 2 |
| D-138 | 6 |
| D-139 | 10 |
| Comparative Dye 1 | 0 |

As shown in Table 4, because the comparative dye 1 had no absorbability to light at 800 nm, the photo-electrochemical cell using the dye could not convert the light into electricity. As compared with this, the second photo-electrochemical cell utilizing the second dyes of the present invention exhibited an excellent photoelectric conversion efficiency to such a light having a long wavelength.

As explained above in detail, the second metal complex dye of the present invention has a high absorbability against light in a large wavelength region containing visible region to infrared region. Consequently, the second photoelectric conversion device using the second dye exhibits a high photoelectric conversion efficiency to a light in the visible region to the infrared region. The second photo-electrochemical cell comprising the second device is extremely useful as a solar cell.

The present invention further comprises the following Embodiments:
1. A photoelectric conversion device comprising semiconductor particles sensitized by a metal complex dye represented by the following general formula (I) or (II):

   M₁(LL₁)m1(X1)ₘ₂ . Cl₁ (I)

   M₂(LL₂)ₘ₃(LL₃)ₘ₄(X₂)ₘ₅ · Cl₂ (II)

   wherein M₁ and M₂ independently represent a metal atom;
   LL₁ and LL₂ independently represent a bidentate or tridentate ligand represented by the following general formula (III): 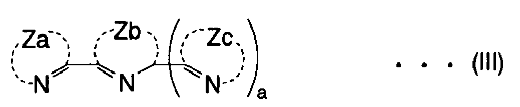 wherein Za, Zb and Zc independently represent nonmetallic atoms forming a 5- or 6-membered ring, *a* being 0 or 1;
   LL₃ represents a bidentate ligand represented by the following general formula (IV): 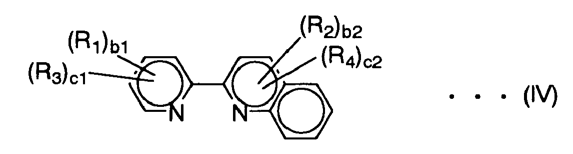 wherein R₁ and R₂ independently represent a carboxyl group, a sulfonic acid group, a hydroxyl group, a hydroxamic acid group, a phosphoryl group or a phosphonyl group, R₃ and R₄ independently represent a substituent, b1 and b2 independently represent an integer of 0 to 4, c1 represents an integer of 0 to 3, c2 represents an integer of 0 to 5, R₁'s may be the same or different groups when b1 is 2 or more, R₂'s may be the same or different groups when b2 is 2 or more, R₃'s may be the same or different groups that may be bonded together to form a ring when c1 is 2 or more, R₄'s may be the same or different groups that may be bonded together to form a ring when c2 is 2 or more, and R₃ and R₄ may be bonded to form a ring when both of c1 and c2 are 1 or more;
   X₁ represents a monodentate or bidentate ligand which coordinates to M₁ via one or two groups selected from the group consisting of an acyloxy group, an acylthio group, an acylaminooxy group, a thioacyloxy group, a thioacylthio group, a thiocarbonate group, a dithiocarbonate group, a trithiocarbonate group, an alkylthio group, an arylthio group, an alkoxy group and an aryloxy group, or a monodentate or bidentate ligand selected from the group consisting of ketones, carbonamides, thiocarbonamides, thioureas and isothioureas;
   X₂ represents a monodentate or bidentate ligand which coordinates to M₂ via one or two groups selected from the group consisting of an acyloxy group, an acylthio group, an acylaminooxy group, a thioacyloxy group, a thioacylthio group, a thiocarbonate group, a dithiocarbonate group, a trithiocarbonate group, an alkylthio group, an arylthio group, an alkoxy group, an aryloxy group, a thiocarbamate group, a dithiocarbamate group, an acyl group, a thiocyanate group, an isothiocyanate group, a cyanate group, an isocyanate group and a cyano group, or a monodentate or bidentate ligand selected from the group consisting of ketones, carbonamides, thiocarbonamides, thioureas, isothioureas, halogen atoms and carbonyl;
   m1 represents 1 or 2, and LL₁'s may be the same or different ligands when m1 is 2;
   m2 represents an integer of 1 to 3, and X₁'s may be the same or different ligands that may be bonded together when m2 is 2 or 3;
   m3 represents an integer of 0 to 2, and LL₂'s may be the same or different ligands when m3 is 2;
   m4 represents an integer of 1 to 3, and LL_{3'}s may be the same or different ligands when m4 is 2 or 3;
   m5 represents an integer of 0 to 3, and X₂'s may be the same or different ligands that may be bonded together when m5 is 2 or 3; and
   Cl₁ and Cl₂ independently represent a counter ion optionally contained to neutralize charge of said metal complex embodiment dye.
2. The photoelectric conversion device according to embodiment 1, wherein said M₁ and M₂ are independently Ru, Fe, Os, Cu, W, Cr, Mo, Ni, Pd, Pt, Co, Ir, Rh, Re, Mn or Zn.
3. The photoelectric conversion device according to embodiment 2, wherein said M₁ and M₂ are independently Ru, Fe, Os or Cu.
4. The photoelectric conversion device according to embodiment 3, wherein said M₁ and M₂ are Ru.
5. The photoelectric conversion device according to any one of embodiment 1 to 4, wherein the sum of b1 and b2 in said general formula (IV) is 1 to 4.
6. The photoelectric conversion device according to any one of claims 1 to 5, wherein the sum of c1 and c2 is 1 to 6, and R₃ and R₄ independently represent an alkyl group, an alkenyl group, a cycloalkyl group, an alkoxy group, an aryloxy group, an acylamino group, an amino group, a hydroxyl group or an alkynyl group in said general formula (IV).
7. The photoelectric conversion device according to any one of embodiment 1 to 6, wherein said LL₁ and LL₂ independently represent a bidentate or tridentate ligand represented by any one of the following general formulae (V-1) to (V-8): 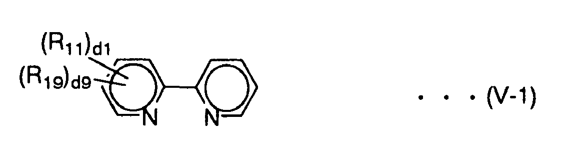 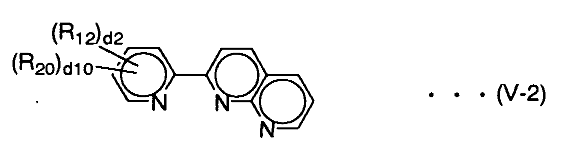 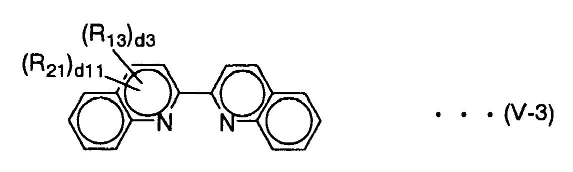 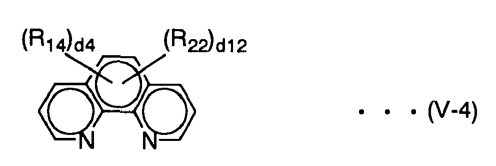 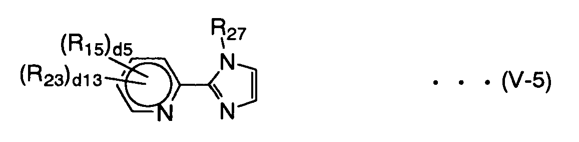 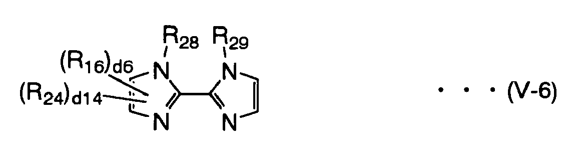 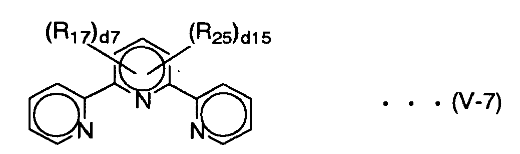 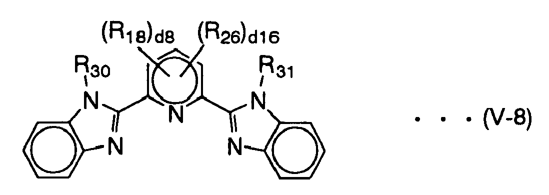 wherein R₁₁ to R₁₈ independently represent a carboxyl group, a sulfonic acid group, a hydroxyl group, a hydroxamic acid group, a phosphoryl group or a phosphonyl group, R₁₉ to R₂₆ independently represent a substituent, R₂₇ to R₃₁ independently represent an alkyl group, an alkenyl group, an aryl group or a hydrogen atom, R₁₁ to R₂₆ may be bonded to any carbon atom forming a ring, d1 to d8, d13, d14 and d16 independently represent an integer of 0 to 4, d9 to d12 and d15 independently represent an integer of 0 to 6, R₁₁ to R₁₈ may be the same or different groups when d1 to d8 are 2 or more, and R₁₉ to R₂₆ may be the same or different groups that may be bonded together to form a ring when d9 to d16 are 2 or more.
8. The photoelectric conversion device according to any one of embodiment 1 to 7, wherein said X₁ is a monodentate or bidentate ligand which coordinates to M₁ via one or two groups selected from the group consisting of an acyloxy group, an acylaminooxy group, an alkylthio group, an arylthio group, an alkoxy group and an aryloxy group, or a monodentate or bidentate ligand selected from the group consisting of ketones, thiocarbonamides, thioureas and isothioureas.
9. The photoelectric conversion device according to embodiment 8, wherein at least one of said X₁'s represents a bidentate ligand represented by any one of the following general formulae (VI-1) to (VI-5): 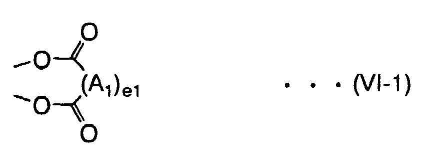 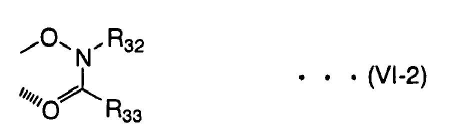 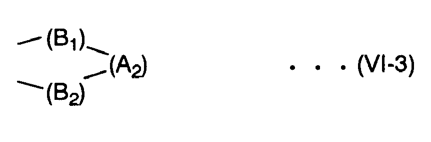 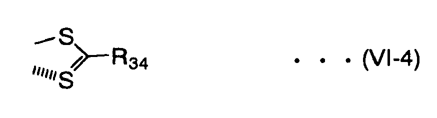 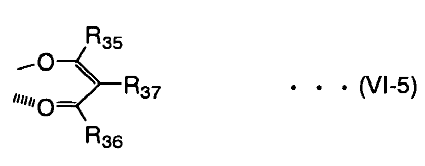 wherein A₁ represents a bidentate linking group, e1 represents 0 or 1, R₃₂ and R₃₃ independently represent an alkyl group, an alkenyl group, a cycloalkyl group, an aryl group, a heterocyclic group, an alkoxy group, an alkoxycarbonyl group, an amino group, an acyl group or a hydrogen atom, B₁ and B₂ independently represent an oxygen atom or a sulfur atom, A₂ represents an alkylene group or an arylene group, R₃₄ represents an alkyl group, an alkenyl group, a cycloalkyl group, an aryl group, a heterocyclic group, an alkoxy group, an aryloxy group, an alkylthio group or an arylthio group, R₃₅ and R₃₆ independently represent an alkenyl group, a cycloalkyl group, an aryl group, an alkoxy group, an amino group, a hydrogen atom, an alkyl group or a heterocyclic group, and R₃₇ represents an alkyl group, an alkenyl group, an aryl group, a halogen atom or a hydrogen atom.
10. The photoelectric conversion device according to any one of embodiment 1 to 9, wherein said semiconductor particles are titanium oxide particles.
11. A photo-electrochemical cell comprising said photoelectric conversion device according to any one of embodiment 1 to 10.
12. A metal complex dye represented by the following general formula (I) or (II):

   M₁(LL₁)ₘ₁(X₁)ₘ₂· Cl₁ (l)

   M₂(LL₂)ₘ₃(LL₃)ₘ₄(X₂)ₘ₅ . Cl₂ (ll)

   wherein M₁ and M₂ are Ru;
   LL₁ and LL₂ independently represent a bidentate or tridentate ligand represented by any one of the following general formulae (V-1) to (V-8): 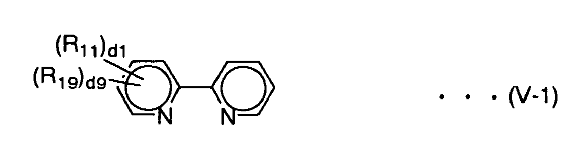 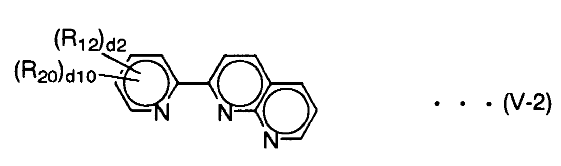 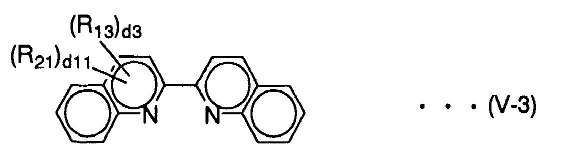 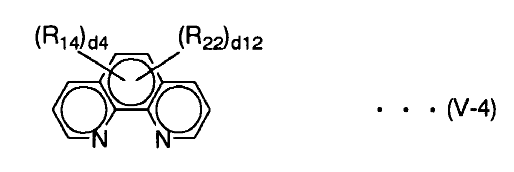 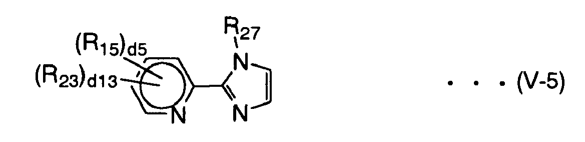 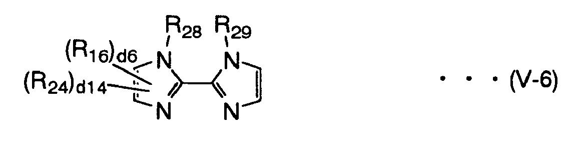 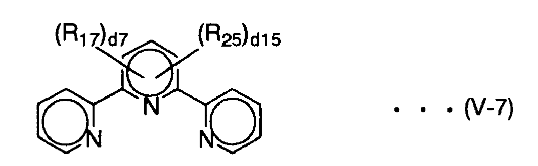 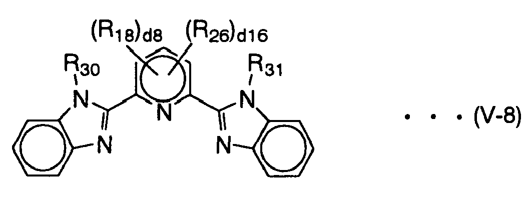 wherein R₁₁ to R₁₈ independently represent a carboxyl group, a sulfonic acid group, a hydroxyl group, a hydroxamic acid group, a phosphoryl group or a phosphonyl group, R₁₉ to R₂₆ independently represent a substituent, R₂₇ to R₃₁ independently represent an alkyl group, an alkenyl group, an aryl group or a hydrogen atom, R₁₁ to R₂₆ may be bonded to any carbon atom forming a ring, d1 to d8, d13, d14 and d16 independently represent an integer of 0 to 4, d9 to d12 and d15 independently represent an integer of 0 to 6, R₁₁ to R₁₈ may be the same or different groups when d1 to d8 are 2 or more, and R₁₉ to R₂₆ may be the same or different groups that may be bonded together to form a ring when d9 to d16 are 2 or more;
   LL₃ represents a bidentate ligand represented by the following general formula (IV): 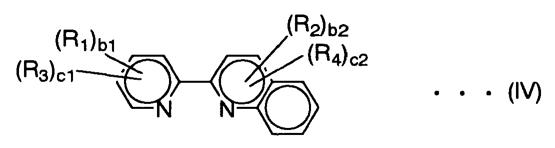 wherein R₁ and R₂ independently represent a carboxyl group, a sulfonic
      acid group, a hydroxyl group, a hydroxamic acid group, a phosphoryl group or a phosphonyl group, R₃ and R₄ independently represent a substituent, b1 and b2 independently represent an integer of 0 to 4, c1 represents an integer of 0 to 3, c2 represents an integer of 0 to 5, R₁'s may be the same or different groups when b1 is 2 or more, R₂'s may be the same or different groups when b2 is 2 or more, R₃'s may be the same or different groups that may be bonded together to form a ring when c1 is 2 or more, R₄'s may be the same or different groups that may be bonded together to form a ring when c2 is 2 or more, and R₃ and R₄ may be bonded to form a ring when both of c1 and c2 are 1 or more;
   X₁ represents a bidentate ligand represented by any one of the following general formulae (VI-1) to (VI-5): 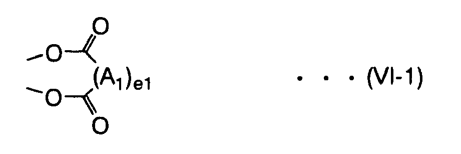 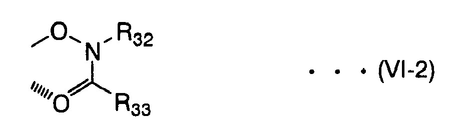 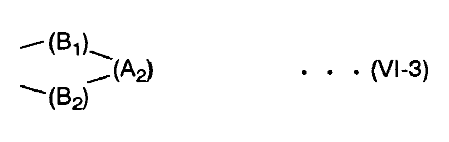 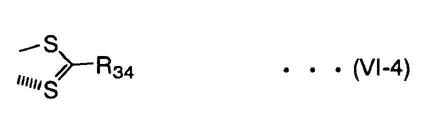 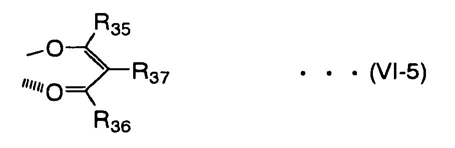 wherein A₁ represents a bidentate linking group, e1 represents 0 or 1, R₃₂ and R₃₃ independently represent an alkyl group, an alkenyl group, a cycloalkyl group, an aryl group, a heterocyclic group, an alkoxy group, an alkoxycarbonyl group, an amino group, an acyl group or a hydrogen atom, B₁ and B₂ independently represent an oxygen atom or a sulfur atom, A₂ represents an alkylene group or an arylene group, R₃₄ represents an alkyl group, an alkenyl group, a cycloalkyl group, an aryl group, a heterocyclic group, an alkoxy group, an aryloxy group, an alkylthio group or an arylthio group, R₃₅ and R₃₆ independently represent an alkenyl group, a cycloalkyl group, an aryl group, an alkoxy group, an amino group, a hydrogen atom, an alkyl group or a heterocyclic group, and R₃₇ represents an alkyl group, an alkenyl group, an aryl group, a halogen atom or a hydrogen atom;
   X₂ represents a monodentate or bidentate ligand which coordinates to M₂ via one or two groups selected from the group consisting of an acyloxy group, an acylthio group, an acylaminooxy group, a thioacyloxy group, a thioacylthio group, a thiocarbonate group, a dithiocarbonate group, a trithiocarbonate group, an alkylthio group, an arylthio group, an alkoxy group, an aryloxy group, a thiocarbamate group, a dithiocarbamate group, an acyl group, a thiocyanate group, an isothiocyanate group, a cyanate group, an isocyanate group and a cyano group, or a monodentate or bidentate ligand selected from the group consisting of ketones, carbonamides, thiocarbonamides, thioureas, isothioureas, halogen atoms and carbonyl;
   m1 represents 1 or 2, and LL₁'s may be the same or different ligands when m1 is 2;
   m2 represents an integer of 1 to 3, and X₁'s may be the same or different ligands that may be bonded together when m2 is 2 or 3;
   m3 represents 0 or 1;
   m4 represents 1 or 2, and LL₃'s may be the same or different ligands when m4 is 2;
   m5 represents an integer of 0 to 2, and X₂'s may be the same or different ligands that may be bonded together when m5 is 2;
   at least one of m3 and m5 is not 0; and
   CI₁ and CI₂ independently represent a counter ion optionally contained to neutralize charge of said metal complex dye.
13. The metal complex dye according to embodiment 12, wherein the sum of b1 and b2 in said general formula (IV) is 1 to 4.
14. The metal complex dye according to embodiment 12 or 13, wherein the sum of c1 and c2 is 1 to 6, and R₃ and R₄ independently represent an alkyl group, an alkenyl group, a cycloalkyl group, an alkoxy group, an aryloxy group, an acylamino group, an amino group, a hydroxyl group or an alkynyl group in said general formula (IV).

## Claims

1. A photoelectric conversion device comprising semiconductor particles sensitized by a metal complex dye represented by the following general formula (II):
M₂(LL₂)ₘ₃(LL₃)ₘ₄(X₂)ₘ₅ · Cl₂ (II)
wherein M₂ is Ru;
LL₂ represents a bidentate ligand represented by the following general formula (III): 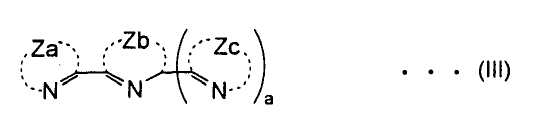 wherein Za, Zb and Zc independently represent nonmetallic atoms forming a 5- or 6-membered ring, a being 0;
LL₃ represents a bidentate ligand represented by the following general formula (IV): 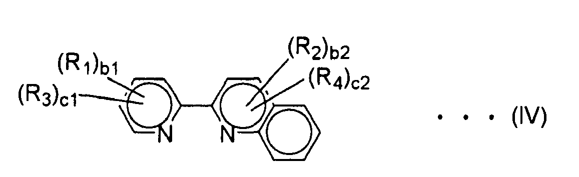 wherein R₁ and R₂ independently represent a carboxyl group, a sulfonic acid group, a hydroxyl group, a hydroxamic acid group, a phosphoryl group or a phosphonyl group, R₃ and R₄ independently represent a substituent, b1 represents an integer of 0 to 4, b2 is 1 or 2, c1 is 0 or 1, c2 represents an integer of 0 to 5, R₁'s may be the same or different groups when b1 is 2 or more, R₂'s may be the same or different groups when b2 is 2, R₄'s may be the same or different groups that may be bonded together to form a ring when c2 is 2 or more, and R₃ and R₄ may be bonded to form a ring when c1 is 1 and c2 is 1 or more;
X₂ represents a monodentate or bidentate ligand which coordinates to M₂ via one or two groups selected from the group consisting of an acyloxy group, an acylthio group, an acylaminooxy group, a thioacyloxy group, a thioacylthio group, a thiocarbonate group, a dithiocarbonate group, a trithiocarbonate group, an alkylthio group, an arylthio group, an alkoxy group, an aryloxy group, a thiocarbamate group, a dithiocarbamate group, an acyl group, a thiocyanate group, an isothiocyanate group, a cyanate group, an isocyanate group and a cyano group, or a monodentate or bidentate ligand selected from the group consisting of ketones, carbonamides, thiocarbonamides, thioureas, isothioureas, halogen atoms and carbonyl;
m3 represents an integer of 0 to 2, and LL₂'s may be the same or different ligands when m3 is 2;
m4 represents an integer of 1 to 3, and LL₃'s may be the same or different ligands when m4 is 2 or 3;
m5 represents an integer of 0 to 3, and X₂'s may be the same or different ligands that may be bonded together when m5 is 2 or 3; and
Cl₂ represents a counter ion optionally contained to neutralize charge of said metal complex dye.

2. The photoelectric conversion device according to claim 1, wherein the sum of b1 and b2 in said general formula (IV) is 1 to 4.

3. The photoelectric conversion device according to claim 1 or 2, wherein the sum of c1 and c2 is 1 to 6, and R₃ and R₄ independently represent an alkyl group, an alkenyl group, a cycloalkyl group, an alkoxy group, an aryloxy group, an acylamino group, an amino group, a hydroxyl group or an alkynyl group in said general formula (IV).

4. The photoelectric conversion device according to any one of claims 1 to 3, wherein said LL₂ represents a bidentate ligand represented by any one of the following general formulae (V-1), (V-3) and (V-6): 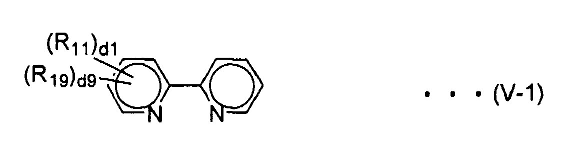 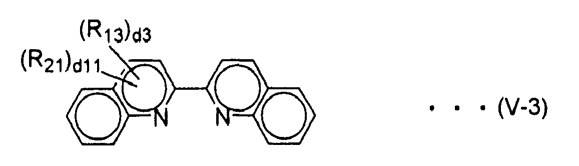 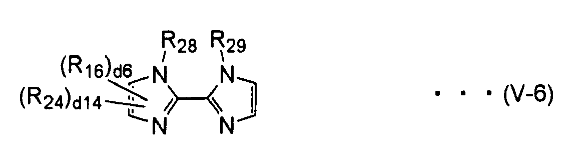 wherein R₁₁, R₁₃ and R₁₆ independently represent a carboxyl group, a sulfonic acid group, a hydroxyl group, a hydroxamic acid group, a phosphoryl group or a phosphonyl group, R₁₉, R₂₁ and R₂₄ independently represent a substituent, R₂₈ and R₂₉ independently represent an alkyl group, an alkenyl group, an aryl group or a hydrogen atom, R₁₁, R₁₃, R₁₆, R₁₉, R₂₁ and R₂₄ may be bonded to any carbon atom forming a ring, d1, d6 and d14 independently represent an integer of 0 to 4, d3 is 1 or 2, d9 and d11 independently represent an integer of 0 to 6, R₁₁, R₁₃ and R₁₆ may be the same or different groups when d1 and d6 are 2 or more and d3 is 2, and R₁₉, R₂₁ and R₂₄ may be the same or different groups that may be bonded together to form a ring when d9, d11 and d14 are 2 or more.

5. The photoelectric conversion device according to any one of claims 1 to 4, wherein said semiconductor particles are titanium oxide particles.

6. A photo-electrochemical cell comprising said photoelectric conversion device according to any one of claims 1 to 5.
